# EUROPEAN PATENT SPECIFICATION

(11) **EP 4 395 515 B1**
(45) Date of publication and mention of the grant of the patent: **18.02.2026**
(21) Application number: 23194259.0
(22) Date of filing: 30.08.2023
(51) Int. Cl.: H10K 85/30, H10K 85/60

(54) **ORGANIC LIGHT EMITTING DIODE AND ORGANIC LIGHT EMITTING DEVICE INCLUDING THE SAME**
ORGANISCHE LICHTEMITTIERENDE DIODE UND ORGANISCHE LICHTEMITTIERENDE VORRICHTUNG DAMIT
DIODE ÉLECTROLUMINESCENTE ORGANIQUE ET DISPOSITIF ÉLECTROLUMINESCENT ORGANIQUE LA COMPRENANT

(30) Priority: 29.12.2022 KR 20220189154
(43) Date of publication of application: 03.07.2024
(73) Proprietor: LG Display Co., Ltd., Seoul 07336 (KR)
(72) Inventor: Kwon, Ju-Hyuk, 10845 Gyeonggi-do (KR); Kim, Chun-Ki, 10845 Gyeonggi-do (KR); Lee, Yu-Jeong, 10845 Gyeonggi-do (KR); Park, Eun-Jung, 10845 Gyeonggi-do (KR); Youn, Jang-Dae, 10845 Gyeonggi-do (KR); Cho, Hyun-Jin, 10845 Gyeonggi-do (KR); Ha, Jun-Su, 10845 Gyeonggi-do (KR)
(74) Representative: Ter Meer Steinmeister & Partner

(56) References cited:
- WO-A1-2021/010656
- JP-A- 2007 294 261
- US-A1- 2011 251 446
- US-A1- 2022 209 119
- US-A1- 2022 285 625

## Description

### FIELD OF TECHNOLOGY

The present invention relates to an organic light emitting device, and more specifically, to an organic light emitting diode (OLED) having advantages in at least one of driving voltage, emitting efficiency and lifespan and an organic light emitting device including the same.

### BACKGROUND

As requests for a flat panel display device having a small occupied area have been increased, an organic light emitting display device including an OLED has been the subject of recent research and development.

The OLED emits light by injecting electrons from a cathode as an electron injection electrode and holes from an anode as a hole injection electrode into an emitting material layer (EML), combining the electrons with the holes, generating an exciton, and transforming the exciton from an excited state to a ground state. A flexible substrate, for example, a plastic substrate, can be used as a base substrate where elements are formed. In addition, the organic light emitting display device can be operated at a voltage (e.g., 10V or below) lower than a voltage required to operate other display devices. Moreover, the organic light emitting display device has advantages in the power consumption and the color sense.

The OLED includes a fist electrode as an anode over a substrate, a second electrode, which is spaced apart from and faces the first electrode, and an organic emitting layer therebetween.

For example, the organic light emitting display device may include a red pixel region, a green pixel region and a blue pixel region, and the OLED may be formed in each of the red, green and blue pixel regions.

JP 2007 294261 A relates to an organic electroluminescent device that has multiple light emitting layers.

However, the OLED in the blue pixel does not provide sufficient emitting efficiency, color purity and lifespan such that the organic light emitting display device has a limitation in the emitting efficiency, the color purity and the lifespan.

### SUMMARY

The present invention is directed to an OLED and an organic light emitting device including the OLED that substantially obviate one or more of the problems associated with the limitations and disadvantages of the related conventional art.

Additional features and advantages of the present invention are set forth in the description which follows, and will be apparent from the description, or evident by practice of the present invention. The objectives and other advantages of the present invention are realized and attained by the features described herein as well as in the appended drawings.

To achieve these and other advantages in accordance with the purpose of the embodiments of the present invention, as described herein, an aspect of the present invention is an organic light emitting diode comprising a first electrode; a second electrode facing the first electrode; and a first emitting part including a first blue emitting layer and a second blue emitting layer and positioned between the first and second electrodes, the second blue emitting layer positioned between the first blue emitting layer and the second electrode and contacting the first blue emitting layer, wherein the first blue emitting layer includes a first host and a first dopant, and the second blue emitting layer includes a second host and a second dopant, wherein the first host is a pyrene derivative, and the second host is an anthracene derivative, wherein the first dopant is a first compound represented by Formula 5 or a second compound represented by Formula 6, and the second dopant is a third compound represented by Formula 5 or a fourth compound represented by Formula 6, 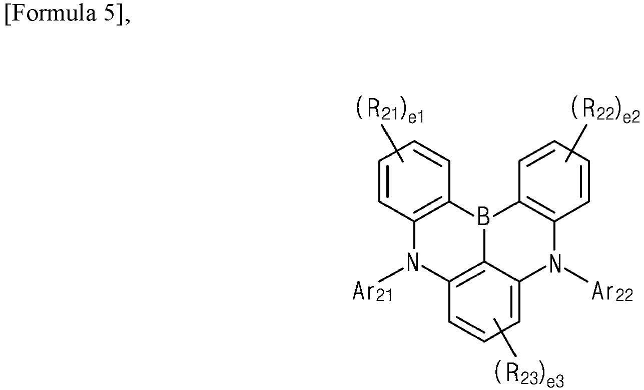
wherein in the Formula 5,
each of e1 and e2 is independently an integer of 0 to 4, and e3 is an integer of 0 to 3,
each of Ar₂₁ and Ar₂₂ is independently selected from the group consisting of a substituted or unsubstituted C6 to C30 arylamino group, a substituted or unsubstituted C6 to C30 aryl group, a substituted or unsubstituted C3 to C30 heteroaryl group and a substituted or unsubstituted C6 to C30 alicyclic group, and R₂₁, R₂₂ and R₂₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group, 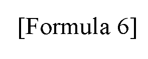 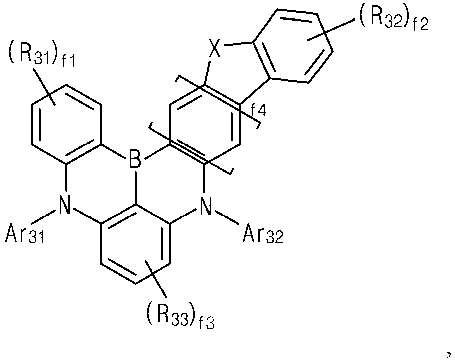
and wherein in the Formula 6,
each of f1 and f2 is independently an integer of 0 to 4, f3 is an integer of 0 to 3, f4 is 0 or 1, X is O or S, each of Ar₃₁ and Ar₃₂ is independently selected from the group consisting of a substituted or unsubstituted C6 to C30 arylamino group, a substituted or unsubstituted C6 to C30 aryl group, a substituted or unsubstituted C3 to C30 heteroaryl group and a substituted or unsubstituted C6 to C30 alicyclic group or forms a substituted or unsubstituted ring with adjacent benzene ring, and each of R₃₁, R₃₂ and R₃₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group.

According to the present invention, the first dopant is represented by one of the Formulas 5 and 6, and the second dopant is represented by the other one of the Formulas 5 and 6.

In an embodiment,when the first dopant is the first compound and the second dopant is the fourth compound, a weight % of the first dopant in the first blue emitting material layer is smaller than a weight % of the second dopant in the second blue emitting material layer, or wherein when the first dopant is the second compound and the second dopant is the third compound, a weight % of the first dopant in the first blue emitting material layer is greater than a weight % of the second dopant in the second blue emitting material layer.

In an embodiment, each of the first compound and the third compound is independently one of compounds in Formula 7:

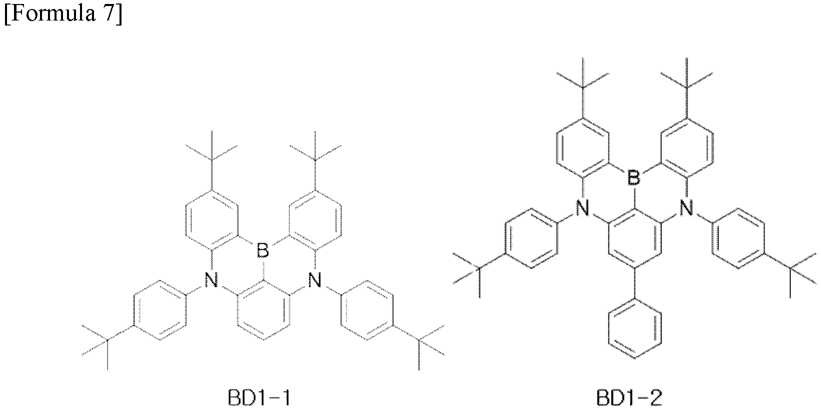

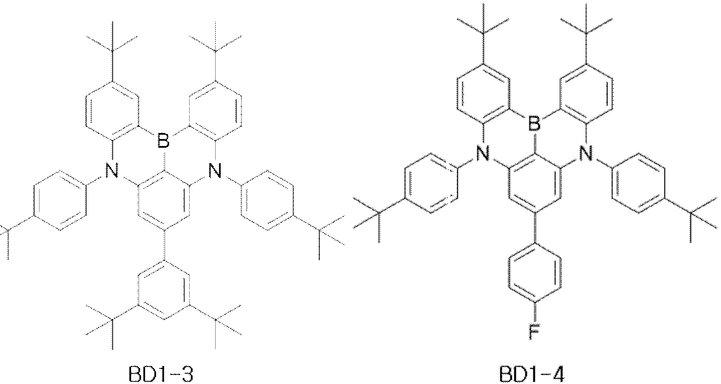

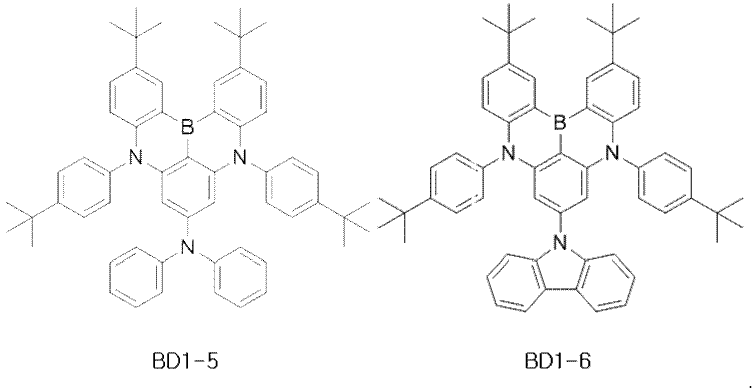

According to the present invention, each of the second compound and the fourth compound represented by Formula 6 is independently one of compounds in Formula 8:

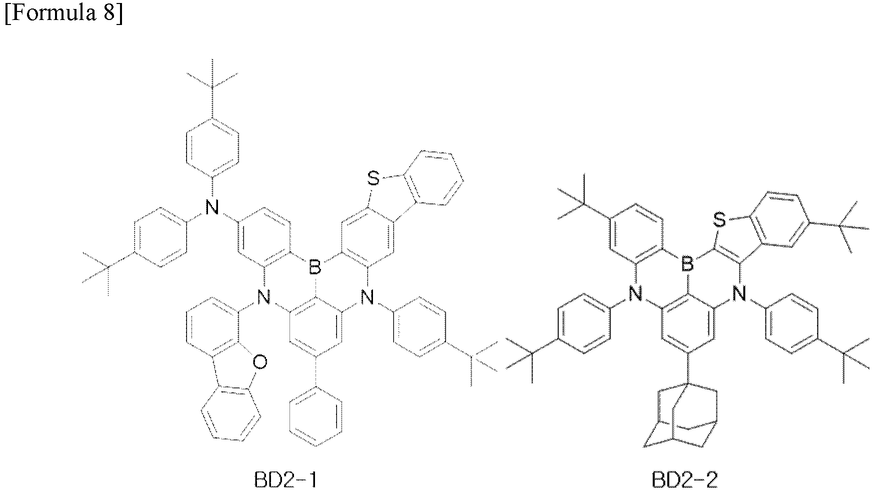

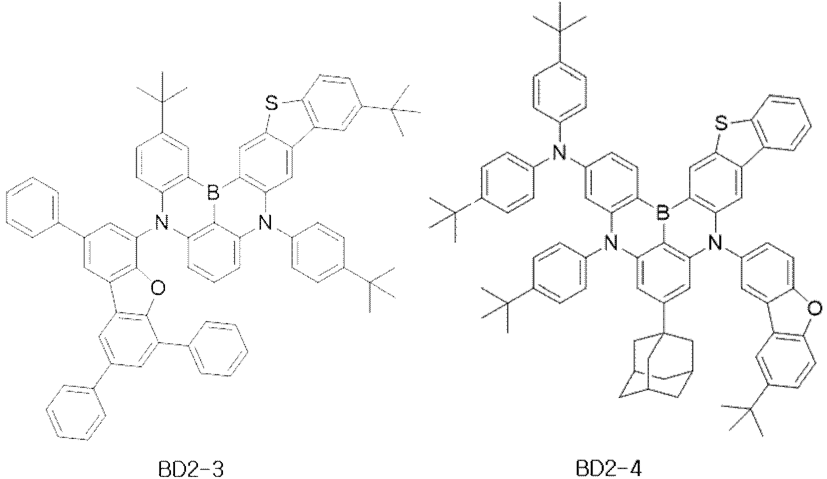

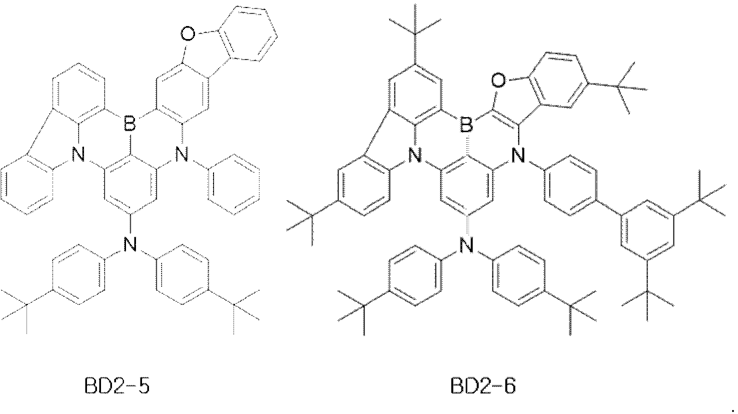

In an embodiment, the first host is represented by Formula 1: 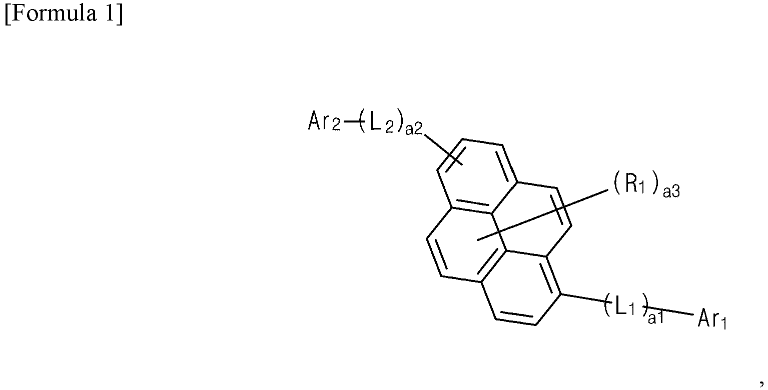 wherein in the Formula 1,
each of a1 and a2 is independently 0 or 1, and a3 is an integer of 0 to 4,
R₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of Ar₁ and Ar₂ is independently selected from the group consisting of hydrogen, deuterium, a substituted or unsubstituted C6 to C30 aryl group and a substituted or unsubstituted C3 to C30 heteroaryl group, and
each of L₁ and L₂ is independently selected from the group consisting of a substituted or unsubstituted C6 to C30 arylene group and a substituted or unsubstituted C3 to C30 heteroarylene group.

In an embodiment, the first host includes at least one of first host compounds in Formula 2:

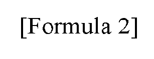

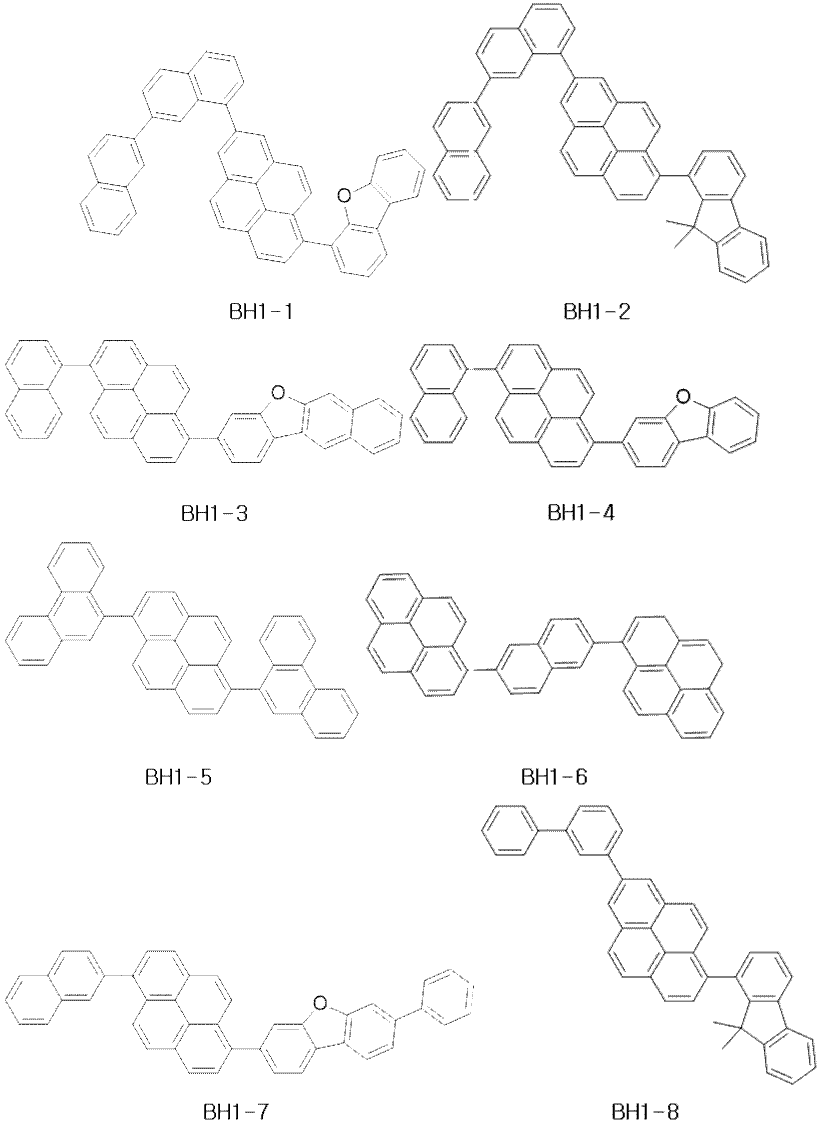

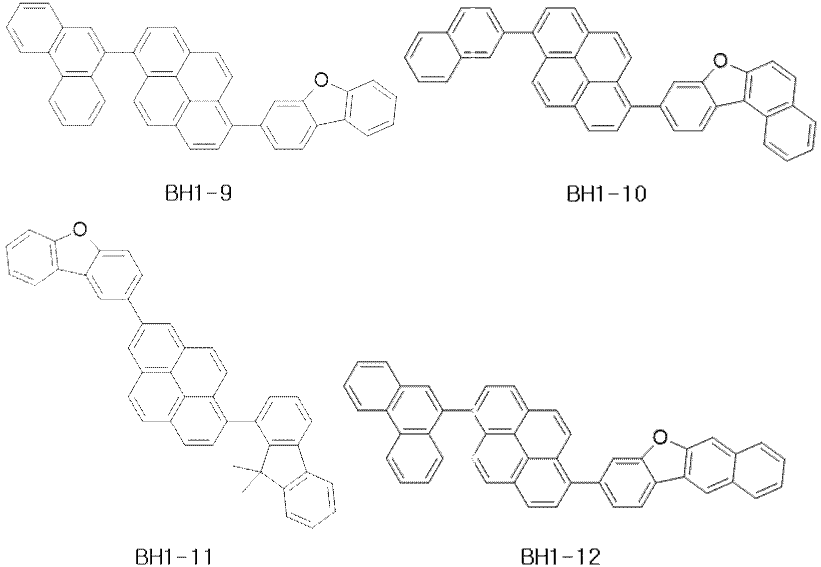

In an embodiment, the second host is represented by Formula 3: 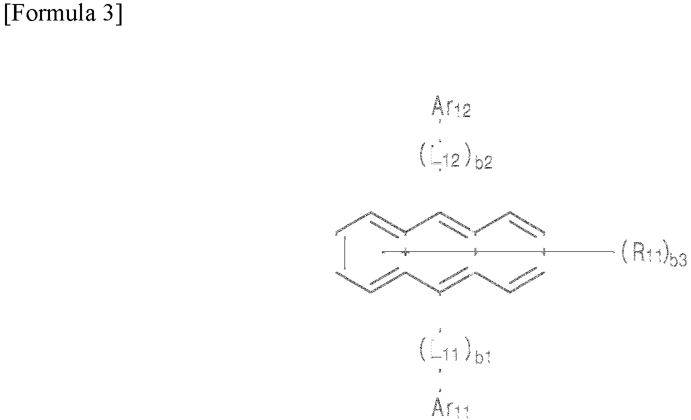 , wherein in the Formula 3,
each of b1 and b2 is independently 0 or 1, and b3 is an integer of 0 to 8,
R₁₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of L₁₁ and L₁₂ is independently selected from the group consisting of a substituted or unsubstituted C6 to C30 arylene group and a substituted or unsubstituted C3 to C30 heteroarylene group, and
each of Ar₁₁ and Ar₁₂ is independently selected from the group consisting of a substituted or unsubstituted C6 to C30 aryl group and a substituted or unsubstituted C3 to C30 heteroaryl group.

In an embodiment, the second host includes at least one of second host compounds in Formula 4:

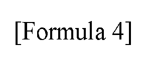

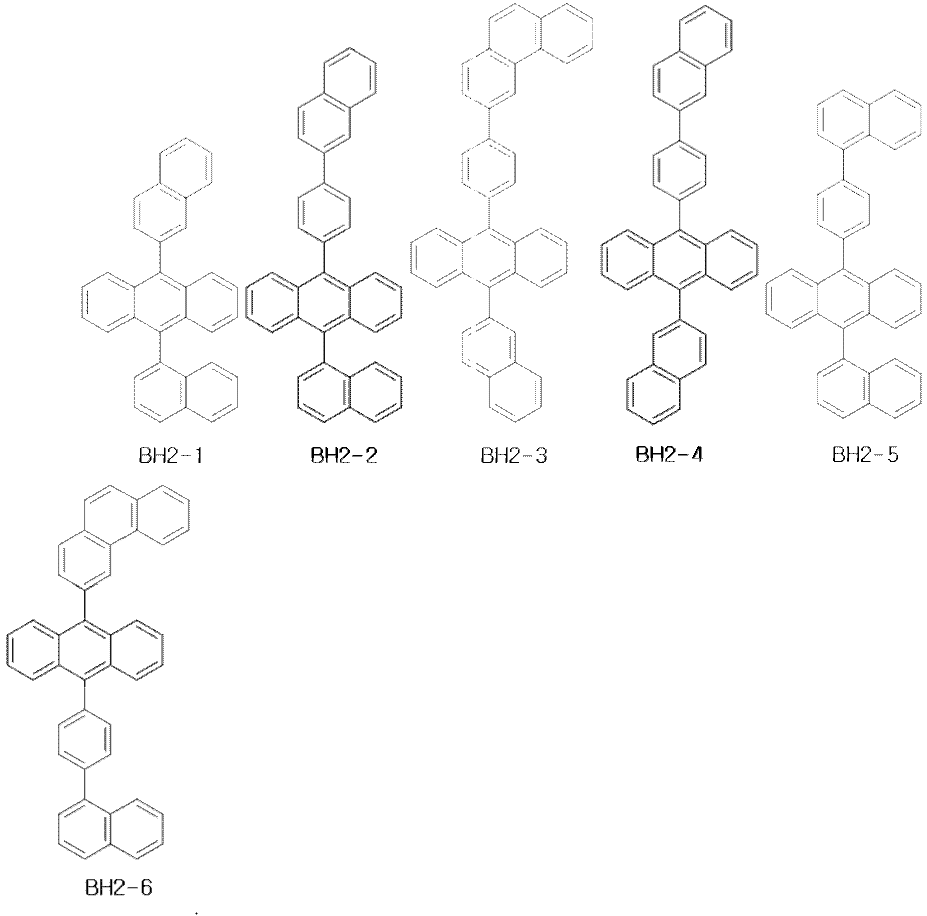

In an embodiment, a thickness of the first blue emitting layer is smaller than a thickness of the second blue emitting layer.

In an embodiment, the organic light emitting diode further comprises:
a second emitting part including a third blue emitting layer and a fourth blue emitting layer and positioned between the first emitting part and the second electrode, the fourth blue emitting layer positioned between the third blue emitting layer and the second electrode and contacting the third blue emitting layer,
wherein the third blue emitting layer includes a third host and a third dopant, and the fourth blue emitting layer includes a fourth host and a fourth dopant,
wherein the third host is the pyrene derivative, and the fourth host is the anthracene derivative, wherein the third dopant is a fifth compound represented by the Formula 5 or a sixth compound represented by the Formula 6, and the second dopant is a seventh compound represented by the Formula 5 or an eighth compound represented by the Formula 6.

In an embodiment, the third dopant is represented by one of the Formulas 5 and 6, and the fourth dopant is represented by the Formulas 5 and 6.

In an embodiment, wherein when the third dopant is the fifth compound and the fourth dopant is the eighth compound, a weight % of the third dopant in the third blue emitting material layer is smaller than a weight % of the fourth dopant in the fourth blue emitting material layer, or wherein when the third dopant is the sixth compound and the second dopant is the seventh compound, a weight % of the third dopant in the third blue emitting material layer is greater than a weight % of the fourth dopant in the fourth blue emitting material layer. In an embodiment, the third host is represented by Formula 1: 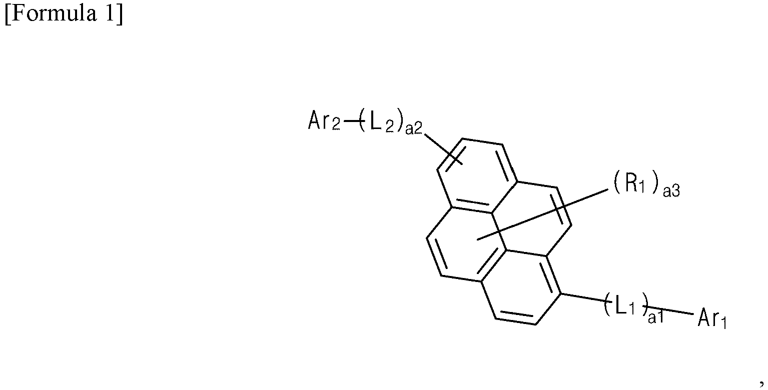 wherein in the Formula 1,
each of a1 and a2 is independently 0 or 1, and a3 is an integer of 0 to 4,
R₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of Ar₁ and Ar₂ is independently selected from the group consisting of hydrogen, deuterium, a substituted or unsubstituted C6 to C30 aryl group and a substituted or unsubstituted C3 to C30 heteroaryl group, and
each of L₁ and L₂ is independently selected from the group consisting of a substituted or unsubstituted C6 to C30 arylene group and a substituted or unsubstituted C3 to C30 heteroarylene group.

In an embodiment, wherein the fourth host is represented by Formula 3: 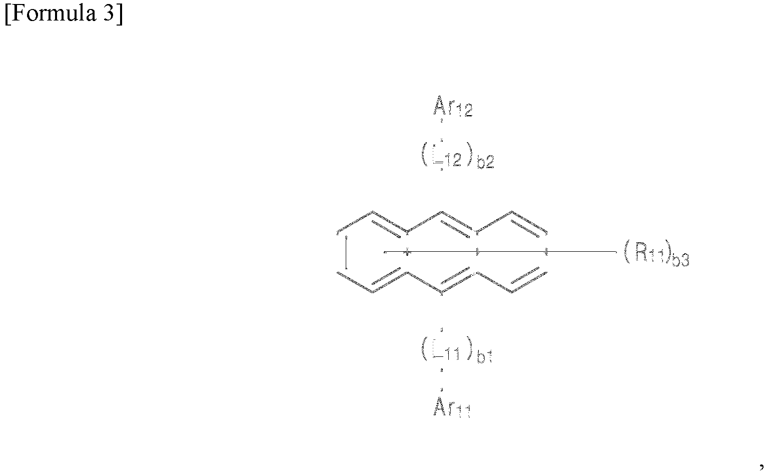 wherein in the Formula 3,
each of b1 and b2 is independently 0 or 1, and b3 is an integer of 0 to 8,
R₁₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of L₁₁ and L₁₂ is independently selected from the group consisting of a substituted or unsubstituted C6 to C30 arylene group and a substituted or unsubstituted C3 to C30 heteroarylene group, and
each of Ar₁₁ and Ar₁₂ is independently selected from the group consisting of a substituted or unsubstituted C6 to C30 aryl group and a substituted or unsubstituted C3 to C30 heteroaryl group.

In an embodiment, a thickness of the third blue emitting layer is smaller than a thickness of the fourth blue emitting layer.

In an embodiment, the organic light emitting diode further comprises:
a third emitting part including a red emitting layer and a green emitting layer and positioned between the first and second emitting parts.

In an embodiment, the organic light emitting diode further comprises:
a third emitting part including a red emitting layer and positioned between the first emitting part and the first electrode; and
a fourth emitting part including a green emitting layer and positioned between the first and second emitting parts.

In an embodiment, the organic light emitting diode further comprises:
a second emitting part including a yellow-green emitting layer and positioned between the first emitting part and the second electrode.

Another aspect of the present invention is an organic light emitting device comprising a substrate; the organic light emitting of the invention -diode over the substrate; and an encapsulation layer covering the organic light emitting diode.

It is to be understood that both the foregoing general description and the following detailed description are exemplary and explanatory and are intended to further explain the present invention as claimed.

### BRIEF DESCRIPTION OF THE DRAWINGS

The accompanying drawings, which are included to provide a further understanding of the present invention and are incorporated in and constitute a part of this specification, illustrate embodiments of the present invention and together with the description serve to explain the principles of the present invention.
FIG. 1 is a schematic circuit diagram illustrating an organic light emitting display device of the present invention.
FIG. 2 is a schematic cross-sectional view illustrating an organic light emitting display device according to a first embodiment of the present invention.
FIG. 3 is a schematic cross-sectional view illustrating an OLED according to a second embodiment of the present invention.
FIG. 4 is a schematic cross-sectional view illustrating an OLED according to a third embodiment of the present invention.
FIG. 5 is a schematic cross-sectional view illustrating an organic light emitting display device according to a fourth embodiment of the present invention.
FIG. 6 is a schematic cross-sectional view illustrating an organic light emitting display device according to a fifth embodiment of the present invention.
FIG. 7 is a schematic cross-sectional view illustrating an OLED according to a sixth embodiment of the present invention.
FIG. 8 is a schematic cross-sectional view illustrating an OLED according to a seventh embodiment of the present invention.
FIG. 9 is a schematic cross-sectional view illustrating an OLED according to an eighth embodiment.

### DETAILED DESCRIPTION

Reference will now be made in detail to aspects of the present invention, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

Advantages and features of the present invention and methods of achieving them will be apparent with reference to the aspects described below in detail with the accompanying drawings. However, the present invention is not limited to the aspects disclosed below, but can be realized in a variety of different forms, and only these aspects allow the disclosure of the present invention to be complete. The present disclosure is provided to fully inform the scope of the invention to the skilled in the art.

The shapes, sizes, proportions, angles, numbers, and the like disclosed in the drawings for explaining the aspects of the present invention are illustrative, and the present invention is not limited to the illustrated matters. The same reference numerals refer to the same elements throughout the specification. In addition, in describing the present invention, if it is determined that a detailed description of the related known technology unnecessarily obscure the subject matter of the present invention, the detailed description thereof can be omitted. When 'including', 'having', 'consisting', and the like are used in this specification, other parts may be added unless 'only' is used. When a component is expressed in the singular, cases including the plural are included unless specific statement is described.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts may be disposed between the two parts unless a more limiting term, such as "just" or "direct(ly)" is used.

In describing a time relationship, for example, when the temporal order is described as, for example, "after," "subsequent," "next," and "before," a case that is not continuous may be included unless a more limiting term, such as "just," "immediate(ly)," or "direct(ly)" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present invention.

Features of various aspects of the present invention may be partially or overall coupled to or combined with each other, and may be variously inter-operated with each other and driven technically as those skilled in the art can sufficiently understand. The aspects of the present invention may be carried out independently from each other, or may be carried out together in co-dependent relationship.

Reference will now be made in detail to some of the examples and preferred embodiments, which are illustrated in the accompanying drawings.

In the present invention, an organic light emitting device including the OLED may be an organic light emitting display device or an organic lightening device. As an example, an organic light emitting display device, which is a display device including the OLED of the present invention, will be mainly described.

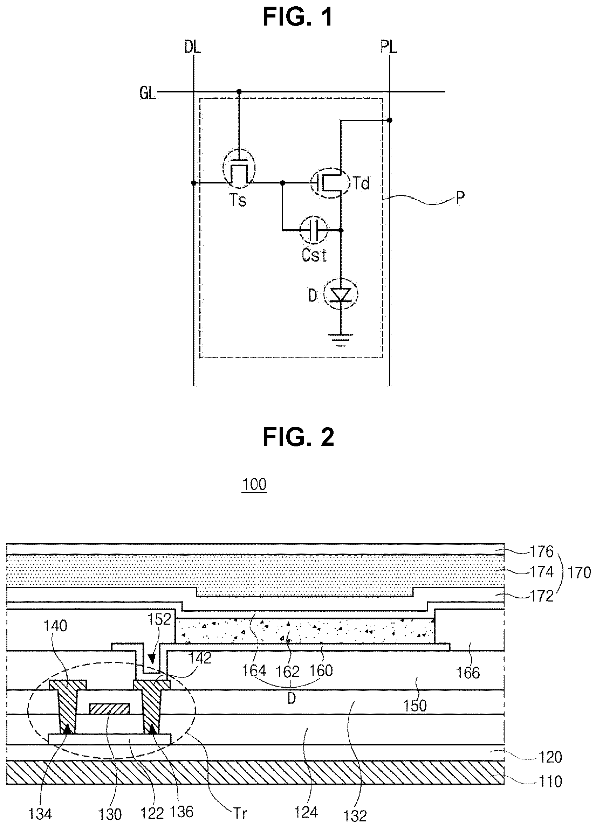

FIG. 1 is a schematic circuit diagram illustrating an organic light emitting display device of the present invention.

As illustrated in FIG. 1, a gate line GL and a data line DL, which cross each other to define a pixel region (pixel) P, and a power line PL are formed in an organic light emitting display device. A switching thin film transistor (TFT) Ts, a driving TFT Td, a storage capacitor Cst and an OLED D are formed in the pixel region P. The pixel region P may include a red pixel region, a green pixel region and a blue pixel region.

The switching thin film transistor Ts is connected to the gate line GL and the data line DL, and the driving thin film transistor Td is connected between the switching thin film transistor Ts and the power line PL. The storage capacitor Cst is connected to a gate electrode and a drain electrode of the driving TFT Td, and the OLED D is connected to the driving thin film transistor Td.

When the switching thin film transistor Ts is turned on by the gate signal applied through the gate line GL, the data signal applied through the data line DL is applied into a gate electrode of the driving thin film transistor Td and one electrode of the storage capacitor Cst through the switching thin film transistor Ts.

The driving thin film transistor Td is turned on by the data signal applied into the gate electrode so that a current proportional to the data signal is supplied from the power line PL to the OLED D through the driving thin film transistor Td. The OLED D emits light having a luminance proportional to the current flowing through the driving thin film transistor Td. In this case, the storage capacitor Cst is charge with a voltage proportional to the data signal so that the voltage of the gate electrode in the driving thin film transistor Td is kept constant during one frame. Therefore, the organic light emitting display device can display a desired image.

FIG. 2 is a schematic cross-sectional view illustrating an organic light emitting display device according to a first embodiment of the present invention.

As illustrated in FIG. 2, the organic light emitting display device 100 includes a substrate 110, a TFT Tr and an OLED D disposed on a planarization layer and connected to the TFT Tr.

The substrate 110 may be a glass substrate or a flexible substrate. For example, the flexible substrate may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 120 is formed on the substrate, and the TFT Tr is formed on the buffer layer 120. The buffer layer 120 may be omitted.

A semiconductor layer 122 is formed on the buffer layer 120. The semiconductor layer 122 may include an oxide semiconductor material or polycrystalline silicon. When the semiconductor layer 122 includes the oxide semiconductor material, a light-shielding pattern (not shown) may be formed under the semiconductor layer 122. The light to the semiconductor layer 122 is shielded or blocked by the light-shielding pattern such that thermal degradation of the semiconductor layer 122 can be prevented. On the other hand, when the semiconductor layer 122 includes polycrystalline silicon, impurities may be doped into both sides of the semiconductor layer 122.

A gate insulating layer 124 is formed on the semiconductor layer 122. The gate insulating layer 124 may be formed of an inorganic insulating material such as silicon oxide (SiOx) or silicon nitride (SiNx).

A gate electrode 130, which is formed of a conductive material, e.g., metal, is formed on the gate insulating layer 124 to correspond to a center of the semiconductor layer 122. In FIG. 2, the gate insulating layer 124 is formed on an entire surface of the substrate 110. Alternatively, the gate insulating layer 124 may be patterned to have the same shape as the gate electrode 130.

An interlayer insulating layer 132, which is formed of an insulating material, is formed on the gate electrode 130. The interlayer insulating layer 132 may be formed of an inorganic insulating material, e.g., silicon oxide or silicon nitride, or an organic insulating material, e.g., benzocyclobutene or photo-acryl.

The interlayer insulating layer 132 includes first and second contact holes 134 and 136 exposing both sides of the semiconductor layer 122. The first and second contact holes 134 and 136 are positioned at both sides of the gate electrode 130 to be spaced apart from the gate electrode 130. The first and second contact holes 134 and 136 are formed through the gate insulating layer 124 and the interlayer insulating layer 132. Alternatively, when the gate insulating layer 124 is patterned to have the same shape as the gate electrode 130, the first and second contact holes 134 and 136 is formed only through the interlayer insulating layer 132.

A source electrode 140 and a drain electrode 142, which are formed of a conductive material, e.g., metal, are formed on the interlayer insulating layer 132. The source electrode 140 and the drain electrode 142 are spaced apart from each other with respect to the gate electrode 130 and respectively contact both sides of the semiconductor layer 122 through the first and second contact holes 134 and 136.

The semiconductor layer 122, the gate electrode 130, the source electrode 140 and the drain electrode 142 constitute the TFT Tr. The TFT Tr serves as a driving element. Namely, the TFT Tr may correspond to the driving TFT Td (of FIG. 1).

In the TFT Tr, the gate electrode 130, the source electrode 140, and the drain electrode 142 are positioned over the semiconductor layer 122. Namely, the TFT Tr has a coplanar structure. Alternatively, in the TFT Tr, the gate electrode may be positioned under the semiconductor layer, and the source and drain electrodes may be positioned over the semiconductor layer such that the TFT Tr may have an inverted staggered structure. In this instance, the semiconductor layer may include amorphous silicon.

Although not shown, the gate line and the data line cross each other to define the pixel region, and the switching TFT is formed to be connected to the gate and data lines. The switching TFT is connected to the TFT Tr as the driving element. In addition, the power line, which may be formed to be parallel to and spaced apart from one of the gate and data lines, and the storage capacitor for maintaining the voltage of the gate electrode of the TFT Tr in one frame may be further formed.

A planarization layer 150 is formed on the source and drain electrodes 140 and 142 and over an entire surface of the substrate 110. The planarization layer 150 has a flat top surface and includes a drain contact hole 152 exposing the drain electrode 142 of the TFT Tr.

The OLED D is disposed on the planarization layer 150 and includes a first electrode 160, which is connected to the drain electrode 142 of the TFT Tr, an organic emitting layer 162 on the first electrode 160 and a second electrode 164 on the organic emitting layer 162. The OLED D is disposed at each of the red, green and blue pixel regions and emits red light, green light and blue light in the red, green and blue pixel regions, respectively.

The first electrode 160 is separately formed in each pixel region. The first electrode 160 may be an anode and may be formed of a conductive material having a relatively high work function. For example, the first electrode 160 may be formed of a conductive material having a relatively high work function, e.g., a transparent conductive oxide (TCO). for example, the first electrode 160 may include at least one of indium-tin-oxide (ITO), indium-zinc-oxide (IZO), indium-tin-zinc oxide (ITZO), tin oxide (SnO), zinc oxide (ZnO), indium-copper-oxide (ICO) and aluminum-zinc-oxide (Al:ZnO, AZO).

When the organic light emitting display device 100 is operated in a bottom-emission type, the first electrode 160 may have a single-layered structure formed of the transparent conductive oxide. Alternatively, when the organic light emitting display device 100 is operated in a top-emission type, the first electrode 160 may further include a reflective layer to have a double-layered structure or a triple-layered structure. For example, the reflective layer may include silver (Ag) or aluminum-palladium-copper alloy (APC). In the top-emission type OLED D, the first electrode 160 may have a double-layered structure of Ag/ITO or APC/ITO or a triple-layered structure of ITO/Ag/ITO or ITO/APC/ITO.

A bank layer 166 is formed on the planarization layer 150 to cover an edge of the first electrode 160. Namely, the bank layer 166 is positioned at a boundary of the pixel region and exposes a center of the first electrode 160 in the pixel region.

An organic emitting layer 162 is formed on the first electrode 160. The organic emitting layer 162 may have a single-layered structure of an emitting material layer (EML). Alternatively, the organic emitting layer 162 may further include at least one of a hole injection layer (HIL), a hole transport layer (HTL), an electron blocking layer (EBL), a hole blocking layer (HBL), an electron transport layer (ETL) and an electron injection layer (EIL) to have a multi-layered structure.

In the blue pixel region, the organic emitting layer 162 of the OLED D includes a blue EML, and the blue EML includes a first blue emitting layer and a second blue emitting layer.

The first blue emitting layer includes a first host being a pyrene derivative (or compound) and a first dopant being one of a first compound represented by Formula 5 and a second compound represented by Formula 6, and the second blue emitting layer includes a second host being an anthracene derivative and a second dopant being one of a third compound represented by Formula 5 and a fourth compound represented by Formula 6. As a result, the OLED D and the organic light emitting display device 100 have an advantage in at least one of the driving voltage, the color purity, the emitting efficiency, and the lifespan.

The organic emitting layer 162 may include two or more blue EMLs, which are disposed to be spaced apart from each other, so that the OLED D may have a tandem structure.

The second electrode 164 is formed over the substrate 110 where the organic emitting layer 162 is formed. The second electrode 164 covers an entire surface of the display area and may be formed of a conductive material having a relatively low work function to serve as a cathode. For example, the second electrode 164 may be formed of a material having high reflectance, such as aluminum (Al), magnesium (Mg), calcium (Ca), silver (Ag), their alloys or their combinations. In the top-emission type organic light emitting display device 100, the second electrode 164 may have a thin profile (small thickness) to provide a light transmittance property (or a semi-transmittance property).

An encapsulation layer (or encapsulation film) 170 is formed on the second electrode 164 to prevent penetration of moisture into the OLED D. The encapsulation film 170 includes a first inorganic insulating layer 172, an organic insulating layer 174 and a second inorganic insulating layer 176 sequentially stacked, but it is not limited thereto. The encapsulation film 170 may be omitted.

In the bottom-emission type organic light emitting display device 100, a metal plate may be disposed on the encapsulation layer 170.

The organic light emitting display device 100 may include a color filter layer corresponding to the red, green and blue pixel regions. The color filter layer may include red, green and blue color filters respectively corresponding to the red, green and blue pixel regions. The organic light emitting display device 100 with the color filter layer may have improved color purity.

In the bottom-emission type organic light emitting display device 100, the color filter layer may be disposed between the OLED D and the substrate 110, e.g., between the interlayer insulating layer 132 and the planarization layer 150. In the top-emission type organic light emitting display device 100, the color filter layer may be disposed over the OLED D, e.g., on or over the second electrode 164 or the encapsulation layer 170.

The organic light emitting display device 100 may further include a polarization plate for reducing an ambient light reflection. For example, the polarization plate may be a circular polarization plate. In the bottom-emission type organic light emitting display device 100, the polarization plate may be disposed under the substrate 110. In the top-emission type organic light emitting display device 100, the polarization plate may be disposed on or over the encapsulation film 170.

In addition, in the top-emission type organic light emitting display device 100, a cover window may be attached to the encapsulation film 170 or the polarization plate. In this instance, the substrate 110 and the cover window have a flexible property such that a flexible organic light emitting display device may be provided.

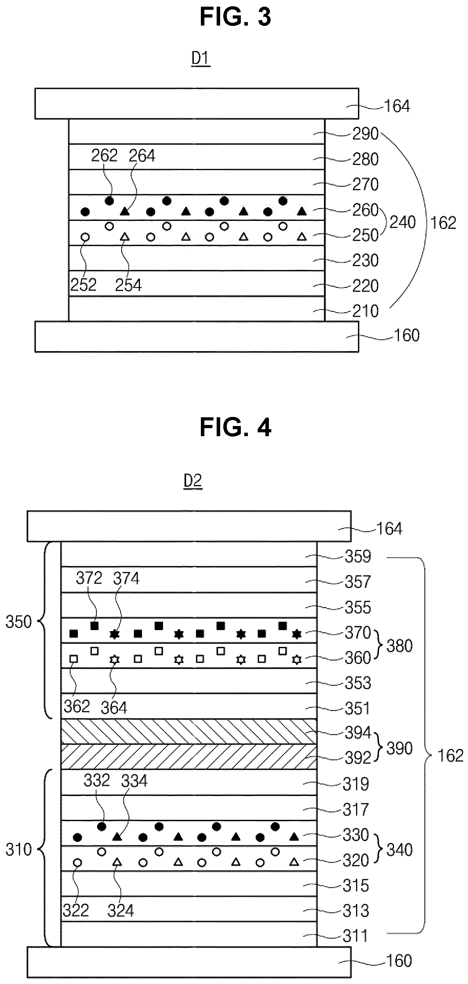

FIG. 3 is a schematic cross-sectional view illustrating an OLED according to a second embodiment of the present invention.

As illustrated in FIG. 3, the OLED D1 includes the first and second electrodes 160 and 164, which face each other, and the organic emitting layer 162 therebetween, and the organic emitting layer 162 includes a blue EML 240.

The organic light emitting display device 100 (of FIG. 2) includes red, green and blue pixels. In addition, the organic light emitting display device 100 may further include a white pixel region. The OLED D1 may be positioned in the blue pixel.

The organic emitting layer 162 in the red pixel region includes a red EML, and the organic emitting layer 162 in the green pixel region includes a green EML.

One of the first and second electrodes 160 and 164 is an anode, and the other one of the first and second electrodes 160 and 164 is a cathode. One of the first and second electrodes 160 and 164 is a reflection electrode, and the other one of the first and second electrodes 160 and 164 is a transparent electrode (or a semi-transparent electrode).

For example, the first electrode 160 may include a transparent conductive material layer of ITO or IZO, and the second electrode 164 may be formed of one of Al, Mg, Ag, AlMg and MgAg.

The blue EML 240 includes a first blue emitting layer 250 being closer to the first electrode 160 and a second blue emitting layer 260 being closer to the second electrode 164 and adjacent to the first blue emitting layer 250. Namely, the second blue emitting layer 260 is disposed between the first blue emitting layer 250 and the second electrode 164 and contacts the first blue emitting layer 250.

The blue EML 240 may have a thickness of 100 to 500 Å. A summation of a thickness of the first blue emitting layer 250 and a thickness of the second blue emitting layer 260 is equal to a thickness of the blue EML 240, and the thickness of the first blue emitting layer 250 and the thickness of the second blue emitting layer 260 may be same or different. Each of the thickness of the first blue emitting layer 250 and the thickness of the second blue emitting layer 260 may be 10 to 250 Å, e.g., 20 to 250 Å.

In an aspect of the present invention, the thickness of the first blue emitting layer 250 may be smaller than that of the second blue emitting layer 260. For example, the first blue emitting layer 250 may have a thickness of 20 to 100 Å, and the second blue emitting layer 260 may have a thickness of 150 to 250 Å.

The first blue emitting layer 250 includes a first host 252 and a first dopant (e.g., a first emitter) 254. In the first blue emitting layer 250, the first host 252 may have a weight % (wt%) of 80 to 99.5, preferably 95 to 99.5, and the first dopant 254 may have a wt% of 0.5 to 20, preferably 0.5 to 5.

The second blue emitting layer 260 includes a second host 262 and a second dopant (e.g., a second emitter) 264. In the second blue emitting layer 260, the second host 262 may have a weight % (wt%) of 80 to 99.5, preferably 95 to 99.5, and the second dopant 264 may have a wt% of 0.5 to 20, preferably 0.5 to 5.

A weight % of the first host 252 in the first blue emitting layer 250 and a weight % of the second host 262 in the second blue emitting layer 260 may be same or different, and a weight % of the first dopant 254 in the first blue emitting layer 250 and a weight % of the second dopant 264 in the second blue emitting layer 260 may be same or different.

The first host 252 includes at least one of a first host compound, i.e., a pyrene derivative, preferably represented by Formula 1.

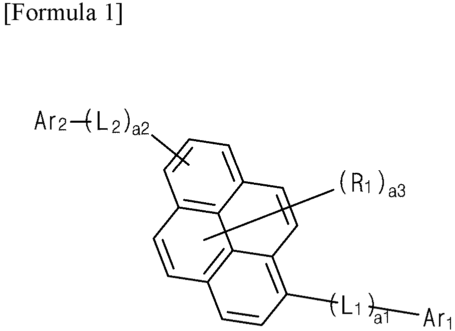

In Formula 1, each of a1 and a2 is independently 0 or 1, and a3 is an integer of 0 to 4,
R₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of Ar₁ and Ar₂ is independently selected from the group consisting of hydrogen, deuterium, a substituted or unsubstituted C6 to C30 aryl group and a substituted or unsubstituted C3 to C30 heteroaryl group, and
each of L₁ and L₂ is independently selected from the group consisting of a substituted or unsubstituted C6 to C30 arylene group and a substituted or unsubstituted C3 to C30 heteroarylene group.

In the present invention, without specific definition, a substituent of an alkyl group, an alkoxy group, a cycloalkyl group, an alicylic group, an aryamino group, an aryl group and a heteroaryl group may be at least one of deuterium, halogen, cyano, a substituted or unsubstituted C1 to C10 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group.

In the present invention, without specific definition, a C1 to C30 alkyl group may be selected from the group consisting of methyl, ethyl, propyl and butyl, e.g., tert-butyl or isobutyl.

In the present invention, without specific definition, a C3 to C30 cycloalkyl group may be selected from the group consisting of cyclopropyl, cyclobutyl, cyclopentyl, cyclohexyl, and adamantanyl.

In the present invention, without specific definition, a C6 to C30 alicyclic group may be selected from the group consisting of tetralinyl, methyltetralinyl, ethyltetralinyl, tetramethyltetralinyl and pentamethylindanyl.

In the present invention, without specific definition, a C6 to C30 aryl group may be selected from the group consisting of phenyl, biphenyl, terphenyl, naphthyl, anthracenyl, pentalenyl, indenyl, indenoindenyl, heptalenyl, biphenylenyl, indacenyl, phenanthrenyl, benzophenanthrenyl, dibenzophenanthrenyl, azulenyl, pyrenyl, fluoranthenyl, triphenylenyl, chrysenyl, tetraphenyl, tetrasenyl, picenyl, pentaphenyl, pentacenyl, fluorenyl, indenofluorenyl and spiro-fluorenyl.

In the present invention, without specific definition, a C6 to C30 arylene group may be selected from the group consisting of phenylene, biphenylene, terphenylene, naphthylene, anthracenylene, pentanenylene, indenylene, indenoindenylene, heptalenylene, biphenylenylene, indacenylene, phenanthrenylene, benzophenanthrenylene, dibenzophenanthrenylene, azulenylene, pyrenylene, fluoranthenylene, triphenylenylene, chrysenylene, tetraphenylene, tetrasenylene, picenylene, pentaphenylene, pentacenylene, fluorenylene, indenofluorenylene and spiro-fluorenylene.

In the present disclosure, without specific definition, a C3 to C30 heteroaryl group can be selected from the group consisting of pyrrolyl, pyridinyl, pyrimidinyl, pyrazinyl, pyridazinyl, triazinyl, tetrazinyl, imidazolyl, pyrazolyl, indolyl, isoindolyl, indazolyl, indolizinyl, pyrrolizinyl, carbazolyl, benzocarbazolyl, dibenzocarbazolyl, indolocarbazolyl, indenocarbazolyl, benzofurocarbazolyl, benzothienocarbazolyl, quinolinyl, isoquinolinyl, phthalazinyl, quinoxalinyl, cinnolinyl, quinazolinyl, quinolizinyl, quinolinyl, purinyl, phthalazinyl, quinoxalinyl, benzoquinolinyl, benzoisoquinolinyl, benzoquinazolinyl, benzoquinoxalinyl, acridinyl, phenanthrolinyl, perimidinyl, phenanthridinyl, pteridinyl, cinnolinyl, naphtharidinyl, furanyl, oxazinyl, oxazolyl, oxadiazolyl, triazolyl, dioxinyl, benzofuranyl, dibenzofuranyl, thiopyranyl, xanthenyl, chromanyl, isochromanyl, thioazinyl, thiophenyl, benzothiophenyl, dibenzothiophenyl, difuropyrazinyl, benzofurodibenzofuranyl, benzothienobenzothiophenyl, benzothienodibenzothiophenyl, benzothienobenzofuranyl, and benzothienodibenzofuranyl.

In the present disclosure, without specific definition, a C3 to C30 heteroarylene group can be selected from the group consisting of pyrrolylene, pyridinylv, pyrimidinylene, pyrazinylene, pyridazinylene, triazinylene, tetrazinylene, imidazolylene, pyrazolylene, indolylene, isoindolylene, indazolylene, indolizinylene, pyrrolizinylene, carbazolylene, benzocarbazolylene, dibenzocarbazolylene, indolocarbazolylene, indenocarbazolylene, benzofurocarbazolylene, benzothienocarbazolylene, quinolinylene, isoquinolinylene, phthalazinylene, quinoxalinylene, cinnolinylene, quinazolinylene, quinolizinyl, quinolinylene, purinylene, phthalazinylene, quinoxalinylene, benzoquinolinylene, benzoisoquinolinylene, benzoquinazolinylene, benzoquinoxalinylene, acridinylene, phenanthrolinylene, perimidinylene, phenanthridinylene, pteridinylene, cinnolinylene, naphtharidinylene, furanylene, oxazinylene, oxazolylene, oxadiazolylene, triazolylene, dioxinylene, benzofuranyenel, dibenzofuranylene, thiopyranylene, xanthenylene, chromanylene, isochromanylene, thioazinylene, thiophenylene, benzothiophenylene, dibenzothiophenylene, difuropyrazinylene, benzofurodibenzofuranylene, benzothienobenzothiophenylene, benzothienodibenzothiophenylene, benzothienobenzofuranylene, and benzothienodibenzofuranylene.

In Formula 1, a3 may be 0 (zero).

In Formula 1, each of Ar₁ and Ar₂ may be independently selected from the group consisting of hydrogen, a C6 to C30 aryl group, e.g., phenyl, naphthyl, fluorenyl, phenanthrenyl or pyrenyl, unsubstituted or substituted with at least one of a C1 to C10 alkyl group and a C6 to C30 aryl group, and a C3 to C30 heteroaryl group, e.g., dibenzothiophenyl, benzo[b]naphto[1,2-d]furanyl, or benzo[b]naphto[2,3-d]furanyl, unsubstituted or substituted with at least one of a C1 to C10 alkyl group and a C6 to C30 aryl group.

In Formula 1, each of L₁ and L₂ may be independently a substituted or unsubstituted C6 to C30 arylene group, e.g., phenylene.

In Formula 1, each of a1 and a2 may be 0 (zero), and a bonding site of Ar₁ and Ar₂ may be specified. For example, Formula 1 may be represented by Formula 1a or 1b.

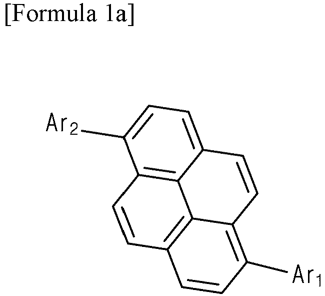

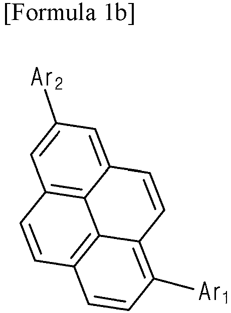

In each of Formulas 1a and 1b, the definitions of Ar₁ and Ar₂ are same as those in Formula 1.

For example, the first host 252 included in the first blue EML 250 may include at least one of compounds in Formula 2as referred to herein above.

The second host 262 includes at least one of a second host compound, i.e., an anthracene derivative, preferably represented by Formula 3.

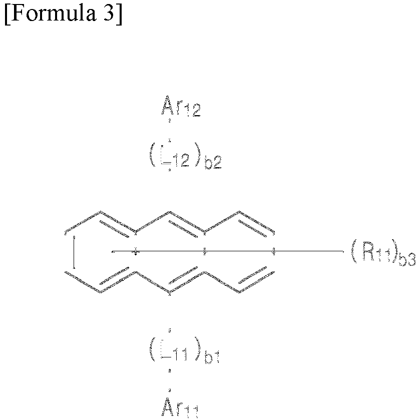

In Formula 3, each of b1 and b2 is independently 0 or 1, and b3 is an integer of 0 to 8,
R₁₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of L₁₁ and L₁₂ is independently selected from the group consisting of a substituted or unsubstituted C6 to C30 arylene group and a substituted or unsubstituted C3 to C30 heteroarylene group, and
each of Ar₁₁ and Ar₁₂ is independently selected from the group consisting of a substituted or unsubstituted C6 to C30 aryl group and a substituted or unsubstituted C3 to C30 heteroaryl group.

In Formula 3, b3 may be 0.

In Formula 3, one of b1 and b2 may be 0, and the other one of b1 and b2 may be 1. Each of L₁₁ and L₁₂ may be independently a substituted or unsubstituted C6 to C30 arylene group, e.g., phenylene.

In Formula 3, each of Ar₁₁ and Ar₁₂ may be a substituted or unsubstituted C6 to C30 aryl group, e.g., naphthyl (1-naphthyl or 2-naphthyl) or phenanthrenyl. For example, at least one of Ar₁₁ and Ar₁₂ may be naphthyl (1-naphthyl or 2-naphthyl).

In certain embodiments, in the Formula 3, b3 is an integer of 0; each of L₁₁ and L₁₂ is independently selected from the group consisting of a substituted or unsubstituted C6 to C12 arylene group and a substituted or unsubstituted C3 to C12 heteroarylene group, and each of Ar₁₁ and Ar₁₂ is independently selected from the group consisting of a substituted or unsubstituted C6 to C20 aryl group and a substituted or unsubstituted C3 to C20 heteroaryl group.

For example, the second host 262 included in the second blue EML 260 may include at least one of compounds in Formula 4 as referred to herein above.

The first dopant 254 is one of a first compound represented by Formula 5 and a second compound represented by Formula 6, and the second dopant 264 is one of a third compound represented by Formula 5 and a fourth compound represented by Formula 6. Namely, i) both of the first dopant 254 and the second dopant 264 are represented by Formula 5, and athe first dopant 254 and the second dopant 264 are same or different, ii) the first dopant 254 is represented by Formula 5, and the second dopant 264 is represented by Formula 6, iii) the first dopant 254 is represented by Formula 6, and the second dopant 264 is represented by Formula 5, or iv) both of the first dopant 254 and the second dopant 264 are represented by Formula 6, and the first dopant 254 and the second dopant 264 are same or different.

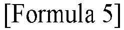

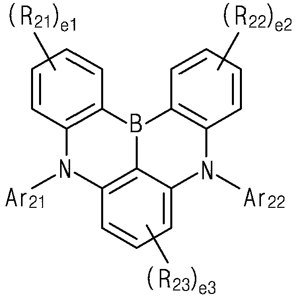

In Formula 5, each of e1 and e2 is independently an integer of 0 to 4, and e3 is an integer of 0 to 3,
each of Ar₂₁ and Ar₂₂ is independently selected from the group consisting of a substituted or unsubstituted C6 to C30 arylamino group, a substituted or unsubstituted C6 to C30 aryl group, a substituted or unsubstituted C3 to C30 heteroaryl group and a substituted or unsubstituted C6 to C30 alicyclic group, and
each of R₂₁, R₂₂ and R₂₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group.

In Formula 5, each of Ar₂₁ and Ar₂₂ may be a C6 to C30 aryl group, e.g., phenyl, biphenyl, naphthyl or anthracenyl, unsubstituted or substituted with a C1 to C30 alkyl group, e.g., methyl or tert-butyl.

In Formula 5, each of e1, e2 and e3 is independently 0 or 1. For example, each of e1 and e2 may be 0, and e3 may be 0 or 1.

In Formula 5, each of R₂₁, R₂₂ and R₂₃ may be independently selected from the group consisting of a substituted or unsubstituted C1 to C30 alkyl group, e.g., methyl or tert-butyl, a C6 to C30 aryl group, e.g., phenyl, unsubstituted or substituted with at least one of a C1 to C30 alkyl group, e.g., methyl or tert-butyl, and halogen, e.g., F, a substituted or unsubstituted C6 to C30 arylamino group, e.g., diphenylamino, and a substituted or unsubstituted C3 to C30 heteroaryl group, e.g., carbazolyl.

In certain embodiments, in the first compound and the third compound represented by Formula 5, each of e1, e2 and e3 may be 1; each of Ar₂₁ and Ar₂₂ is independently a substituted or unsubstituted phenyl; and R₂₁, R₂₂ and R₂₃ are each independently selected from the group consisting of a substituted or unsubstituted C1 to C10 alkyl group, a substituted or unsubstituted C6 to C10 aryl group and a substituted or unsubstituted C3 to C10 heteroaryl group.

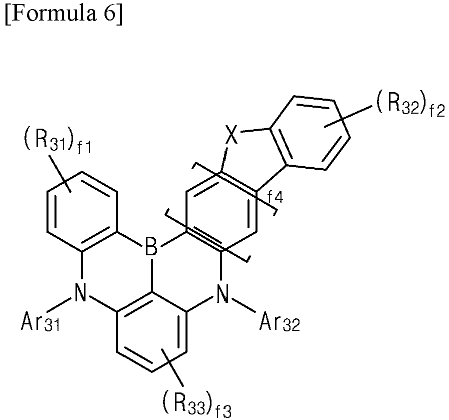

In Formula 6, each of f1 and f2 is independently an integer of 0 to 4, f3 is an integer of 0 to 3, f4 is 0 or 1,
X is O or S,
each of Ar₃₁ and Ar₃₂ is independently selected from the group consisting of a substituted or unsubstituted C6 to C30 arylamino group, a substituted or unsubstituted C6 to C30 aryl group, a substituted or unsubstituted C3 to C30 heteroaryl group and a substituted or unsubstituted C6 to C30 alicyclic group or forms a substituted or unsubstituted ring with adjacent benzene ring, and
each of R₃₁, R₃₂ and R₃₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group.

In Formula 6, each of Ar₃₁ and Ar₃₂ may be independently selected from the group consisting of a C6 to C30 aryl group, e.g., phenyl or biphenyl, unsubstituted or substituted with a C1 to C30 alkyl group, e.g., tert-butyl, and a C3 to C30 heteroaryl group, e.g., dibenzofuranyl, unsubstituted or substituted with at least one of a C1 to C30 alkyl group, e.g., tert-butyl, and a C6 to C30 aryl group, e.g., phenyl or biphenyl. In an aspect, at least one of Ar₃₁ and Ar₃₂ may form a carbazole ring, which is unsubstituted or substituted with a C1 to C30 alkyl group, e.g., tert-butyl, with adjacent benzene ring and nitrogen.

In Formula 6, each of f1, f2 and f3 is independently 0 or 1.

In Formula 6, each of R₃₁, R₃₂ and R₃₃ may be independently selected from the group consisting of a substituted or unsubstituted C1 to C30 alkyl group, e.g., methyl or tert-butyl, a C6 to C30 arylamino group, e.g., diphenylamino, unsubstituted or substituted with a C1 to C30 alkyl group, e.g., tert-butyl, a substituted or unsubstituted C3 to C30 cycloalkyl group, e.g., adamantanyl, and a substituted or unsubstituted C6 to C30 aryl group.

In certain embodiments, in the second compound and the fourth compound represented by Formula 6, each of f1, f2 and f3 is an integer of 1, f4 is 0 or 1; X is O or S; each of Ar₃₁ and Ar₃₂ is independently selected from the group consisting of a substituted or unsubstituted C6 to C10 arylamino group, a substituted or unsubstituted C6 to C10 aryl group, a substituted or unsubstituted C3 to C10 heteroaryl group and a substituted or unsubstituted C6 to C10 alicyclic group or forms a ring with adjacent benzene ring, and R₃₁, R₃₂ and R₃₃ are each independently selected from the group consisting of a substituted or unsubstituted C1 to C10 alkyl group, a substituted or unsubstituted C3 to C10 cycloalkyl group, a substituted or unsubstituted C6 to C10 arylamino group, a substituted or unsubstituted C6 to C10 aryl group and a substituted or unsubstituted C3 to C10 heteroaryl group.

In certain embodiments, Formula 6 may be represented by Formula 6-1, i.e., f4 in Formula 6 is 0, or Formula 6-2, i.e., f4 in Formula 6 is 1.

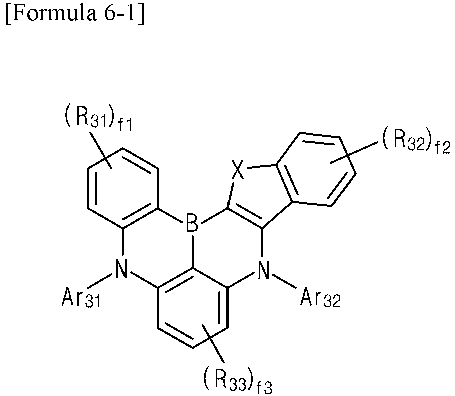

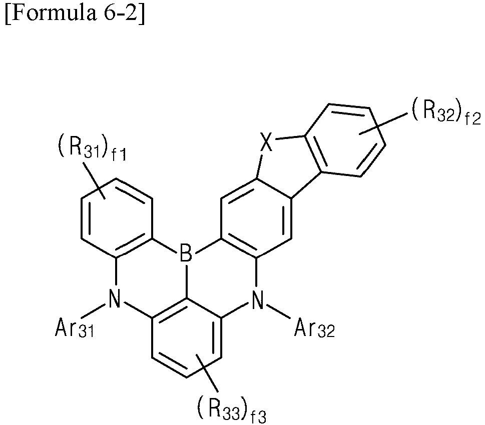

In each of Formulas 6-1 and 6-2, the definitions of f1, f2, f3, Ar₃₁, Ar₃₂, R₃₁, R₃₂ and R₃₃ are same as those in Formula 6.

Each of the first compound and the third compound represented by Formula 5 is independently one of compounds in Formula 7 as referred to herein above.

Each of the second compound and the fourth compound represented by Formula 6 is one of compounds in Formula 8 as referred to herein above.

The first dopant 254 may include one of the compound represented by Formula 5 and the compound represented by Formula 6, and the second dopant 264 may include the other one of the compound represented by Formula 5 and the compound represented by Formula 6. A weight % of the compound represented by Formula 5 may be smaller than that of the compound represented by Formula 6. For example, the compound represented by Formula 5 may have a weight % of 0.5 to 3, and the compound represented by Formula 6 may have a weight % of 1.5 to 5.

In an aspect of the present invention, the first dopant 254 may include the first compound represented by Formula 5, and the second dopant 264 may include the fourth compound represented by Formula 6. A weight % of the first dopant 254 in the first blue emitting layer 250 may be smaller than that of the second dopant 264 in the second blue emitting layer 260. For example, the first dopant 254 in the first blue emitting layer 250 may have a weight % of 0.5 to 3, and the second dopant 264 in the second blue emitting layer 260 may have a weight % of 1.5 to 5. In this instance, the OLED D1 may have a big advantage in the driving voltage, the emitting efficiency and the lifespan.

In an aspect of the present invention, the first dopant 254 may include the second compound represented by Formula 6, and the second dopant 264 may include the third compound represented by Formula 5. A weight % of the first dopant 254 in the first blue emitting layer 250 may be greater than that of the second dopant 264 in the second blue emitting layer 260. For example, the first dopant 254 in the first blue emitting layer 250 may have a weight % of 1.5 to 5, and the second dopant 264 in the second blue emitting layer 260 may have a weight % of 0.5 to 3. In this instance, the OLED D1 may have a big advantage in the driving voltage, the color purity and the lifespan.

A triplet energy level of the first host 252 included in the first blue emitting layer 250, which is positioned to be closer to the first electrode 160 as an anode for injecting a hole, is higher than that of the second host 262 included in the second blue emitting layer 260, which is positioned to be closer to the second electrode 164 as a cathode for injecting an electron. For example, a triplet energy of the first host 252 may be in a range of about 1.9 to 2.1eV, and a triplet energy of the second host 262 may be in a range of about 1.6 to 1.8eV.

A triplet energy of the first dopant 254 is greater than that of the first host 252, and a triplet energy of the second dopant 264 is greater than that of the second host 262.

The organic emitting layer 162 may further include at least one of an HTL 220 disposed under the blue EML 240 and an ETL 280 disposed over the blue EML 240. Namely, the HTL 220 may be disposed between the blue EML 240 and the first electrode 160, and the ETL 280 may be disposed between the blue EML 240 and the second electrode 164.

The organic emitting layer 162 may further include at least one of an HIL 210 between the HTL 220 and the first electrode 160 and an EIL 290 between the ETL 280 and the second electrode 164.

The organic emitting layer 162 may further include at least one of an EBL 230 between the blue EML 240 and the HTL 220 and an HBL 270 between the blue EML 240 and the ETL 280.

For example, the organic emitting layer 162 may have a structure of the HIL 210, the HTL 220, the EBL 230, the first bule emitting layer 250, the second blue emitting layer 260, the HBL 270, the ETL 280 and the EIL 290 sequentially stacked on the first electrode 160. In this case, the first blue emitting layer 250 is spaced apart from the HTL 220 and contacts the EBL 230, and the second blue emitting layer 260 is spaced apparat from the ETL 280 and contacts the HBL 270.

The HIL 210 may include a hole injection material being at least one compound selected from the group consisting of 4,4' ,4" -tris(3-methylphenylamino)triphenylamine (MTDATA), 4,4' ,4" -tris(N,N-diphenyl-amino)triphenylamine (NATA), 4,4' ,4" -tris(N-(naphthalene-1-yl)-N-phenyl-amino)triphenylamine (1T-NATA), 4,4' ,4" -tris(N-(naphthalene-2-yl)-N-phenyl-amino)triphenylamine (2T-NATA), copper phthalocyanine(CuPc), tris(4-carbazoyl-9-yl-phenyl)amine (TCTA), N,N' -diphenyl-N,N' - bis(1-naphthyl)-1,1' -biphenyl-4,4" -diamine (NPB or NPD), 1,4,5,8,9,11-hexaazatriphenylenehexacarbonitrile(dipyrazino[2,3-f:2' 3' -h]quinoxaline-2,3,6,7,10,11-hexacarbonitrile (HAT-CN), 1,3,5-tris[4-(diphenylamino)phenyl]benzene (TDAPB), poly(3,4-ethylenedioxythiphene)polystyrene sulfonate (PEDOT/PSS), and N-(biphenyl-4-yl)-9,9-dimethyl-N-(4-(9-phenyl-9H-carbazol-3-yl)phenyl)-9H-fluoren-2-amine, but it is not limited thereto. For example, the hole injection material for the HIL 210 may include a compound in Formula 9 and a compound as a p-type dopant in Formula 10. In this case, the compound in Formula 10 may have a weight % of 5 to 30. The HIL 210 may have a thickness of 10 to 200 Å.

The HTL 220 may include a hole transporting material being at least one compound selected from the group consisting of N,N' -diphenyl-N,N' -bis(3-methylphenyl)-1,1' -biphenyl-4,4' -diamine (TPD), NPB (or NPD), 4,4' -bis(N-carbazolyl)-1,1' -biphenyl (CBP), poly[N,N' -bis(4-butylphenyl)-N,N' -bis(phenyl)-benzidine] (poly-TPD), (poly[(9,9-dioctylfluorenyl-2,7-diyl)-co-(4,4' -(N-(4-sec-butylphenyl)diphenylamine))] (TFB), di-[4-(N,N-di-p-tolyl-amino)-phenyl]cyclohexane (TAPC), 3,5-di(9H-carbazol-9-yl)-N,N-diphenylaniline (DCDPA), N-(biphenyl-4-yl)-9,9-dimethyl-N-(4-(9-phenyl-9H-carbazol-3-yl)phenyl)-9H-fluoren-2-amine, and N-(biphenyl-4-yl)-N-(4-(9-phenyl-9H-carbazol-3-yl)phenyl)biphenyl-4-amine, but it is not limited thereto. For example, the hole transporting material for the HTL 220 may include the compound in Formula 9. The HTL 220 may have a thickness of 500 to 1500 Å, preferably 600 to 1000 Å.

The ETL 280 may include an electron transporting material being at least one compound selected from the group consisting of tris-(8-hydroxyquinoline aluminum (Alq₃), 2-biphenyl-4-yl-5-(4-t-butylphenyl)-1,3,4-oxadiazole (PBD), spiro-PBD, lithium quinolate (Liq), 1,3,5-tris(N-phenylbenzimidazol-2-yl)benzene (TPBi), bis(2-methyl-8-quinolinolato-N1,O8)-(1,1' -biphenyl-4-olato)aluminum (BAlq), 4,7-diphenyl-1,10-phenanthroline (Bphen), 2,9-bis(naphthalene-2-yl)-4,7-diphenyl-1,10-phenanthroline (NBphen), 2,9-dimethyl-4,7-diphenyl-1,10-phenathroline (BCP), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), 1,3,5-tri(p-pyrid-3-yl-phenyl)benzene (TpPyPB), 2,4,6-tris(3' -(pyridin-3-yl)biphenyl-3-yl)1,3,5-triazine (TmPPPyTz), poly[9,9-bis(3' -((N,N-dimethyl)-N-ethylammonium)-propyl)-2,7-fluorene]-alt-2,7-(9,9-dioctylfluorene)] (PFNBr), tris(phenylquinoxaline) (TPQ), diphenyl-4-triphenylsilyl-phenylphosphine oxide (TSPO1), and 2-[4-(9,10-Di-2-naphthalen2-yl-2-anthracen-2-yl)phenyl]-1-phenyl-1H-benzimidazole (ZADN). For example, the electron transporting material for the ETL 280 may include a compound in Formula 12. The ETL 280 may have a thickness of 100 to 500 Å, preferably 100 to 300 Å.

The EIL 290 may include an electron injection material being at least one of an alkali metal, such as Li, an alkali halide compound, such as LiF, CsF, NaF, or BaF₂, and an organo-metallic compound, such as Liq, lithium benzoate, or sodium stearate. The EIL 290 may have a thickness of 5 to 40 Å, preferably 10 to 20 Å.

The EBL 230 may include an electron blocking material being at least one compound selected from the group consisting of TCTA, tris[4-(diethylamino)phenyl]amine, N-(biphenyl-4-yl)-9,9-dimethyl-N-(4-(9-phenyl-9H-carbazol-3-yl)phenyl)-9H-fluoren-2-amine, TAPC, MTDATA, 1,3-bis(carbazol-9-yl)benzene (mCP), 3,3' -bis(N-carbazolyl)-1,1' - biphenyl (mCBP), CuPc, N,N' -bis[4-[bis(3-methylphenyl)amino]phenyl]-N,N' -diphenyl-[1,1' -biphenyl]-4,4' -diamine (DNTPD), TDAPB, DCDPA, and 2,8-bis(9-phenyl-9H-carbazol-3-yl)dibenzo[b,d]thiophene). For example, the electron blocking material for the EBL 230 may include a compound in Formula 11. The EBL 230 may have a thickness of 100 to 300 Å.

The HBL 270 may include the material of the ETL 280. For example, the HBL 270 may include a hole blocking material being at least one compound selected from the group consisting of BCP, BAlq, Alq3, PBD, spiro-PBD, Liq, bis-4,6-(3,5-di-3-pyridylphenyl)-2-methylpyrimidine (B3PYMPM), bis[2-(diphenylphosphino)phenyl]ether oxide (DPEPO), 9-(6-9H-carbazol-9-yl)pyridine-3-yl)-9H-3,9'-bicarbazole, TSPO1 and the compound in Formula 12, but it is not limited thereto. The HBL 270 may have a thickness of 100 to 300 Å.

For example, when the ETL 280 includes the compound in Formula 12, the ETL 280 may have a hole blocking function as well as an electron transporting function so that the HBL 270 may be omitted. In this case, the organic emitting layer 162 has a structure of the HIL 210, the HTL 220, the EBL 230, the first bule emitting layer 250, the second blue emitting layer 260, the ETL 280 and the EIL 290 sequentially stacked on the first electrode 160. As a result, the first blue emitting layer 250 is spaced apart from the HTL 220 and contacts the EBL 230, and the second blue emitting layer 260 contacts the ETL 280.

In the OLED D1, the blue EML 240 including the first and second blue emitting layers 250 and 260 constitutes an emitting part, or the blue EML 240 including the first and second blue emitting layers 250 and 260 with at least one of the HIL 210, the HTL 220, the EBL 230, the HBL 270, the ETL 280 and the EIL 290 constitutes an emitting part.

As described above, in the OLED D1 of the present invention, the blue EML 240 includes the first blue emitting layer 250, which includes the first host 252 and the first dopant 254 and is disposed to be closer to the first electrode 160 as an anode, and the second blue emitting layer 260, which includes the second host 262 and the second dopant 264 and is disposed to be closer to the second electrode 164 as a cathode. In this case, the first host 252 includes at least one of the first host compounds represented by Formula 1, and the second host 262 includes at least one of the second host compounds represented by Formula 3. The first dopant 254 is one of the first compound represented by Formula 5 and the second compound represented by Formula 6, and the second dopant 264 is one of the third compound represented by Formula 5 and the fourth compound represented by Formula 6.

Accordingly, the OLED D1 and the organic light emitting display device 100 may have an advantage in at least one of the driving voltage, the color purity, the emitting efficiency and the lifespan.

FIG. 4 is a schematic cross-sectional view illustrating an OLED according to a third embodiment of the present invention.

As illustrated in FIG. 4, the OLED D2 includes the first and second electrodes 160 and 164 facing each other and the organic emitting layer 162 between the first and second electrodes 160 and 164. The organic emitting layer 162 includes a first emitting part 310 including a first blue EML 340 and a second emitting part 350 including a second blue EML 380. In addition, the organic emitting layer 162 may further include a charge generation layer (CGL) 390 between the first and second emitting parts 310 and 350.

The organic light emitting display device 100 (of FIG. 2) includes a red pixel, a green pixel and a blue pixel. The organic light emitting display device 100 may further include a white pixel region. The OLED D2 is positioned in the blue pixel.

One of the first and second electrodes 160 and 164 is an anode, and the other one of the first and second electrodes 160 and 164 is cathode. In addition, one of the first and second electrodes 160 and 164 may be a reflection electrode, and the other one of the first and second electrodes 160 and 164 may be a transparent (or a semi-transparent) electrode.

For example, the first electrode 160 may include a transparent conductive material layer of ITO or IZO, and the second electrode 164 may be formed of one of Al, Mg, Ag, AlMg and MgAg.

The CGL 390 is positioned between the first and second emitting parts 310 and 350, and the first emitting part 310, the CGL 390 and the second emitting part 350 are sequentially stacked on the first electrode 160. Namely, the first emitting part 310 is positioned between the first electrode 160 and the CGL 390, and the second emitting part 350 is positioned between the second electrode 164 and the CGL 390.

In the first emitting part 310, the first blue EML 340 includes a first blue emitting layer 320 being closer to the first electrode 160 and a second blue emitting layer 330 being closer to the second electrode 164 and adjacent to the first blue emitting layer 320. Namely, the second blue emitting layer 330 is disposed between the first blue emitting layer 320 and the second electrode 164 and contacts the first blue emitting layer 320.

The first blue EML 340 may have a thickness of 100 to 500 Å. A summation of a thickness of the first blue emitting layer 320 and a thickness of the second blue emitting layer 330 is equal to a thickness of the first blue EML 340, and the thickness of the first blue emitting layer 320 and the thickness of the second blue emitting layer 330 may be same or different. Each of the thickness of the first blue emitting layer 320 and the thickness of the second blue emitting layer 330 may be 10 to 250 Å, e.g., 20 to 250 Å.

In an aspect of the present invention, the thickness of the first blue emitting layer 320 may be smaller than that of the second blue emitting layer 330. For example, the first blue emitting layer 320 may have a thickness of 20 to 100 Å, and the second blue emitting layer 330 may have a thickness of 150 to 250 Å.

The first blue emitting layer 320 includes a first host 322 and a first dopant (e.g., a first emitter) 324. In the first blue emitting layer 320, the first host 322 may have a weight % (wt%) of 80 to 99.5, preferably 95 to 99.5, and the first dopant 324 may have a wt% of 0.5 to 20, preferably 0.5 to 5.

The second blue emitting layer 330 includes a second host 332 and a second dopant (e.g., a second emitter) 334. In the second blue emitting layer 330, the second host 332 may have a weight % (wt%) of 80 to 99.5, preferably 95 to 99.5, and the second dopant 334 may have a wt% of 0.5 to 20, preferably 0.5 to 5.

A weight % of the first host 322 in the first blue emitting layer 320 and a weight % of the second host 332 in the second blue emitting layer 330 may be same or different, and a weight % of the first dopant 324 in the first blue emitting layer 320 and a weight % of the second dopant 334 in the second blue emitting layer 330 may be same or different.

The first host 322 includes at least one of the first host compounds, e.g., a pyrene derivative, represented by Formula 1, and the second host 332 includes at least one of the second host compounds, e.g., an anthracene derivative, represented by Formula 3. For example, the first host 322 may include at least one of the compounds in Formula 2, and the second host 332 may include at least one of the compounds in Formula 4.

The first dopant 324 is one of a first compound represented by Formula 5 and a second compound represented by Formula 6, and the second dopant 334 is one of a third compound represented by Formula 5 and a fourth compound represented by Formula 6. Namely, i) both of the first dopant 324 and the second dopant 334 are represented by Formula 5, and the first dopant 324 and the second dopant 334 are same or different, ii) the first dopant 324 is represented by Formula 5, and the second dopant 334 is represented by Formula 6, iii) the first dopant 324 is represented by Formula 6, and the second dopant 334 is represented by Formula 5, or iv) both of the first dopant 324 and the second dopant 334 are represented by Formula 6, and the first dopant 324 and the second dopant 334 are same or different.

The first dopant 324 may include one of the compound represented by Formula 5 and the compound represented by Formula 6, and the second dopant 334 may include the other one of the compound represented by Formula 5 and the compound represented by Formula 6. For example, the compound represented by Formula 5 may have a weight % of 0.5 to 3, and the compound represented by Formula 6 may have a weight % of 1.5 to 5.

In an aspect of the present invention, the first dopant 324 may include the first compound represented by Formula 5, and the second dopant 334 may include the fourth compound represented by Formula 6. A weight % of the first dopant 324 in the first blue emitting layer 320 may be smaller than that of the second dopant 334 in the second blue emitting layer 330. For example, the first dopant 324 in the first blue emitting layer 320 may have a weight % of 0.5 to 3, and the second dopant 334 in the second blue emitting layer 330 may have a weight % of 1.5 to 5. In this instance, the OLED D2 may have a big advantage in the driving voltage, the emitting efficiency and the lifespan.

In an aspect of the present invention, the first dopant 324 may include the second compound represented by Formula 6, and the second dopant 334 may include the third compound represented by Formula 5. A weight % of the first dopant 324 in the first blue emitting layer 320 may be greater than that of the second dopant 334 in the second blue emitting layer 330. For example, the first dopant 324 in the first blue emitting layer 320 may have a weight % of 1.5 to 5, and the second dopant 334 in the second blue emitting layer 330 may have a weight % of 0.5 to 3. In this instance, the OLED D2 may have a big advantage in the driving voltage, the color purity and the lifespan.

The first emitting part 310 may further include at least one of a first HTL 313 disposed under the first blue EML 340 and a first ETL 319 disposed over the first blue EML 340. Namely, the first HTL 313 may be disposed between the first blue EML 340 and the first electrode 160, and the first ETL 319 may be disposed between the first blue EML 340 and the second electrode 164.

The first emitting part 310 may further include an HIL 311 between the first HTL 313 and the first electrode 160.

The first emitting part 310 may further include at least one of a first EBL 315 between the first blue EML 340 and the first HTL 313 and a first HBL 317 between the first blue EML 340 and the first ETL 319.

For example, the first emitting part 310 may have a structure of the HIL 311, the first HTL 313, the first EBL 315, the first bule emitting layer 320, the second blue emitting layer 330, the first HBL 317 and the first ETL 319 sequentially stacked on the first electrode 160. In this case, the first blue emitting layer 320 is spaced apart from the first HTL 313 and contacts the first EBL 315, and the second blue emitting layer 330 is spaced apart from the first ETL 319 and contacts the first HBL 317.

The first ETL 319 may have a hole blocking function as well as an electron transporting function so that the first HBL 317 may be omitted. In this case, the first emitting part 310 has a structure of the HIL 311, the first HTL 313, the first EBL 315, the first bule emitting layer 320, the second blue emitting layer 330 and the first ETL 319 sequentially stacked on the first electrode 160. As a result, the first blue emitting layer 320 is spaced apart from the first HTL 313 and contacts the first EBL 315, and the second blue emitting layer 330 contacts the first ETL 319.

In the second emitting part 350, the second blue EML 380 includes a third blue emitting layer 360, which is disposed to be closer to the first electrode 160, and a fourth blue emitting layer 370, which is disposed to be closer to the second electrode 164 and is adjacent to the third blue emitting layer 360. Namely, the fourth blue emitting layer 370 is positioned between the third blue emitting layer 360 and the second electrode 164 and contacts the third blue emitting layer 360.

The second blue EML 380 may have a thickness of 100 to 500 Å. A summation of a thickness of the third blue emitting layer 360 and a thickness of the fourth blue emitting layer 370 is equal to a thickness of the second blue EML 380, and the thickness of the third blue emitting layer 360 and the thickness of the fourth blue emitting layer 370 may be same or different. Each of the thickness of the third blue emitting layer 360 and the thickness of the fourth blue emitting layer 370 may be 10 to 250 Å, e.g., 20 to 250 Å.

In an aspect of the present invention, the thickness of the third blue emitting layer 360 may be smaller than that of the fourth blue emitting layer 370. For example, the third blue emitting layer 360 may have a thickness of 20 to 100 Å, and the fourth blue emitting layer 370 may have a thickness of 150 to 250 Å.

The third blue emitting layer 360 includes a third host 362 and a third dopant (e.g., a third emitter) 364. In the third blue emitting layer 360, the third host 362 may have a weight % (wt%) of 80 to 99.5, preferably 95 to 99.5, and the third dopant 364 may have a wt% of 0.5 to 20, preferably 0.5 to 5.

The fourth blue emitting layer 370 includes a fourth host 372 and a fourth dopant (e.g., a fourth emitter) 374. In the fourth blue emitting layer 370, the fourth host 372 may have a weight % (wt%) of 80 to 99.5, preferably 95 to 99.5, and the fourth dopant 374 may have a wt% of 0.5 to 20, preferably 0.5 to 5.

A weight % of the third host 362 in the third blue emitting layer 360 and a weight % of the fourth host 372 in the fourth blue emitting layer 370 may be same or different, and a weight % of the third dopant 364 in the third blue emitting layer 360 and a weight % of the fourth dopant 374 in the fourth blue emitting layer 370 may be same or different.

The third host 362 includes at least one of the first host compounds, e.g., a pyrene derivative, represented by Formula 1, and the fourth host 372 includes at least one of the second host compounds, e.g., an anthracene derivative, represented by Formula 3. For example, the third host 362 may include at least one of the compounds in Formula 2, and the fourth host 372 may include at least one of the compounds in Formula 4.

The third dopant 364 is one of a first compound represented by Formula 5 and a second compound represented by Formula 6, and the fourth dopant 374 is one of a third compound represented by Formula 5 and a fourth compound represented by Formula 6. Namely, i) both of the third dopant 364 and the fourth dopant 374 are represented by Formula 5, and the third dopant 364 and the fourth dopant 374 are same or different, ii) the third dopant 364 is represented by Formula 5, and the fourth dopant 374 is represented by Formula 6, iii) the third dopant 364 is represented by Formula 6, and the fourth dopant 374 is represented by Formula 5, or iv) both of the third dopant 364 and the fourth dopant 374 are represented by Formula 6, and the third dopant 364 and the fourth dopant 374 are same or different.

The third dopant 364 may include one of the compound represented by Formula 5 and the compound represented by Formula 6, and the fourth dopant 374 may include the other one of the compound represented by Formula 5 and the compound represented by Formula 6. For example, the compound represented by Formula 5 may have a weight % of 0.5 to 3, and the compound represented by Formula 6 may have a weight % of 1.5 to 5.

In an aspect of the present invention, the third dopant 364 may include the first compound represented by Formula 5, and the fourth dopant 374 may include the fourth compound represented by Formula 6. A weight % of the third dopant 364 in the third blue emitting layer 360 may be smaller than that of the fourth dopant 374 in the fourth blue emitting layer 370. For example, the third dopant 364 in the third blue emitting layer 360 may have a weight % of 0.5 to 3, and the fourth dopant 374 in the fourth blue emitting layer 370 may have a weight % of 1.5 to 5. In this instance, the OLED D2 may have a big advantage in the driving voltage, the emitting efficiency and the lifespan.

In an aspect of the present invention, the third dopant 364 may include the second compound represented by Formula 6, and the fourth dopant 374 may include the third compound represented by Formula 5. A weight % of the third dopant 364 in the third blue emitting layer 360 may be greater than that of the fourth dopant 374 in the fourth blue emitting layer 370. For example, the third dopant 364 in the third blue emitting layer 360 may have a weight % of 1.5 to 5, and the fourth dopant 374 in the fourth blue emitting layer 370may have a weight % of 0.5 to 3. In this instance, the OLED D2 may have a big advantage in the driving voltage, the color purity and the lifespan.

The second emitting part 350 may further include at least one of a second HTL 351 disposed under the second blue EML 380 and a second ETL 357 disposed over the second blue EML 380. Namely, the second HTL 351 is positioned between the second blue EML 380 and the first emitting part 310, and the second ETL 357 is positioned between the second blue EML 380 and the second electrode 164.

The second emitting part 350 may further include an EIL 359 between the second ETL 357 and the second electrode 164.

The second emitting part 350 may further include a second EBL 353 between the second blue EML 380 and the second HTL 351 and a second HBL 355 between the second blue EML 380 and the second ETL 357.

For example, the second emitting part 350 may have a structure of the second HTL 351, the second EBL 353, the third blue emitting layer 360, the fourth blue emitting layer 370, the second HBL 355, the second ETL 357 and the EIL 359. In this instance, the third blue emitting layer 360 is spaced apart from the second HTL 351 and contacts the second EBL 353, and the fourth blue emitting layer 370 is spaced apart from the second ETL 357 and contacts the second HBL 355.

The second ETL 357 may have a hole blocking function as well as an electron transporting function so that the second HBL 355 may be omitted. In this case, the second emitting part 350 has a structure of the second HTL 351, the second EBL 353, the third blue emitting layer 360, the fourth blue emitting layer 370, the second ETL 357 and the EIL 359. As a result, the third blue emitting layer 360 is spaced apart from the second HTL 351 and contacts the second EBL 353, and the fourth blue emitting layer 370 contacts the second ETL 357.

The HIL 311 may include the above-mentioned hole injection material and may have a thickness of 10 to 200 Å.

Each of the first and second HTLs 313 and 351 may include the above-mentioned hole transporting material and may have a thickness of 500 to 1500 Å, preferably 600 to 1000 Å.

Each of the first and second ETLs 319 and 357 may include the above-mentioned electron transporting material and may have a thickness of 100 to 500 Å, preferably 100 to 300 Å.

The EIL 359 may include the above-mentioned electron injection material and may have a thickness of 5 to 40 Å, preferably 10 to 20 Å.

Each of the first and second EBLs 315 and 353 may include the above-mentioned electron blocking material and may have a thickness of 10 to 300 Å.

Each of the first and second HBLs 317 and 355 may include the above-mentioned hole blocking material and may have a thickness of 10 to 300 Å.

The CGL 390 is positioned between the first and second emitting parts 310 and 350. Namely, the first and second emitting parts 310 and 350 are connected through the CGL 390. The CGL 390 may be a P-N junction CGL of an N-type CGL 392 and a P-type CGL 394.

The N-type CGL 392 is positioned between the first ETL 319 and the second HTL 351, and the P-type CGL 394 is positioned between the N-type CGL 392 and the second HTL 351.

The N-type CGL 392 may be an organic layer doped with an alkali metal, e.g., Li, Na, K and Cs, and/or an alkali earth metal, e.g., Mg, Sr, Ba and Ra. For example, the N-type CGL 392 may be formed of an N-type charge generation material including a host being the organic material, e.g., 4,7-dipheny-1,10-phenanthroline (Bphen) and MTDATA, a dopant being an alkali metal and/or an alkali earth metal, and the dopant may be doped with a weight % of 0.01 to 30.

The P-type CGL 394 may be formed of a P-type charge generation material including an inorganic material, e.g., tungsten oxide (WOx), molybdenum oxide (MoOx), beryllium oxide (Be2O3) and vanadium oxide (V2O5), an organic material, e.g., NPD, HAT-CN, F4TCNQ, TPD, TNB, TCTA and N,N'-dioctyl-3,4,9,10-perylenedicarboximide (PTCDI-C8). For example, the P-type charge generation material for the P-type CGL 394 may include a compound in Formula 9 and a compound in Formula 10 as a p-type dopant, and the compound in Formula 10 may have a weight % of 5 to 30.

In FIG. 4, the first blue EML 340 has a double-layered structure including the first and second blue emitting layers 320 and 330, and the second blue EML 380 has a double-layered structure including the third and fourth blue emitting layers 360 and 370.

Alternatively, one of the first and second blue EMLs 340 and 380 may have a double-layered structure, while the other one of the first and second blue EMLs 340 and 380 may have a single-layered structure. In this instance, the other one of the first and second blue EMLs 340 and 380 may include a blue host and a blue dopant.

For example, the blue host may be selected from the group consisting of mCP, 9-(3-(9H-carbazol-9-yl)phenyl)-9H-carbazole-3-carbonitrile (mCP-CN), mCBP, CBP-CN, 9-(3-(9H-Carbazol-9-yl)phenyl)-3-(diphenylphosphoryl)-9H-carbazole (mCPPO1) 3,5-Di(9H-carbazol-9-yl)biphenyl (Ph-mCP), TSPO1, 9-(3'-(9H-carbazol-9-yl)-[1,1'-biphenyl]-3-yl)-9H-pyrido[2,3-b]indole (CzBPCb), bis(2-methylphenyl)diphenylsilane (UGH-1), 1,4-bis(triphenylsilyl)benzene (UGH-2), 1,3-bis(triphenylsilyl)benzene (UGH-3), 9,9-spiorobifluoren-2-yl-diphenyl-phosphine oxide (SPPO1) and 9,9'-(5-(triphenylsilyl)-1,3-phenylene)bis(9H-carbazole) (SimCP).

The blue dopant may be selected from the group consisting of perylene, 4,4'-bis[4-(di-p-tolylamino)styryl]biphenyl (DPAVBi), 4-(di-p-tolylamino)-4-4'-[(di-p-tolylamino)styryl]stilbene (DPAVB), 4,4'-bis[4-(diphenylamino)styryl]biphenyl (BDAVBi), 2,7-bis(4-diphenylamino)styryl)-9,9-spiorfluorene (spiro-DPVBi), [1,4-bis[2-[4-[N,N-di(p-tolyl)amino]phenyl]vinyl] benzene (DSB), 1,4-di-[4-(N,N-diphenyl)amino]styryl-benzene (DSA), 2,5,8,11-tetra-tetr-butylperylene (TBPe), bis(2-hydroxylphenyl)-pyridine)beryllium (Bepp2), 9-(9-Phenylcarbazole-3-yl)-10-(naphthalene-1-yl)anthracene (PCAN), mer-tris(1-phenyl-3-methylimidazolin-2-ylidene-C,C(2)'iridium(III) (mer-Ir(pmi)3), fac-Tris(1,3-diphenyl-benzimidazolin-2-ylidene-C,C(2)'iridium(III) (fac-Ir(dpbic)3), bis(3,4,5-trifluoro-2-(2-pyridyl)phenyl-(2-carboxypyridyl)iridium(III) (Ir(tfpd)2pic), tris(2-(4,6-difluorophenyl)pyridine))iridium(III) (Ir(Fppy)3) and bis[2-(4,6-difluorophenyl)pyridinato-C2,N](picolinato)iridium(III) (FIrpic).

The OLED D2 of the present invention includes the first emitting part 310 including the first blue EML 340 and the second emitting part 350 including the second blue EML 380, and at least one of the first and second blue EMLs 340 and 380 includes a first blue emitting layer including a first host and a first dopant and a second blue emitting layer including a second host and a second dopant. In this case, the first host includes at least one of the first host compounds represented by Formula 1, and the second host includes at least one of the second host compounds represented by Formula 3, and each of the first and second dopants independently includes the compound represented by Formula 5 or the compound represented by Formula 6.

Accordingly, the OLED D2 and the organic light emitting display device 100 have an advantages in at least one of the driving voltage, the color purity, the emitting efficiency and the lifespan.

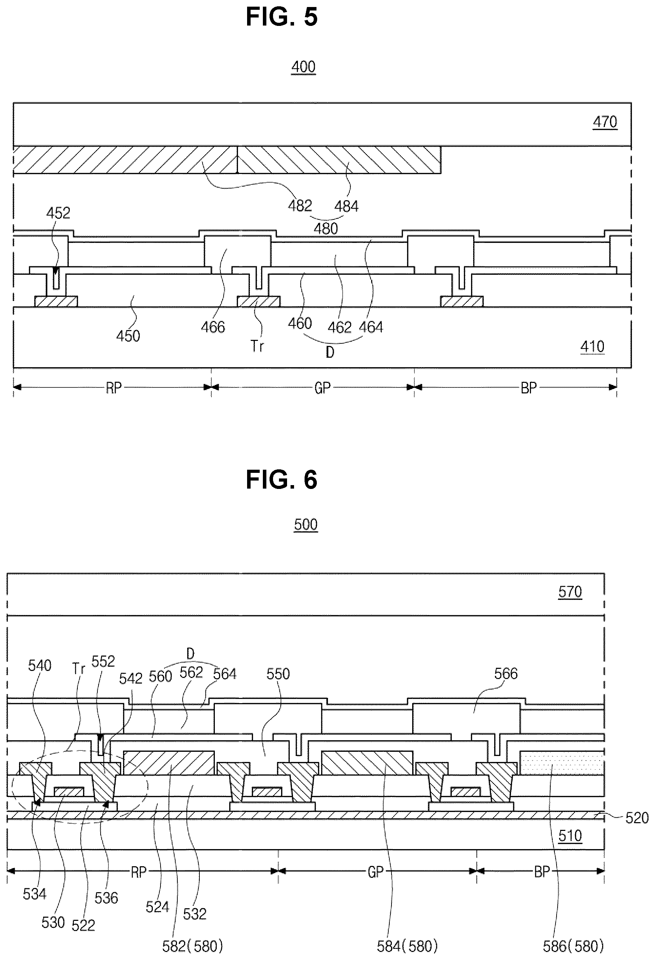

FIG. 5 is a schematic cross-sectional view illustrating an organic light emitting display device according to a fourth embodiment of the present invention.

As illustrated in FIG. 5, the organic light emitting display device 400 includes a first substrate 410, where a red pixel RP, a green pixel GP and a blue pixel BP are defined, a second substrate 470 facing the first substrate 410, an OLED D, which is positioned between the first and second substrates 410 and 470 and providing white emission, and a color conversion layer 480 between the OLED D and the second substrate 470.

Although not shown, a color filter may be formed between the second substrate 470 and each color conversion layer 480.

Each of the first and second substrates 410 and 470 may be a glass substrate or a flexible substrate. For example, each of the first and second substrates 410 and 470 may be a polyimide (PI) substrate, a polyethersulfone (PES) substrate, a polyethylenenaphthalate (PEN) substrate, a polyethylene terephthalate (PET) substrate or a polycarbonate (PC) substrate.

A TFT Tr, which corresponding to each of the red, green and blue pixels RP, GP and BP, is formed on the first substrate 410, and a planarization layer 450, which has a drain contact hole 452 exposing an electrode, e.g., a drain electrode, of the TFT Tr is formed to cover the TFT Tr.

The OLED D including a first electrode 460, an organic emitting layer 462 and a second electrode 464 is formed on the planarization layer 450. In this instance, the first electrode 460 may be connected to the drain electrode of the TFT Tr through the drain contact hole 452.

A bank layer 466 is formed on the planarization layer 450 to cover an edge of the first electrode 460. Namely, the bank layer 466 is positioned at a boundary of the pixel and exposes a center of the first electrode 460 in the pixel.

The OLED D emits a blue light and may have a structure shown in FIG. 3 or FIG. 4. Namely, the OLED D is formed in each of the red, green and blue pixels RP, GP and BP and provides the blue light.

For example, referring to FIG. 3, the organic emitting layer 462 of the OLED D includes the blue EML 240 including the first blue emitting layer 250, which is disposed to be closer to the first electrode 160 as an anode, and the second blue emitting layer 260, which is disposed to be closer to the second electrode 164 as a cathode. The first blue emitting layer 250 includes the first host 252 and the first dopant 254, and the second blue emitting layer 260 includes the second host 262 and the second dopant 264. In this case, the first host 252 includes at least one of the first host compounds represented by Formula 1, the second host 262 includes at least one of the second host compounds represented by Formula 3. The first dopant 254 is one of the first compound represented by Formula 5 and the second compound represented by Formula 6, and the second dopant 264 is one of the third compound represented by Formula 5 and the fourth compound represented by Formula 6.

The color conversion layer 480 includes a first color conversion layer 482 corresponding to the red pixel RP and a second color conversion layer 484 corresponding to the green pixel GP. For example, the color conversion layer 480 may include an inorganic color conversion material such as a quantum dot.

The blue light from the OLED D is converted into the red light by the first color conversion layer 482 in the red pixel RP, and the blue light from the OLED D is converted into the green light by the second color conversion layer 484 in the green pixel GP.

Accordingly, the organic light emitting display device 400 can display a full-color image.

A color filter layer may be disposed between the second substrate 470 and the color conversion layer 480. The color filter layer may include a red color filter and a green color filter respectively corresponding to the red and green pixel regions.

On the other hand, when the light from the OLED D passes through the first substrate 410, the color conversion layer 480 is disposed between the OLED D and the first substrate 410. In this case, the color filter layer may be disposed between the first substrate 410 and the color conversion layer 480.

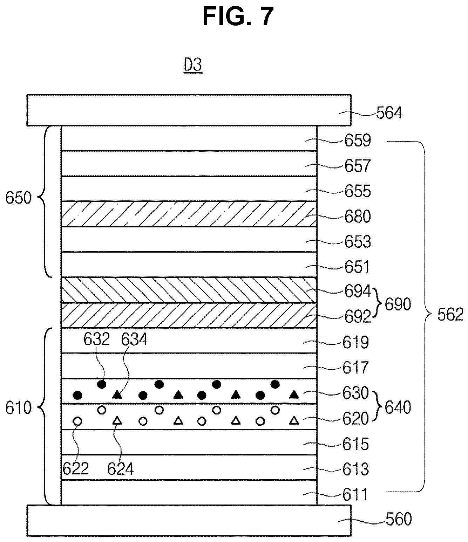

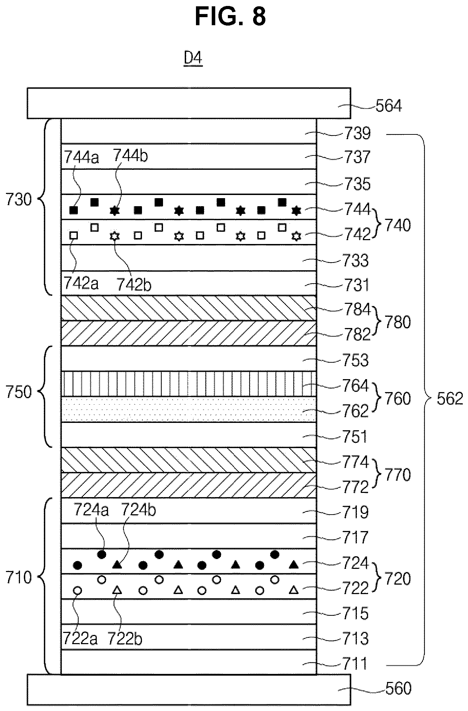

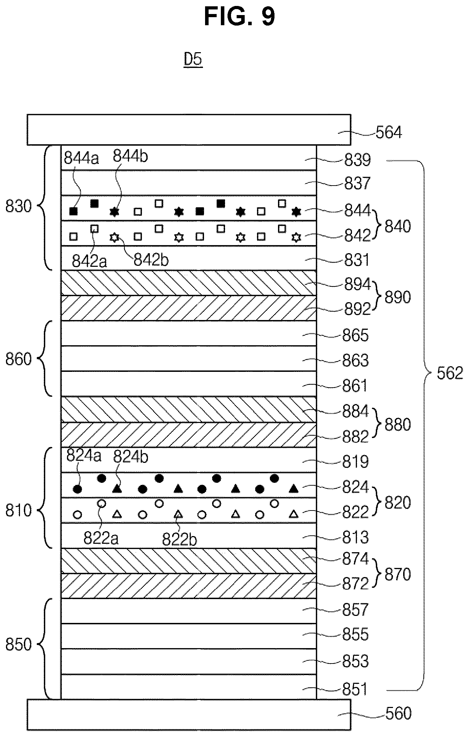

FIG. 6 is a schematic cross-sectional view illustrating an organic light emitting display device according to a fifth embodiment of the present invention. FIG. 7 is a schematic cross-sectional view illustrating an OLED according to a sixth embodiment of the present invention, FIG. 8 is a schematic cross-sectional view illustrating an OLED according to a seventh embodiment of the present invention, and FIG. 9 is a schematic cross-sectional view illustrating an OLED according to an eighth embodiment.

As illustrated in FIG. 6, the organic light emitting display device 500 includes a first substrate 510, where a red pixel RP, a green pixel GP and a blue pixel BP are defined, a second substrate 570 facing the first substrate 510, an OLED D, which is positioned between the first and second substrates 510 and 570 and providing white emission, and a color filter layer 580 between the OLED D and the first substrate 510.

Each of the first and second substrates 510 and 570 may be a glass substrate or a flexible substrate. For example, each of the first and second substrates 510 and 570 may be a polyimide (PI) substrate, a polyethersulfone (PES) substrate, a polyethylenenaphthalate (PEN) substrate, a polyethylene terephthalate (PET) substrate or a polycarbonate (PC) substrate.

A buffer layer 520 is formed on the substrate, and the TFT Tr corresponding to each of the red, green and blue pixels RP, GP and BP is formed on the buffer layer 520. The buffer layer 520 may be omitted.

A semiconductor layer 522 is formed on the buffer layer 520. The semiconductor layer 522 may include an oxide semiconductor material or polycrystalline silicon.

A gate insulating layer 524 is formed on the semiconductor layer 522. The gate insulating layer 524 may be formed of an inorganic insulating material such as silicon oxide or silicon nitride.

A gate electrode 530, which is formed of a conductive material, e.g., metal, is formed on the gate insulating layer 524 to correspond to a center of the semiconductor layer 522.

An interlayer insulating layer 532, which is formed of an insulating material, is formed on the gate electrode 530. The interlayer insulating layer 532 may be formed of an inorganic insulating material, e.g., silicon oxide or silicon nitride, or an organic insulating material, e.g., benzocyclobutene or photo-acryl.

The interlayer insulating layer 532 includes first and second contact holes 534 and 536 exposing both sides of the semiconductor layer 522. The first and second contact holes 534 and 536 are positioned at both sides of the gate electrode 530 to be spaced apart from the gate electrode 530.

A source electrode 540 and a drain electrode 542, which are formed of a conductive material, e.g., metal, are formed on the interlayer insulating layer 532.

The source electrode 540 and the drain electrode 542 are spaced apart from each other with respect to the gate electrode 530 and respectively contact both sides of the semiconductor layer 522 through the first and second contact holes 534 and 536.

The semiconductor layer 522, the gate electrode 530, the source electrode 540 and the drain electrode 542 constitute the TFT Tr. The TFT Tr serves as a driving element. Namely, the TFT Tr may correspond to the driving TFT Td (of FIG. 1).

The color filter layer 580 is formed on the interlayer insulating layer 532. The color filter layer 580 includes red, green and blue color filters 582, 584 and 586 respectively corresponding to the red, green and blue pixel regions RP, GP and BP.

Although not shown, the gate line and the data line cross each other to define the pixel, and the switching TFT is formed to be connected to the gate and data lines. The switching TFT is connected to the TFT Tr as the driving element.

In addition, the power line, which may be formed to be parallel to and spaced apart from one of the gate and data lines, and the storage capacitor for maintaining the voltage of the gate electrode of the TFT Tr in one frame may be further formed.

A planarization layer 550, which includes a drain contact hole 552 exposing the drain electrode 542 of the TFT Tr, is formed to cover the color filter layer 580 and the TFT Tr.

A first electrode 560, which is connected to the drain electrode 542 of the TFT Tr through the drain contact hole 552, is separately formed in each pixel and on the planarization layer 550. The first electrode 560 may be an anode and may be formed of a conductive material having a relatively high work function. For example, the first electrode 560 may be formed of a transparent conductive material, e.g., ITO or IZO.

A bank layer 566 is formed on the planarization layer 550 to cover an edge of the first electrode 560. Namely, the bank layer 566 is positioned at a boundary of the pixel and exposes a center of the first electrode 560 in the pixel.

An organic emitting layer 562 is formed on the first electrode 560.

Referring to FIG. 7, the OLED D3 includes the first electrode 560, the second electrode 564 and the organic emitting layer 562 therebetween, and the organic emitting layer 562 includes a first emitting part 610 including a first EML 640 and a second emitting part 650 including a second EML 680. In addition, the organic emitting layer 562 may further include a charge generation layer (CGL) 690 between the first and second emitting parts 610 and 650.

The OLED D3 is positioned to correspond to all of the red, green and blue pixel regions RP, GP and BP.

The CGL 690 is positioned between the first and second emitting parts 610 and 650, and the first emitting part 610, the CGL 690 and the second emitting part 650 are sequentially stacked on the first electrode 560. Namely, the first emitting part 610 is positioned between the first electrode 560 and the CGL 690, and the second emitting part 650 is positioned between the second electrode 564 and the CGL 690.

The first EML 640 in the first emitting part 610 is a blue EML. The first EML 640 includes a first blue emitting layer 620 being closer to the first electrode 560 and a second blue emitting layer 630 being closer to the second electrode 564 and adjacent to the first blue emitting layer 620. Namely, the second blue emitting layer 630 is disposed between the first blue emitting layer 620 and the second electrode 564 and contacts the first blue emitting layer 620.

The first EML 640 may have a thickness of 100 to 500 Å. A summation of a thickness of the first blue emitting layer 620 and a thickness of the second blue emitting layer 630 is equal to a thickness of the first EML 640, and the thickness of the first blue emitting layer 620 and the thickness of the second blue emitting layer 630 may be same or different. Each of the thickness of the first blue emitting layer 620 and the thickness of the second blue emitting layer 630 may be 10 to 250 Å, e.g., 20 to 250 Å.

In an aspect of the present invention, the thickness of the first blue emitting layer 620 may be smaller than that of the second blue emitting layer 630. For example, the first blue emitting layer 620 may have a thickness of 20 to 100 Å, and the second blue emitting layer 630 may have a thickness of 150 to 250 Å.

The first blue emitting layer 620 includes a first host 622 and a first dopant (e.g., a first emitter) 624. In the first blue emitting layer 620, the first host 622 may have a weight % (wt%) of 80 to 99.5, preferably 95 to 99.5, and the first dopant 624 may have a wt% of 0.5 to 20, preferably 0.5 to 5.

The second blue emitting layer 630 includes a second host 632 and a second dopant (e.g., a second emitter) 634. In the second blue emitting layer 630, the second host 632 may have a weight % (wt%) of 80 to 99.5, preferably 95 to 99.5, and the second dopant 634 may have a wt% of 0.5 to 20, preferably 0.5 to 5.

A weight % of the first host 622 in the first blue emitting layer 620 and a weight % of the second host 632 in the second blue emitting layer 630 may be same or different, and a weight % of the first dopant 624 in the first blue emitting layer 620 and a weight % of the second dopant 634 in the second blue emitting layer 630 may be same or different.

The first host 622 includes at least one of the first host compounds, e.g., a pyrene derivative, represented by Formula 1, and the second host 632 includes at least one of the second host compounds, e.g., an anthracene derivative, represented by Formula 3. For example, the first host 622 may include at least one of the compounds in Formula 2, and the second host 632 may include at least one of the compounds in Formula 4.

The first dopant 624 is one of a first compound represented by Formula 5 and a second compound represented by Formula 6, and the second dopant 634 is one of a third compound represented by Formula 5 and a fourth compound represented by Formula 6. Namely, i) both of the first dopant 624 and the second dopant 634 are represented by Formula 5, and the first dopant 624 and the second dopant 634 are same or different, ii) the first dopant 624 is represented by Formula 5, and the second dopant 634 is represented by Formula 6, iii) the first dopant 624 is represented by Formula 6, and the second dopant 634 is represented by Formula 5, or iv) both of the first dopant 624 and the second dopant 634 are represented by Formula 6, and the first dopant 624 and the second dopant 634 are same or different.

The first dopant 624 may include one of the compound represented by Formula 5 and the compound represented by Formula 6, and the second dopant 634 may include the other one of the compound represented by Formula 5 and the compound represented by Formula 6. For example, the compound represented by Formula 5 may have a weight % of 0.5 to 3, and the compound represented by Formula 6 may have a weight % of 1.5 to 5.

In an aspect of the present invention, the first dopant 624 may include the first compound represented by Formula 5, and the second dopant 634 may include the fourth compound represented by Formula 6. A weight % of the first dopant 624 in the first blue emitting layer 620 may be smaller than that of the second dopant 634 in the second blue emitting layer 630. For example, the first dopant 624 in the first blue emitting layer 620 may have a weight % of 0.5 to 3, and the second dopant 634 in the second blue emitting layer 630 may have a weight % of 1.5 to 5. In this instance, the OLED D3 may have a big advantage in the driving voltage, the emitting efficiency and the lifespan.

In an aspect of the present invention, the first dopant 624 may include the second compound represented by Formula 6, and the second dopant 634 may include the third compound represented by Formula 5. A weight % of the first dopant 624 in the first blue emitting layer 620 may be greater than that of the second dopant 634 in the second blue emitting layer 630. For example, the first dopant 624 in the first blue emitting layer 620 may have a weight % of 1.5 to 5, and the second dopant 634 in the second blue emitting layer 630 may have a weight % of 0.5 to 3. In this instance, the OLED D3 may have a big advantage in the driving voltage, the color purity and the lifespan.

The first emitting part 610 may further include at least one of a first HTL 613 disposed under the first EML 640 and a first ETL 619 disposed over the first EML 640. Namely, the first HTL 613 may be disposed between the first EML 640 and the first electrode 560, and the first ETL 619 may be disposed between the first EML 640 and the second electrode 564.

The first emitting part 610 may further include an HIL 611 between the first HTL 613 and the first electrode 560

The first emitting part 610 may further include at least one of a first EBL 615 between the first EML 640 and the first HTL 613 and a first HBL 617 between the first EML 640 and the first ETL 619.

For example, the first emitting part 610 may have a structure of the HIL 611, the first HTL 613, the first EBL 615, the first bule emitting layer 620, the second blue emitting layer 630, the first HBL 617 and the first ETL 619 sequentially stacked on the first electrode 560. In this case, the first blue emitting layer 620 is spaced apart from the first HTL 613 and contacts the first EBL 615, and the second blue emitting layer 630 is spaced apparat from the first ETL 619 and contacts the first HBL 617.

The first ETL 619 may have a hole blocking function as well as an electron transporting function so that the first HBL 617 may be omitted. In this case, the first emitting part 610 has a structure of the HIL 611, the first HTL 613, the first EBL 615, the first bule emitting layer 620, the second blue emitting layer 630 and the first ETL 619 sequentially stacked on the first electrode 560. As a result, the first blue emitting layer 620 is spaced apart from the first HTL 613 and contacts the first EBL 615, and the second blue emitting layer 630 contacts the first ETL 619.

The second EML 680 in the second emitting part 650 may be a yellow-green EML. The second EML 680 may include a yellow-green host and a yellow-green dopant. For example, the yellow-green dopant may be one of a fluorescent compound, a phosphorescent compound and a delayed fluorescent compound.

In the second EML 680, the yellow-green host may have a weight % of about 70 to 99.9, and the yellow-green dopant may have a weight % of about 0.1 to 10, preferably about 1 to 5.

For example, the yellow-green host may be selected from the group consisting of mCP-CN, CBP, mCBP, mCP, DPEPO, 2,8-bis(diphenylphosphoryl)dibenzothiophene (PPT), TmPyPB, PYD-2Cz, 2,8-di(9H-carbazol-9-yl)dibenzothiophene (DCzDBT), 3',5'-di(carbazol-9-yl)-[1,1'-bipheyl]-3,5-dicarbonitrile (DCzTPA), 4'-(9H-carbazol-9-yl)biphenyl-3,5-dicarbonitrile(4'-(9H-carbazol-9-yl)biphenyl-3,5-dicarbonitrile (pCzB-2CN), 3'-(9H-carbazol-9-yl)biphenyl-3,5-dicarbonitrile (mCzB-2CN), TSPO1, and 9-(9-phenyl-9H-carbazol-6-yl)-9H-carbazole (CCP), but it is not limited thereto.

For example, the yellow-green dopant may be selected from the group consisting of 5,6,11,12-tetraphenylnaphthalene (Rubrene), 2,8-di-tert-butyl-5,11-bis(4-tert-butylphenyl)-6,12-diphenyltetracene (TBRb), bis(2-phenylbenzothiazolato)(acetylacetonate)irdium(III) (Ir(BT)2(acac)), bis(2-(9,9-diethytl-fluoren-2-yl)-1-phenyl-1H-benzo[d]imdiazolato)(acetylacetonate)iridium(III) (Ir(fbi)2(acac)), bis(2-phenylpyridine)(3-(pyridine-2-yl)-2H-chromen-2-onate)iridium(III) (fac-Ir(ppy)2Pc), bis(2-(2,4-difluorophenyl)quinoline)(picolinate)iridium(III) (FPQIrpic), and bis(4-phenylthieno[3,2-c]pyridinato-N,C2') (acetylacetonate) iridium(III) (PO-01), but it is not limited thereto.

The second emitting part 650 may further include at least one of a second HTL 651 disposed under the second EML 680 and a second ETL 657 disposed over the second EML 680. Namely, the second HTL 651 is positioned between the second EML 680 and the first emitting part 610, and the second ETL 657 is positioned between the second EML 680 and the second electrode 564.

The second emitting part 650 may further include an EIL 659 between the second ETL 657 and the second electrode 564.

The second emitting part 650 may further include a second EBL 653 between the second EML 680 and the second HTL 651 and a second HBL 655 between the second EML 680 and the second ETL 657.

The HIL 611 may include the above-mentioned hole injection material and may have a thickness of 10 to 200 Å.

Each of the first and second HTLs 613 and 651 may include the above-mentioned hole transporting material and may have a thickness of 500 to 1500 Å, preferably 700 to 1300 Å.

Each of the first and second ETLs 619 and 657 may include the above-mentioned electron transporting material and may have a thickness of 500 to 1500 Å, preferably 600 to 1000 Å.

The EIL 659 may include the above-mentioned electron injection material and may have a thickness of 5 to 40 Å, preferably 10 to 20 Å.

Each of the first and second EBLs 615 and 653 may include the above-mentioned electron blocking material and may have a thickness of 10 to 300 Å.

Each of the first and second HBLs 617 and 655 may include the above-mentioned hole blocking material and may have a thickness of 10 to 300 Å.

The CGL 690 is positioned between the first and second emitting parts 610 and 650. Namely, the first and second emitting parts 610 and 650 are connected through the CGL 690. The CGL 690 may be a P-N junction CGL of an N-type CGL 692 and a P-type CGL 694.

The N-type CGL 692 is positioned between the first ETL 619 and the second HTL 651, and the P-type CGL 694 is positioned between the N-type CGL 692 and the second HTL 651.

The N-type CGL 692 may include the above-mentioned N-type charge generation material, and the P-type CGL 694 may include the above-mentioned P-type charge generation material.

In FIG. 7, the first EML 640 between the first electrode 560 and the CGL 690 is the blue EML including the first and second blue emitting layers 620 and 630, while the second EML 680 between the second electrode 564 and the CGL 690 is the yellow-green EML.

Alternatively, the first EML 640 between the first electrode 560 and the CGL 690 may be the yellow-green EML, while the second EML 680 between the second electrode 564 and the CGL 690 may be the blue EML including the first and second blue emitting layers 620 and 630.

In the OLED D3, the first EML 640 includes the first blue emitting layer 620, which includes the first host 622 and the first dopant 624 and is disposed to be closer to the first electrode 560 as an anode, and the second blue emitting layer 630, which includes the second host 632 and the second dopant 634 and is disposed to be closer to the second electrode 564 as a cathode. In this case, the first host 622 includes at least one of the first host compounds represented by Formula 1, and the second host 632 includes at least one of the second host compounds represented by Formula 3. The first dopant 624 is one of the first compound represented by Formula 5 and the second compound represented by Formula 6, and the second dopant 634 is one of the third compound represented by Formula 5 and the fourth compound represented by Formula 6.

Accordingly, the OLED D3 and the organic light emitting display device 100 have an advantages in at least one of the driving voltage, the color purity, the emitting efficiency and the lifespan.

In addition, the OLED D3 including the first emitting part 610, which emits a blue light, and the second emitting part 650, which emits a yellow-green light, can provide a white light.

Referring to FIG. 8, the OLED D4 includes the first electrode 560, the second electrode 564 and the organic emitting layer 562 therebetween, and the organic emitting layer 562 includes a first emitting part 710 including a first EML 720, a second emitting part 730 including a second EML 740 and a third emitting part 750 including a third EML 760. In addition, the organic emitting layer 562 may further include a first CGL 770 between the first and third emitting parts 710 and 750 and a second CGL 780 between the second and third emitting parts 730 and 750.

The OLED D4 is positioned to correspond to all of the red, green and blue pixel regions RP, GP and BP.

The first CGL 770 is positioned between the first and third emitting parts 710 and 750, and the second CGL 780 is positioned between the second and third emitting parts 730 and 750. Namely, the first emitting part 710, the first CGL 770, the third emitting part 750, the second CGL 780 and the second emitting part 730 may be sequentially stacked on the first electrode 560. In other words, the first emitting part 710 may be positioned between the first electrode 560 and the first CGL 770, the third emitting part 750 may be positioned between the first and second CGLs 770 and 780, and the second emitting part 730 may be positioned between the second CGL 780 and the second electrode 564.

The first EML 720 in the first emitting part 710 is a blue EML. The first EML 720 includes a first blue emitting layer 722 being closer to the first electrode 560 and a second blue emitting layer 724 being closer to the second electrode 564 and adjacent to the first blue emitting layer 722. Namely, the second blue emitting layer 724 is disposed between the first blue emitting layer 722 and the second electrode 564 and contacts the first blue emitting layer 722.

The first EML 720 may have a thickness of 100 to 500 Å. A summation of a thickness of the first blue emitting layer 722 and a thickness of the second blue emitting layer 724 is equal to a thickness of the first EML 720, and the thickness of the first blue emitting layer 722 and the thickness of the second blue emitting layer 724 may be same or different. Each of the thickness of the first blue emitting layer 722 and the thickness of the second blue emitting layer 724 may be 10 to 250 Å, e.g., 20 to 250 Å.

In an aspect of the present invention, the thickness of the first blue emitting layer 722 may be smaller than that of the second blue emitting layer 724. For example, the first blue emitting layer 722 may have a thickness of 20 to 100 Å, and the second blue emitting layer 724 may have a thickness of 150 to 250 Å.

The first blue emitting layer 722 includes a first host 722a and a first dopant (e.g., a first emitter) 722b. In the first blue emitting layer 722, the first host 722a may have a weight % (wt%) of 80 to 99.5, preferably 95 to 99.5, and the first dopant 722b may have a wt% of 0.5 to 20, preferably 0.5 to 5.

The second blue emitting layer 724 includes a second host 724a and a second dopant (e.g., a second emitter) 724b. In the second blue emitting layer 724, the second host 724a may have a weight % (wt%) of 80 to 99.5, preferably 95 to 99.5, and the second dopant 724b may have a wt% of 0.5 to 20, preferably 0.5 to 5.

A weight % of the first host 722a in the first blue emitting layer 722 and a weight % of the second host 724a in the second blue emitting layer 724 may be same or different, and a weight % of the first dopant 722b in the first blue emitting layer 722 and a weight % of the second dopant 724b in the second blue emitting layer 724 may be same or different.

The first host 722a includes at least one of the first host compounds, e.g., a pyrene derivative, represented by Formula 1, and the second host 724a includes at least one of the second host compounds, e.g., an anthracene derivative, represented by Formula 3. For example, the first host 722a may include at least one of the compounds in Formula 2, and the second host 724a may include at least one of the compounds in Formula 4.

The first dopant 722b is one of a first compound represented by Formula 5 and a second compound represented by Formula 6, and the second dopant 724b is one of a third compound represented by Formula 5 and a fourth compound represented by Formula 6. Namely, i) both of the first dopant 722b and the second dopant 724b are represented by Formula 5, and the first dopant 722b and the second dopant 724b are same or different , ii) the first dopant 722b is represented by Formula 5, and the second dopant 724b is represented by Formula 6, iii) the first dopant 722b is represented by Formula 6, and the second dopant 724b is represented by Formula 5, or iv) both of the first dopant 722b and the second dopant 724b are represented by Formula 6, and the first dopant 722b and the second dopant 724b are same or different.

The first dopant 722b may include one of the compound represented by Formula 5 and the compound represented by Formula 6, and the second dopant 724b may include the other one of the compound represented by Formula 5 and the compound represented by Formula 6. For example, the compound represented by Formula 5 may have a weight % of 0.5 to 3, and the compound represented by Formula 6 may have a weight % of 1.5 to 5.

In an aspect of the present invention, the first dopant 722b may include the first compound represented by Formula 5, and the second dopant 724b may include the fourth compound represented by Formula 6. A weight % of the first dopant 722b in the first blue emitting layer 722 may be smaller than that of the second dopant 724b in the second blue emitting layer 724. For example, the first dopant 722b in the first blue emitting layer 722 may have a weight % of 0.5 to 3, and the second dopant 724b in the second blue emitting layer 724 may have a weight % of 1.5 to 5. In this instance, the OLED D4 may have a big advantage in the driving voltage, the emitting efficiency and the lifespan.

In an aspect of the present invention, the first dopant 722b may include the second compound represented by Formula 6, and the second dopant 724b may include the third compound represented by Formula 5. A weight % of the first dopant 722b in the first blue emitting layer 722 may be greater than that of the second dopant 724b in the second blue emitting layer 724. For example, the first dopant 722b in the first blue emitting layer 722 may have a weight % of 1.5 to 5, and the second dopant 724b in the second blue emitting layer 724 may have a weight % of 0.5 to 3. In this instance, the OLED D4 may have a big advantage in the driving voltage, the color purity and the lifespan.

The first emitting part 710 may further include at least one of a first HTL 713 disposed under the first EML 720 and a first ETL 719 disposed over the first EML 720. Namely, the first HTL 713 may be disposed between the first EML 720 and the first electrode 560, and the first ETL 719 may be disposed between the first EML 720 and the second electrode 564.

The first emitting part 710 may further include an HIL 711 between the first HTL 713 and the first electrode 560

The first emitting part 710 may further include at least one of a first EBL 715 between the first EML 720 and the first HTL 713 and a first HBL 717 between the first EML 720 and the first ETL 719.

For example, the first emitting part 710 may have a structure of the HIL 711, the first HTL 713, the first EBL 715, the first blue emitting layer 722, the second blue emitting layer 724, the first HBL 717 and the first ETL 719 sequentially stacked on the first electrode 560. In this case, the first blue emitting layer 722 is spaced apart from the first HTL 713 and contacts the first EBL 715, and the second blue emitting layer 724 is spaced apparat from the first ETL 719 and contacts the first HBL 717.

The first ETL 719 may have a hole blocking function as well as an electron transporting function so that the first HBL 717 may be omitted. In this case, the first emitting part 710 has a structure of the HIL 711, the first HTL 713, the first EBL 715, the first bule emitting layer 722, the second blue emitting layer 724 and the first ETL 719 sequentially stacked on the first electrode 560. As a result, the first blue emitting layer 722 is spaced apart from the first HTL 713 and contacts the first EBL 715, and the second blue emitting layer 724 contacts the first ETL 719.

The second EML 740 in the second emitting part 730 is a blue EML. The second EML 740 includes a third blue emitting layer 742, which is disposed to be closer to the first electrode 560, and a fourth blue emitting layer 744, which is disposed to be closer to the second electrode 564 and is adjacent to the third blue emitting layer 742. Namely, the fourth blue emitting layer 744 is positioned between the third blue emitting layer 742 and the second electrode 564 and contacts the third blue emitting layer 742.

The second EML 740 may have a thickness of 100 to 500Á. A summation of a thickness of the third blue emitting layer 742 and a thickness of the fourth blue emitting layer 744 is equal to a thickness of the second EML 740, and the thickness of the third blue emitting layer 742 and the thickness of the fourth blue emitting layer 744 may be same or different. Each of the thickness of the third blue emitting layer 742 and the thickness of the fourth blue emitting layer 744 may be 10 to 250 Å, e.g., 20 to 250 Å.

In an aspect of the present invention, the thickness of the third blue emitting layer 742 may be smaller than that of the fourth blue emitting layer 744. For example, the third blue emitting layer 742 may have a thickness of 20 to 100 Å, and the fourth blue emitting layer 744 may have a thickness of 150 to 250 Å.

The third blue emitting layer 742 includes a third host 742a and a third dopant (e.g., a third emitter) 742b. In the third blue emitting layer 742, the third host 742a may have a weight % (wt%) of 80 to 99.5, preferably 95 to 99.5, and the third dopant 742b may have a wt% of 0.5 to 20, preferably 0.5 to 5.

The fourth blue emitting layer 744 includes a fourth host 744a and a fourth dopant (e.g., a fourth emitter) 744b. In the fourth blue emitting layer 744, the fourth host 744a may have a weight % (wt%) of 80 to 99.5, preferably 95 to 99.5, and the fourth dopant 744b may have a wt% of 0.5 to 20, preferably 0.5 to 5.

A weight % of the third host 742a in the third blue emitting layer 742 and a weight % of the fourth host 744a in the fourth blue emitting layer 744 may be same or different, and a weight % of the third dopant 742b in the third blue emitting layer 742 and a weight % of the fourth dopant 744b in the fourth blue emitting layer 744 may be same or different.

The third host 742a includes at least one of the first host compounds, e.g., a pyrene derivative, represented by Formula 1, and the fourth host 744a includes at least one of the second host compounds, e.g., an anthracene derivative, represented by Formula 3. For example, the third host 742a may include at least one of the compounds in Formula 2, and the fourth host 744a may include at least one of the compounds in Formula 4.

The third dopant 742b is one of a first compound represented by Formula 5 and a second compound represented by Formula 6, and the fourth dopant 744b is one of a third compound represented by Formula 5 and a fourth compound represented by Formula 6. Namely, i) both of the third dopant 742b and the fourth dopant 744b are represented by Formula 5, and the third dopant 742b and the fourth dopant 744b are same or different, ii) the third dopant 742b is represented by Formula 5, and the fourth dopant 744b is represented by Formula 6, iii) the third dopant 742b is represented by Formula 6, and the fourth dopant 744b is represented by Formula 5, or iv) both of the third dopant 742b and the fourth dopant 744b are represented by Formula 6, and the third dopant 742b and the fourth dopant 744b are same or different.

The third dopant 742b may include one of the compound represented by Formula 5 and the compound represented by Formula 6, and the fourth dopant 744b may include the other one of the compound represented by Formula 5 and the compound represented by Formula 6. For example, the compound represented by Formula 5 may have a weight % of 0.5 to 3, and the compound represented by Formula 6 may have a weight % of 1.5 to 5.

In an aspect of the present invention, the third dopant 742b may include the first compound represented by Formula 5, and the fourth dopant 744b may include the fourth compound represented by Formula 6. A weight % of the third dopant 742b in the third blue emitting layer 742 may be smaller than that of the fourth dopant 744b in the fourth blue emitting layer 744. For example, the third dopant 742b in the third blue emitting layer 742 may have a weight % of 0.5 to 3, and the fourth dopant 744b in the fourth blue emitting layer 744 may have a weight % of 1.5 to 5. In this instance, the OLED D4 may have a big advantage in the driving voltage, the emitting efficiency and the lifespan.

In an aspect of the present invention, the third dopant 742b may include the second compound represented by Formula 6, and the fourth dopant 744b may include the third compound represented by Formula 5. A weight % of the third dopant 742b in the third blue emitting layer 742 may be greater than that of the fourth dopant 744b in the fourth blue emitting layer 744. For example, the third dopant 742b in the third blue emitting layer 742 may have a weight % of 1.5 to 5, and the fourth dopant 744b in the fourth blue emitting layer 744may have a weight % of 0.5 to 3. In this instance, the OLED D4 may have a big advantage in the driving voltage, the color purity and the lifespan.

The second emitting part 730 may further include at least one of a second HTL 731 disposed under the second EML 740 and a second ETL 737 disposed over the second EML 740. Namely, the second HTL 731 is positioned between the second EML 740 and the first emitting part 710, and the second ETL 737 is positioned between the second EML 740 and the second electrode 564.

The second emitting part 730 may further include an EIL 739 between the second ETL 737 and the second electrode 564.

The second emitting part 730 may further include a second EBL 733 between the second EML 740 and the second HTL 731 and a second HBL 735 between the second EML 740 and the second ETL 737.

For example, the second emitting part 730 may have a structure of the second HTL 731, the second EBL 733, the third blue emitting layer 742, the fourth blue emitting layer 744, the second HBL 735, the second ETL 737 and the EIL 739. In this instance, the third blue emitting layer 742 is spaced apart from the second HTL 731 and contacts the second EBL 733, and the fourth blue emitting layer 744 is spaced apart from the second ETL 737 and contacts the second HBL 735.

The second ETL 737 may have a hole blocking function as well as an electron transporting function so that the second HBL 735 may be omitted. In this case, the second emitting part 730 has a structure of the second HTL 731, the second EBL 733, the third blue emitting layer 742, the fourth blue emitting layer 744, the second ETL 737 and the EIL 739. As a result, the third blue emitting layer 742 is spaced apart from the second HTL 731 and contacts the second EBL 733, and the fourth blue emitting layer 744 contacts the second ETL 737.

The third EML 760 in the third emitting part 750 includes a red emitting layer 762 and a green emitting layer 764 to provide red and green light.

The red emitting layer 762 may include a red host and a red dopant. For example, the red dopant may be one of a fluorescent compound, a phosphorescent compound and a delayed fluorescent compound.

The red host may be selected from the group consisting of mCP-CN, CBP, mCBP, mCP, DPEPO, 2,8-bis(diphenylphosphoryl)dibenzothiophene (PPT), 1,3,5-tri[(3-pyridyl)-phen-3-yl]benzene (TmPyPB), 2,6-di(9H-carbazol-9-yl)pyridine (PYD-2Cz), 2,8-di(9H-carbazol-9-yl)dibenzothiophene (DCzDBT), 3',5'-di(carbazol-9-yl)-[1,1'-bipheyl]-3,5-dicarbonitrile (DCzTPA), 4'-(9H-carbazol-9-yl)biphenyl-3,5-dicarbonitrile(4'-(9H-carbazol-9-yl)biphenyl-3,5-dicarbonitrile (pCzB-2CN), 3'-(9H-carbazol-9-yl)biphenyl-3,5-dicarbonitrile (mCzB-2CN), TSPO1, 9-(9-phenyl-9H-carbazol-6-yl)-9H-carbazole (CCP), 4-(3-(triphenylen-2-yl)phenyl)dibenzo[b,d]thiophene, 9-(4-(9H-carbazol-9-yl)phenyl)-9H-3,9'-bicarbazole, 9-(3-(9H-carbazol-9-yl)phenyl)-9H-3,9'-bicarbazole, 9-(6-(9H-carbazol-9-yl)pyridin-3-yl)-9H-3,9'-bicabazole, 9,9'-diphenyl-9H,9'H-3,3'-bicarbazole (BCzPh), 1,3,5-tris(carbazole-9-yl)benzene (TCP), TCTA, 4,4'-bis(carbazole-9-yl)-2,2'-dimethylbipheyl (CDBP), 2,7-bis(carbazole-9-yl)-9,9-dimethylfluorene (DMFL-CBP), 2,2',7,7'-tetrakis(carbazole-9-yl)-9,9-spiorofluorene (Spiro-CBP), and 3,6-bis(carbazole-9-yl)-9-(2-ethyl-hexyl)-9H-carbazole (TCz1), but it is not limited thereto.

The red dopant may be selected from the group consisting of[bis(2-(4,6-dimethyl)phenylquinoline)](2,2,6,6-tetramethylheptane-3,5-dionate)iridium(III), bis[2-(4-n-hexylphenyl)quinoline](acetylacetonate)iridium(III) (Hex-Ir(phq)2(acac)), tris[2-(4-n-hexylphenyl)quinoline]iridium(III) (Hex-Ir(phq)3), tris[2-phenyl-4-methylquinoline]iridium( III) (Ir(Mphq)3), bis(2-phenylquinoline)(2,2,6,6-tetramethylheptene-3,5-dionate)iridium(III) (Ir(dpm)PQ2), bis(phenylisoquinoline)(2,2,6,6-tetramethylheptene-3,5-dionate)iridium(III) (Ir(dpm)(piq)2), bis[(4-n-hexylphenyl)isoquinoline](acetylacetonate)iridium(III) (Hex-Ir(piq)2(acac)), tris[2-(4-n-hexylphenyl)quinoline]iridium(III) (Hex-Ir(piq)3), tris(2-(3-methylphenyl)-7-methyl-quinolato)iridium (Ir(dmpq)3), bis[2-(2-methylphenyl)-7-methylquinoline](acetylacetonate)iridium(III) (Ir(dmpq)2(acac)), bis[2-(3,5-dimethylphenyl)-4-methyl-quinoline](acetylacetonate)iridium(III) (Ir(mphmq)2(acac)), and tris(dibenzoylmethane)mono(1,10-phenanthroline)europium(III) (Eu(dbm)3(phen)), but it is not limited thereto.

The green emitting layer 764 may include a green host and a green dopant. For example, the green dopant may be one of a fluorescent compound, a phosphorescent compound and a delayed fluorescent compound.

The green host may be one of the materials for the yellow-green host.

The green dopant may be selected from the group consisting of [bis(2-phenylpyridine)](pyridyl-2-benzofuro[2,3-b]pyridine)iridium, tris[2-phenylpyridine]iridium (III ) (Ir(ppy)3), fac-tris(2-phenylpyridine)iridium(III) (fac-Ir(ppy)3), bis(2-phenylpyridine)(acetylacetonate)iridium(III) (Ir(ppy)2(acac)), tris[2-(p-tolyl)pyridine]iridium( III) (Ir(mppy)3), bis(2-(naphthalene-2-yl)pyridine)(acetylacetonate)iridium(III) (Ir(npy)2acac), tris(2-phenyl-3-methyl-pyridine)iridium (Ir(3mppy)3), and fac-tris(2-(3-p-xylyl)phenyl)pyridine iridium(III) (TEG), but it is not limited thereto.

In an aspect, the third EML 760 in the third emitting part 750 may further include a yellow-green emitting layer to have a triple-layered structure. The yellow-green emitting layer may include the above-mentioned yellow-green host and the above-mentioned yellow-green dopant. In another aspect, the yellow-green EML may be included instead of the third EML760.

The third emitting part 750 may further include at least one of a third HTL 751 under the third EML 760 and a third ETL 753 on the third EML 760.

In addition, the third emitting part 750 may further include at least one of a third EBL between the third HTL 751 and the third EML 760 and a third HBL between the third EML 760 and the third ETL 753.

The HIL 711 may include the above-mentioned hole injection material and may have a thickness of 10 to 200 Å.

Each of the first to third HTLs 713, 731 and 751 may include the above-mentioned hole transporting material and may have a thickness of 500 to 1500 Å, preferably 600 to 1000 Å.

Each of the first to third ETLs 719, 737 and 753 may include the above-mentioned electron transporting material and may have a thickness of 100 to 500 Å, preferably 100 to 300Å.

The EIL 739 may include the above-mentioned electron injection material and may have a thickness of 5 to 40 Å, preferably 10 to 20 Å.

Each of the first EBL 715, the second EBL 733 and the third EBL may include the above-mentioned electron blocking material and may have a thickness of 10 to 300 Å.

Each of the first HBL 717, the second HBL 735 and the third HBL may include the above-mentioned hole blocking material and may have a thickness of 10 to 300 Å.

The first CGL 770 is positioned between the first and third emitting parts 710 and 750, and the second CGL 780 is positioned between the second and third emitting parts 730 and 750. Namely, the first and third emitting parts 710 and 750 may be connected to each other through the first CGL 770, and the second and third emitting parts 730 and 750 may be connected to each other through the second CGL 780. The first CGL 770 may be a P-N junction CGL of a first N-type CGL 772 and a first P-type CGL 774, and the second CGL 780 may be a P-N junction CGL of a second N-type CGL 782 and a second P-type CGL 784.

In the first CGL 770, the first N-type CGL 772 is positioned between the first ETL 719 and the third HTL 751, and the first P-type CGL 774 is positioned between the first N-type CGL 772 and the third HTL 751.

In the second CGL 780, the second N-type CGL 782 is positioned between the third ETL 753 and the second HTL 731, and the second P-type CGL 784 is positioned between the second N-type CGL 782 and the second HTL 731.

Each of the first and second N-type CGLs 772 and 782 may include the above-mentioned N-type charge generation material, and each of the first and second P-type CGLs 774 and 784 may include the above-mentioned P-type charge generation material.

In FIG. 8, the first EML 720 has a double-layered structure including the first and second blue emitting layers 722 and 724, and the second EML 740 has a double-layered structure including the third and fourth blue emitting layers 742 and 744.

Alternatively, one of the first and second EMLs 720 and 740 may have a double-layered structure, while the other one of the first and second EMLs 720 and 740 may have a single-layered structure. In this instance, the other one of the first and second EMLs 720 and 740 may include a blue host and a blue dopant. The blue host may be the above-mentioned blue host material, and the blue dopant may be the above-mentioned blue dopant material.

The OLED D4 of the present invention includes the first emitting part 710 including the first EML 720 (e.g., a first blue EML), the second emitting part 730 including the second EML 740 (e.g., a second blue EML) and the third emitting part 750 including the third EML 760, which includes the red and green emitting layers 762 and 764, and at least one of the first and second blue EMLs 720 and 740 includes a first blue emitting layer including a first host and a first dopant and a second blue emitting layer including a second host and a second dopant. In this case, the first host includes at least one of the first host compounds represented by Formula 1, and the second host includes at least one of the second host compounds represented by Formula 3. The first dopant is one of the first compound represented by Formula 5 and the second compound represented by Formula 6, and the second dopant is one of the third compound represented by Formula 5 and the fourth compound represented by Formula 6.

Accordingly, the OLED D4 and the organic light emitting display device 100 have an advantages in at least one of the driving voltage, the color purity, the emitting efficiency and the lifespan.

In addition, the OLED D4 includes the first and second emitting parts 710 and 730 each providing a blue emission and the third emitting part 750 providing a red-green emission such that the OLED D4 can provide a white emission.

The OLED D4 in FIG. 8 has a three-stack structure including the first, second and third emitting parts 710, 730 and 750. The OLED D4 may further include additional emitting part and additional CGL.

Referring to FIG. 9, the OLED D5 includes the first electrode 560, the second electrode 564 and the organic emitting layer 562 therebetween, and the organic emitting layer 562 includes a first emitting part 810 including a first EML 820, a second emitting part 830 including a second EML 840, a third emitting part 850 including a third EML 855 and a fourth emitting part 860 including a fourth EML 863. In addition, the organic emitting layer 562 may further include a first CGL 870 between the first and third emitting parts 810 and 850, a second CGL 880 between the first and fourth emitting parts 810 and 860, and a third CGL 890 between the second and fourth emitting parts 830 and 860.

The OLED D5 is positioned to correspond to all of the red, green and blue pixel regions RP, GP and BP.

The first CGL 870 is positioned between the first and third emitting parts 810 and 850, the second CGL 880 is positioned between the first and fourth emitting parts 810 and 860, and the third CGL 890 is positioned between the second and fourth emitting parts 830 and 860. Namely, the third emitting part 850, the first CGL 870, the first emitting part 810, the second CGL 880, the fourth emitting part 860, the third CGL 890 and the second emitting part 830 may be sequentially stacked on the first electrode 560. In other words, the first emitting part 810 may be positioned between the first and second CGLs 870 and 880, the second emitting part 830 may be positioned between the third CGL 890 and the second electrode 564, the third emitting part 850 may be positioned between the first electrode 560 and the first CGL 870, and the fourth emitting part 860 may be positioned between the second and third CGLs 880 and 890.

The first EML 820 in the first emitting part 810 is a blue EML. The first EML 820 includes a first blue emitting layer 822 being closer to the first electrode 560 and a second blue emitting layer 824 being closer to the second electrode 564 and adjacent to the first blue emitting layer 822. Namely, the second blue emitting layer 824 is disposed between the first blue emitting layer 822 and the second electrode 564 and contacts the first blue emitting layer 822.

The first EML 820 may have a thickness of 100 to 500 Å. A summation of a thickness of the first blue emitting layer 822 and a thickness of the second blue emitting layer 824 is equal to a thickness of the first EML 820, and the thickness of the first blue emitting layer 822 and the thickness of the second blue emitting layer 824 may be same or different. Each of the thickness of the first blue emitting layer 822 and the thickness of the second blue emitting layer 824 may be 10 to 250 Å, e.g., 20 to 250 Å.

In an aspect of the present invention, the thickness of the first blue emitting layer 822 may be smaller than that of the second blue emitting layer 824. For example, the first blue emitting layer 822 may have a thickness of 20 to 100 Å, and the second blue emitting layer 824 may have a thickness of 150 to 250 Å.

The first blue emitting layer 822 includes a first host 822a and a first dopant (e.g., a first emitter) 822b. In the first blue emitting layer 822, the first host 822a may have a weight % (wt%) of 80 to 99.5, preferably 95 to 99.5, and the first dopant 822b may have a wt% of 0.5 to 20, preferably 0.5 to 5.

The second blue emitting layer 824 includes a second host 824a and a second dopant (e.g., a second emitter) 824b. In the second blue emitting layer 824, the second host 824a may have a weight % (wt%) of 80 to 99.5, preferably 95 to 99.5, and the second dopant 824b may have a wt% of 0.5 to 20, preferably 0.5 to 5.

A weight % of the first host 822a in the first blue emitting layer 822 and a weight % of the second host 824a in the second blue emitting layer 824 may be same or different, and a weight % of the first dopant 822b in the first blue emitting layer 822 and a weight % of the second dopant 824b in the second blue emitting layer 824 may be same or different.

The first host 822a includes at least one of the first host compounds, e.g., a pyrene derivative, represented by Formula 1, and the second host 824a includes at least one of the second host compounds, e.g., an anthracene derivative, represented by Formula 3. For example, the first host 822a may include at least one of the compounds in Formula 2, and the second host 824a may include at least one of the compounds in Formula 4.

The first dopant 822b is one of a first compound represented by Formula 5 and a second compound represented by Formula 6, and the second dopant 824b is one of a third compound represented by Formula 5 and a fourth compound represented by Formula 6. Namely, i) both of the first dopant 822b and the second dopant 824b are represented by Formula 5, and the first dopant 822b and the second dopant 824b are same or different , ii) the first dopant 822b is represented by Formula 5, and the second dopant 824b is represented by Formula 6, iii) the first dopant 822b is represented by Formula 6, and the second dopant 824b is represented by Formula 5, or iv) both of the first dopant 822b and the second dopant 824b are represented by Formula 6, and the first dopant 822b and the second dopant 824b are same or different.

The first dopant 822b may include one of the compound represented by Formula 5 and the compound represented by Formula 6, and the second dopant 824b may include the other one of the compound represented by Formula 5 and the compound represented by Formula 6. For example, the compound represented by Formula 5 may have a weight % of 0.5 to 3, and the compound represented by Formula 6 may have a weight % of 1.5 to 5.

In an aspect of the present invention, the first dopant 822b may include the first compound represented by Formula 5, and the second dopant 824b may include the fourth compound represented by Formula 6. A weight % of the first dopant 822b in the first blue emitting layer 822 may be smaller than that of the second dopant 824b in the second blue emitting layer 824. For example, the first dopant 822b in the first blue emitting layer 822 may have a weight % of 0.5 to 3, and the second dopant 824b in the second blue emitting layer 824 may have a weight % of 1.5 to 5. In this instance, the OLED D5 may have a big advantage in the driving voltage, the emitting efficiency and the lifespan.

In an aspect of the present invention, the first dopant 822b may include the second compound represented by Formula 6, and the second dopant 824b may include the third compound represented by Formula 5. A weight % of the first dopant 822b in the first blue emitting layer 822 may be greater than that of the second dopant 824b in the second blue emitting layer 824. For example, the first dopant 822b in the first blue emitting layer 822 may have a weight % of 1.5 to 5, and the second dopant 824b in the second blue emitting layer 824 may have a weight % of 0.5 to 3. In this instance, the OLED D5 may have a big advantage in the driving voltage, the color purity and the lifespan.

The first emitting part 810 can further include at least one of a first HTL 813 under the first EML 820 and a first ETL 819 on the first EML 820. Namely, the first HTL 813 can be positioned between the first EML 820 and the first electrode 560, and the first ETL 819 can be positioned between the first EML 820 and the second CGL 880.

The first emitting part 810 may further include at least one of a first EBL between the first EML 820 and the first HTL 813 and a first HBL between the first EML 820 and the first ETL 819.

For example, the first emitting part 810 may have a structure including the first HTL 813, the first EBL, the first bule emitting layer 822, the second blue emitting layer 824, the first HBL and the first ETL 819 sequentially stacked over the first electrode 560. In this case, the first blue emitting layer 822 is spaced apart from the first HTL 813 and contacts the first EBL, and the second blue emitting layer 824 is spaced apparat from the first ETL 819 and contacts the first HBL.

The first ETL 819 may have a hole blocking function as well as an electron transporting function so that the first HBL may be omitted. In this case, the first emitting part 810 has a structure of the first HTL 813, the first EBL, the first bule emitting layer 822, the second blue emitting layer 824 and the first ETL 819 sequentially stacked over the first electrode 560. As a result, the first blue emitting layer 822 is spaced apart from the first HTL 813 and contacts the first EBL, and the second blue emitting layer 824 contacts the first ETL 819.

The second EML 840 in the second emitting part 830 is a blue EML. The second EML 840 includes a third blue emitting layer 842, which is disposed to be closer to the first electrode 560, and a fourth blue emitting layer 844, which is disposed to be closer to the second electrode 564 and is adjacent to the third blue emitting layer 842. Namely, the fourth blue emitting layer 844 is positioned between the third blue emitting layer 842 and the second electrode 564 and contacts the third blue emitting layer 842.

The second EML 840 may have a thickness of 100 to 500Å. A summation of a thickness of the third blue emitting layer 842 and a thickness of the fourth blue emitting layer 844 is equal to a thickness of the second EML 840, and the thickness of the third blue emitting layer 842 and the thickness of the fourth blue emitting layer 844 may be same or different. Each of the thickness of the third blue emitting layer 842 and the thickness of the fourth blue emitting layer 844 may be 10 to 250 Å, e.g., 20 to 250 Å.

In an aspect of the present invention, the thickness of the third blue emitting layer 842 may be smaller than that of the fourth blue emitting layer 844. For example, the third blue emitting layer 842 may have a thickness of 20 to 100 Å, and the fourth blue emitting layer 844 may have a thickness of 150 to 250 Å.

The third blue emitting layer 842 includes a third host 842a and a third dopant (e.g., a third emitter) 842b. In the third blue emitting layer 842, the third host 842a may have a weight % (wt%) of 80 to 99.5, preferably 95 to 99.5, and the third dopant 842b may have a wt% of 0.5 to 20, preferably 0.5 to 5.

The fourth blue emitting layer 844 includes a fourth host 844a and a fourth dopant (e.g., a fourth emitter) 844b. In the fourth blue emitting layer 844, the fourth host 844a may have a weight % (wt%) of 80 to 99.5, preferably 95 to 99.5, and the fourth dopant 844b may have a wt% of 0.5 to 20, preferably 0.5 to 5.

A weight % of the third host 842a in the third blue emitting layer 842 and a weight % of the fourth host 844a in the fourth blue emitting layer 844 may be same or different, and a weight % of the third dopant 842b in the third blue emitting layer 842 and a weight % of the fourth dopant 844b in the fourth blue emitting layer 844 may be same or different.

The third host 842a includes at least one of the first host compounds, e.g., a pyrene derivative, represented by Formula 1, and the fourth host 844a includes at least one of the second host compounds, e.g., an anthracene derivative, represented by Formula 3. For example, the third host 842a may include at least one of the compounds in Formula 2, and the fourth host 844a may include at least one of the compounds in Formula 4.

The third dopant 842b is one of a first compound represented by Formula 5 and a second compound represented by Formula 6, and the fourth dopant 844b is one of a third compound represented by Formula 5 and a fourth compound represented by Formula 6. Namely, i) both of the third dopant 842b and the fourth dopant 844b are represented by Formula 5, and the third dopant 842b and the fourth dopant 844b are same or different, ii) the third dopant 842b is represented by Formula 5, and the fourth dopant 844b is represented by Formula 6, iii) the third dopant 842b is represented by Formula 6, and the fourth dopant 844b is represented by Formula 5, or iv) both of the third dopant 842b and the fourth dopant 844b are represented by Formula 6, and the third dopant 842b and the fourth dopant 844b are same or different.

The third dopant 842b may include one of the compound represented by Formula 5 and the compound represented by Formula 6, and the fourth dopant 844b may include the other one of the compound represented by Formula 5 and the compound represented by Formula 6. For example, the compound represented by Formula 5 may have a weight % of 0.5 to 3, and the compound represented by Formula 6 may have a weight % of 1.5 to 5.

In an aspect of the present invention, the third dopant 842b may include the first compound represented by Formula 5, and the fourth dopant 844b may include the fourth compound represented by Formula 6. A weight % of the third dopant 842b in the third blue emitting layer 842 may be smaller than that of the fourth dopant 844b in the fourth blue emitting layer 844. For example, the third dopant 842b in the third blue emitting layer 842 may have a weight % of 0.5 to 3, and the fourth dopant 844b in the fourth blue emitting layer 844 may have a weight % of 1.5 to 5. In this instance, the OLED D5 may have a big advantage in the driving voltage, the emitting efficiency and the lifespan.

In an aspect of the present invention, the third dopant 842b may include the second compound represented by Formula 6, and the fourth dopant 844b may include the third compound represented by Formula 5. A weight % of the third dopant 842b in the third blue emitting layer 842 may be greater than that of the fourth dopant 844b in the fourth blue emitting layer 844. For example, the third dopant 842b in the third blue emitting layer 842 may have a weight % of 1.5 to 5, and the fourth dopant 844b in the fourth blue emitting layer 844may have a weight % of 0.5 to 3. In this instance, the OLED D5 may have a big advantage in the driving voltage, the color purity and the lifespan.

The second emitting part 830 may further include at least one of a second HTL 831 disposed under the second EML 840 and a second ETL 837 disposed over the second EML 840. Namely, the second HTL 831 is positioned between the second EML 840 and the first emitting part 810, and the second ETL 837 is positioned between the second EML 840 and the second electrode 564.

The second emitting part 830 may further include an EIL 839 between the second ETL 837 and the second electrode 564.

The second emitting part 830 may further include a second EBL between the second EML 840 and the second HTL 831 and a second HBL between the second EML 840 and the second ETL 837.

For example, the second emitting part 830 may have a structure of the second HTL 831, the second EBL, the third blue emitting layer 842, the fourth blue emitting layer 844, the second HBL, the second ETL 837 and the EIL 839. In this instance, the third blue emitting layer 842 is spaced apart from the second HTL 831 and contacts the second EBL, and the fourth blue emitting layer 844 is spaced apart from the second ETL 837 and contacts the second HBL.

The second ETL 837 may have a hole blocking function as well as an electron transporting function so that the second HBL may be omitted. In this case, the second emitting part 830 has a structure of the second HTL 831, the second EBL, the third blue emitting layer 842, the fourth blue emitting layer 844, the second ETL 837 and the EIL 839. As a result, the third blue emitting layer 842 is spaced apart from the second HTL 831 and contacts the second EBL, and the fourth blue emitting layer 844 contacts the second ETL 837.

The third EML 855 in the third emitting part 850 may be a red EML. The third EML 855 may include a red host and a red dopant. For example, the red host may be the above-mentioned red host, and the red dopant may be the above-mentioned red dopant.

The third emitting part 850 may further include at least one of a third HTL 853 between the third EML 855 and the first electrode 560 and a third ETL 857 disposed between the third EML 855 and the first CGL 870.

The third emitting part 850 may further include an HIL 851 between the third HTL 853 and the first electrode 560

The third emitting part 850 may further include at least one of a third EBL between the third EML 855 and the third HTL 853 and a third HBL between the third EML 855 and the third ETL 857.

The fourth EML 863 in the fourth emitting part 860 may be a green EML. The fourth EML 863 may include a green host and a green dopant. The green host may be the above-mentioned green host, and the green dopant may be the above-mentioned green dopant.

The fourth emitting part 860 may further include at least one of a fourth HTL 861 between the fourth EML 863 and the second CGL 880 and a fourth ETL 865 between the fourth EML 863 and the third CGL 890.

In addition, the fourth emitting part 860 may further include at least one of a fourth EBL between the fourth EML 863 and the fourth HTL 861 and a fourth HBL between the fourth EML 863 and the fourth ETL 865.

The HIL 851 may include the above-mentioned hole injection material and may have a thickness of 10 to 200Å.

Each of the first to fourth HTLs 813, 831, 853 and 861 may include the above-mentioned hole transporting material and may have a thickness of 500 to 1500 Å, preferably 600 to 1000 Å.

Each of the first to fourth ETLs 819, 837, 857 and 865 may include the above-mentioned electron transporting material and may have a thickness of 100 to 500 Å, preferably 100 to 300 Å.

The EIL 839 may include the above-mentioned electron injection material and may have a thickness of 5 to 40 Å, preferably 10 to 20 Å.

Each of the first to fourth EBLs may include the above-mentioned electron blocking material and may have a thickness of 10 to 300 Å.

Each of the first to fourth HBLs may include the above-mentioned hole blocking material and may have a thickness of 10 to 300 Å.

The first CGL 870 is positioned between the first and third emitting parts 810 and 850, the second CGL 880 is positioned between the first and fourth emitting parts 810 and 860, and the third CGL 890 is positioned between the second and fourth emitting parts 830 and 860. Namely, the first and third emitting parts 810 and 850 may be connected to each other through the first CGL 870, the first and fourth emitting parts 810 and 860 may be connected to each other through the second CGL 880, and the second and fourth emitting parts 830 and 860 may be connected to each other through the third CGL 890. The first CGL 870 may be a P-N junction CGL of a first N-type CGL 872 and a first P-type CGL 874, the second CGL 880 may be a P-N junction CGL of a second N-type CGL 882 and a second P-type CGL 884, and the third CGL 890 may be a P-N junction CGL of a third N-type CGL 892 and a third P-type CGL 894.

In the first CGL 870, the first N-type CGL 872 is positioned between the first HTL 813 and the third ETL 857, and the first P-type CGL 874 is positioned between the first N-type CGL 872 and the first HTL 813.

In the second CGL 880, the second N-type CGL 882 is positioned between the first ETL 819 and the fourth HTL 861, and the second P-type CGL 884 is positioned between the second N-type CGL 882 and the fourth HTL 861.

In the third CGL 890, the third N-type CGL 892 is positioned between the fourth ETL 865 and the second HTL 831, and the third P-type CGL 894 is positioned between the third N-type CGL 892 and the second HTL 831.

Each of the first to third N-type CGLs 872, 882 and 892 may include the above-mentioned N-type charge generation material, and each of the first to third P-type CGLs 874, 884 and 894 may include the above-mentioned P-type charge generation material.

In FIG. 9, the first EML 820 has a double-layered structure including the first and second blue emitting layers 822 and 824, and the second EML 840 has a double-layered structure including the third and fourth blue emitting layers 842 and 844.

Alternatively, one of the first and second EMLs 820 and 840 may have a double-layered structure, while the other one of the first and second EMLs 820 and 840 may have a single-layered structure. In this instance, the other one of the first and second EMLs 820 and 840 may include a blue host and a blue dopant. The blue host may be the above-mentioned blue host material, and the blue dopant may be the above-mentioned blue dopant material.

The OLED D5 of the present invention includes the first emitting part 810 including the first EML 820 (e.g., a first blue EML), the second emitting part 830 including the second EML 840 (e.g., a second blue EML), the third emitting part 850 including the third EML 855, i.e., a red EML, and the fourth emitting part 860 including the fourth EML 863, i.e., a green EML, and at least one of the first and second blue EMLs 820 and 840 includes a first blue emitting layer including a first host and a first dopant and a second blue emitting layer including a second host and a second dopant. In this case, the first host includes at least one of the first host compounds represented by Formula 1, and the second host includes at least one of the second host compounds represented by Formula 3. The first dopant is one of the first compound represented by Formula 5 and the second compound represented by Formula 6, and the second dopant is one of the third compound represented by Formula 5 and the fourth compound represented by Formula 6.

Accordingly, the OLED D5 and the organic light emitting display device 100 have an advantages in at least one of the driving voltage, the color purity, the emitting efficiency and the lifespan.

In addition, the OLED D5 includes the first and second emitting parts 810 and 830 each providing a blue emission, the third emitting part 850 providing a red emission and the fourth emitting part 860 providing a green emission such that the OLED D5 can provide a white emission.

Referring to FIG. 6 again, a second electrode 564 is formed over the first substrate 510 where the organic emitting layer 562 is formed.

In the organic light emitting display device 500, since the light emitted from the organic emitting layer 562 is incident to the color filter layer 580 through the second electrode 564, the second electrode 564 has a thin profile for transmitting the light.

The first electrode 560, the organic emitting layer 562 and the second electrode 564 constitute the OLED D.

An encapsulation layer (or an encapsulation film) may be formed to prevent penetration of moisture into the OLED D. For example, the encapsulation film may include a first inorganic insulating layer, an organic insulating layer and a second inorganic insulating layer sequentially stacked, but it is not limited thereto. The encapsulation film may be omitted.

A polarization plate for reducing an ambient light reflection may be disposed over the top-emission type OLED D. For example, the polarization plate may be a circular polarization plate.

In the OLED D of FIG. 6, the color filter layer 580 is disposed between the OLED D and the interlayer insulating layer 532. However, the color filter layer 580 can be positioned at any position between the OLED D and the first substrate 510.

In the OLED D of FIG. 6, the light from the organic emitting layer 562 passes through the first electrode 560, and the color filter layer 580 is disposed under the OLED D. Alternatively, the light from the organic emitting layer 562 passes through the second electrode 564, and the color filter layer 580 may be disposed between the OLED D and the second substrate 570. In this case, the first electrode 560 further include a reflection layer to serve as a reflective electrode, and the second electrode 564 has a thin profile to serve as a transparent (semi-transparent) electrode. For example, the color filter layer may be formed directly on the second electrode of the OLED D or may be formed on an inner surface of the second substrate 570.

A color conversion layer (not shown) may be formed between the OLED D and the color filter layer 580. The color conversion layer may include a red color conversion layer, a green color conversion layer and a blue color conversion layer respectively corresponding to the red, green and blue pixels RP, GP and BP. The white light from the OLED D is converted into the red light, the green light and the blue light by the red, green and blue color conversion layer, respectively.

As described above, in the organic light emitting display device 500, the OLED D in the red, green and blue pixels RP, GP and BP emits the white light, and the white light from the organic light emitting diode D passes through the red color filter 582, the green color filter 584 and the blue color filter 586. As a result, the red light, the green light and the blue light are provided from the red pixel RP, the green pixel GP and the blue pixel BP, respectively.

In FIGs. 6 to 9, the OLED D emitting the white light is used for a display device. Alternatively, the OLED D may be formed on an entire surface of a substrate without at least one of the driving element and the color filter layer to be used for a lightening device. The display device and the lightening device each including the OLED D of the present invention may be referred to as an organic light emitting device.

### [OLED1]

On an anode (ITO, 1100 Å), an HIL (the compound in Formula 9 and the compound in Formula 10 (20wt%), 100 Å), an HTL (the compound in Formula 9, 800 Å), an EBL (the compound in Formula 11, 150 Å), a blue EML (a host and a dopant (1.5wt% doping), 250 Å), an ETL (the compound in Formula 12, 200 Å), an EIL (LiF, 15 Å), and a cathode (Al, 1000 Å) were sequentially stacked to form an OLED.

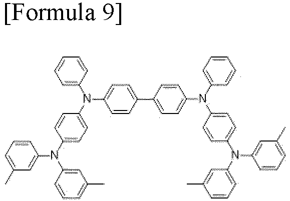

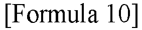

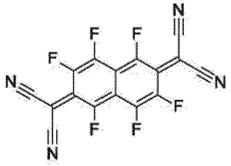

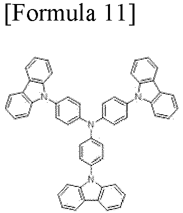

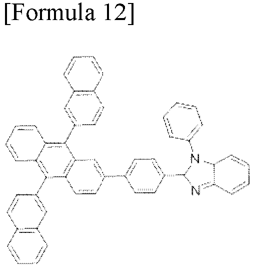

### 1. Comparative Examples

### (1) Comparative Example 1 (Ref1)

The compound BH2-1 in Formula 4 was used as the host, and the compound BD2-1 in Formula 8 was used as the dopant.

### (2) Comparative Example 2 (Ref2)

The compound BH2-1 in Formula 4 was used as the host, and the compound BD1-1 in Formula 7 was used as the dopant.

### [OLED2]

On an anode (ITO, 1100 Å), an HIL (the compound in Formula 9 and the compound in Formula 10 (20wt%), 100 Å), an HTL (the compound in Formula 9, 800 Å), an EBL (the compound in Formula 11, 150 Å), a first blue emitting layer (a first host and a first dopant (1.5wt% doping), 50 Å), a second blue emitting layer (a second host and a second dopant (2wt% doping), 200 Å), an ETL (the compound in Formula 12, 200 Å), an EIL (LiF, 15 Å), and a cathode (Al, 1000 Å) were sequentially stacked to form an OLED.

### 2. Examples

### (1) Examples 1 to 3 (Ex1 to Ex3) (Reference Examples)

The compound BH1-1 in Formula 2 was used as the first host, the compounds BD1-1, BD1-2 and BD1-3 in Formula 7 were used as the first dopant. The compound BH2-1 in in Formula 4 was used as the second host, and the compound BD1-1 in Formula 7 was used as the second dopant. Examples 1 to 3 are not according to the invention.

### (2) Examples 4 to 6 (Ex4 to Ex6) (Reference Examples)

The compound BH1-2 in Formula 2 was used as the first host, the compounds BD1-1, BD1-2 and BD1-3 in Formula 7 were used as the first dopant. The compound BH2-1 in in Formula 4 was used as the second host, and the compound BD1-1 in Formula 7 was used as the second dopant. Examples 4 to 6 are not according to the invention.

### (3) Examples 7 to 9 (Ex7 to Ex9) (Reference Examples)

The compound BH1-3 in Formula 2 was used as the first host, the compounds BD1-1, BD1-2 and BD1-3 in Formula 7 were used as the first dopant. The compound BH2-1 in in Formula 4 was used as the second host, and the compound BD1-1 in Formula 7 was used as the second dopant. Examples 7 to 9 are not according to the invention.

### (4) Examples 10 to 12 (Ex10 to Ex12)

The compound BH1-1 in Formula 2 was used as the first host, the compounds BD1-1, BD1-2 and BD1-3 in Formula 7 were used as the first dopant. The compound BH2-1 in in Formula 4 was used as the second host, and the compound BD2-1 in Formula 8 was used as the second dopant.

### (5) Examples 13 to 15 (Ex13 to Ex15)

The compound BH1-2 in Formula 2 was used as the first host, the compounds BD1-1, BD1-2 and BD1-3 in Formula 7 were used as the first dopant. The compound BH2-1 in in Formula 4 was used as the second host, and the compound BD2-1 in Formula 8 was used as the second dopant.

### (6) Examples 16 to 18 (Ex16 to Ex18)

The compound BH1-3 in Formula 2 was used as the first host, the compounds BD1-1, BD1-2 and BD1-3 in Formula 7 were used as the first dopant. The compound BH2-1 in in Formula 4 was used as the second host, and the compound BD2-1 in Formula 8 was used as the second dopant.

### (7) Examples 19 to 21 (Ex19 to Ex21)

The compound BH1-1 in Formula 2 was used as the first host, the compounds BD2-1, BD2-2 and BD2-3 in Formula 8 were used as the first dopant. The compound BH2-1 in in Formula 4 was used as the second host, and the compound BD1-1 in Formula 7 was used as the second dopant.

### (8) Examples 22 to 24 (Ex22 to Ex24)

The compound BH1-2 in Formula 2 was used as the first host, the compounds BD2-1, BD2-2 and BD2-3 in Formula 8 were used as the first dopant. The compound BH2-1 in in Formula 4 was used as the second host, and the compound BD1-1 in Formula 7 was used as the second dopant.

### (9) Examples 25 to 27 (Ex25 to Ex27)

The compound BH1-3 in Formula 2 was used as the first host, the compounds BD2-1, BD2-2 and BD2-3 in Formula 8 were used as the first dopant. The compound BH2-1 in in Formula 4 was used as the second host, and the compound BD1-1 in Formula 7 was used as the second dopant.

### (10) Examples 28 to 30 (Ex28 to Ex30) (Reference Examples)

The compound BH1-1 in Formula 2 was used as the first host, the compounds BD2-1, BD2-2 and BD2-3 in Formula 8 were used as the first dopant. The compound BH2-1 in in Formula 4 was used as the second host, and the compound BD2-1 in Formula 8 was used as the second dopant.

### (11) Examples 31 to 33 (Ex31 to Ex33) (Reference Examples)

The compound BH1-2 in Formula 2 was used as the first host, the compounds BD2-1, BD2-2 and BD2-3 in Formula 8 were used as the first dopant. The compound BH2-1 in in Formula 4 was used as the second host, and the compound BD2-1 in Formula 8 was used as the second dopant.

### (12) Examples 34 to 36 (Ex34 to Ex36) (Reference Examples)

The compound BH1-3 in Formula 2 was used as the first host, the compounds BD2-1, BD2-2 and BD2-3 in Formula 8 were used as the first dopant. The compound BH2-1 in in Formula 4 was used as the second host, and the compound BD2-1 in Formula 8 was used as the second dopant.

The properties, i.e., a voltage (V), a color coordinate (CIEx, CIEy), an external quantum efficiency (EQE) and a lifespan (T95), of the OLEDs manufactured in Comparative Examples 1 and 2 and Examples 1 to 36 were measured and listed in Tables 1 to 4.

**Table 1**

| | B-EML | | Property (@10mA/cm²) | | | | | T95 (%) |
|---|---|---|---|---|---|---|---|---|
| | B-EML1 | B-EML2 | Volt (V) | Volt (V) @100J | CIEx | CIEy | EQE (%) | |
| Ref1 | BH2-1 + BD2-1 | | 0 | 0 | 0.000 | 0.000 | 100.0% | 100.0% |
| Ref2 | BH2-1 + BD1-1 | | -0.01 | -0.02 | -0.001 | -0.005 | 90.5% | 94.3% |
| Ex1 | BH1-1+BD1-1 | BH2-1+BD1-1 | -0.16 | -0.12 | -0.002 | -0.003 | 95.3% | 136.7% |
| Ex2 | BH1-1+BD1-2 | BH2-1+BD1-1 | -0.13 | -0.10 | -0.002 | -0.004 | 96.5% | 132.3% |
| Ex3 | BH1-1+BD1-3 | BH2-1+BD1-1 | -0.15 | -0.12 | -0.002 | -0.003 | 95.0% | 139.2% |
| Ex4 | BH1-2+BD1-1 | BH2-1+BD1-1 | -0.15 | -0.11 | -0.001 | -0.002 | 94.7% | 137.7% |
| Ex5 | BH1-2+BD1-2 | BH2-1+BD1-1 | -0.12 | -0.08 | -0.001 | -0.003 | 95.6% | 134.9% |

| | | | | | | | | |
|---|---|---|---|---|---|---|---|---|
| Ex6 | BH1-2+BD1-3 | BH2-1+BD1-1 | -0.17 | -0.13 | -0.001 | -0.003 | 94.8% | 138.4% |
| Ex7 | BH1-3+BD1-1 | BH2-1+BD1-1 | -0.11 | -0.07 | -0.001 | -0.003 | 95.2% | 135.6% |
| Ex8 | BH1-3+BD1-2 | BH2-1+BD1-1 | -0.12 | -0.08 | -0.002 | -0.004 | 96.7% | 131.0% |
| Ex9 | BH1-3+BD1-3 | BH2-1+BD1-1 | -0.14 | -0.09 | -0.001 | -0.003 | 94.9% | 137.9% |

**Table 2**

| | B-EML | | Property (@10mA/cm²) | | | | | T95 (%) |
|---|---|---|---|---|---|---|---|---|
| | B-EML1 | B-EML2 | Volt (V) | Volt (V) @100J | CIEx | CIEy | EQE (%) | |
| Ex10 | BH1-1+BD1-1 | BH2-1+BD2-1 | -0.15 | -0.10 | -0.001 | +0.001 | 102.0% | 141.3% |
| Ex11 | BH1-1+BD1-2 | BH2-1+BD2-1 | -0.11 | -0.05 | -0.001 | +0.000 | 102.6% | 139.2% |
| Ex12 | BH1-1+BD1-3 | BH2-1+BD2-1 | -0.13 | -0.07 | -0.001 | +0.001 | 101.7% | 142.7% |
| Ex13 | BH1-2+BD1-1 | BH2-1+BD2-1 | -0.14 | -0.09 | -0.001 | +0.001 | 101.5% | 142.1% |
| Ex14 | BH1-2+BD1-2 | BH2-1+BD2-1 | -0.10 | -0.05 | -0.001 | +0.001 | 101.8% | 140.3% |
| Ex15 | BH1-2+BD1-3 | BH2-1+BD2-1 | -0.15 | -0.10 | -0.001 | +0.001 | 101.6% | 145.4% |
| Ex16 | BH1-3+BD1-1 | BH2-1+BD2-1 | -0.09 | -0.04 | -0.001 | +0.001 | 102.1% | 139.1% |
| Ex17 | BH1-3+BD1-2 | BH2-1+BD2-1 | -0.11 | -0.06 | -0.001 | +0.000 | 102.4% | 138.3% |
| Ex18 | BH1-3+BD1-3 | BH2-1+BD2-1 | -0.12 | -0.06 | -0.001 | +0.001 | 101.9% | 140.3% |

**Table 3**

| | B-EML | | Property (@10mA/cm²) | | | | | T95 (%) |
|---|---|---|---|---|---|---|---|---|
| | B-EML1 | B-EML2 | Volt (V) | Volt (V) @100J | CIEx | CIEy | EQE (%) | |
| Ex19 | BH1-1+BD2-1 | BH2-1+BD1-1 | -0.16 | -0.11 | -0.002 | -0.001 | 97.0% | 139.6% |
| Ex20 | BH1-1+BD2-2 | BH2-1+BD1-1 | -0.14 | -0.09 | -0.002 | -0.001 | 96.4% | 138.7% |
| Ex21 | BH1-1+BD2-3 | BH2-1+BD1-1 | -0.13 | -0.09 | -0.002 | -0.002 | 98.0% | 137.3% |
| Ex22 | BH1-2+BD2-1 | BH2-1+BD1-1 | -0.15 | -0.11 | -0.002 | -0.001 | 96.6% | 141.6% |
| Ex23 | BH1-2+BD2-2 | BH2-1+BD1-1 | -0.11 | -0.05 | -0.002 | -0.001 | 97.0% | 140.9% |
| Ex24 | BH1-2+BD2-3 | BH2-1+BD1-1 | -0.16 | -0.10 | -0.002 | -0.002 | 97.6% | 140.1% |
| Ex25 | BH1-3+BD2-1 | BH2-1+BD1-1 | -0.08 | -0.03 | -0.002 | -0.001 | 97.2% | 138.9% |
| Ex26 | BH1-3+BD2-2 | BH2-1+BD1-1 | -0.08 | -0.04 | -0.002 | -0.001 | 96.7% | 139.2% |
| Ex27 | BH1-3+BD2-3 | BH2-1+BD1-1 | -0.10 | -0.04 | -0.002 | -0.002 | 97.8% | 138.4% |

**Table 4**

| | B-EML | | Property (@10mA/cm²) | | | | | T95 (%) |
|---|---|---|---|---|---|---|---|---|
| | B-EML1 | B-EML2 | Volt (V) | Volt (V) @100J | CIEx | CIEy | EQE (%) | |
| Ex28 | BH1-1+BD2-1 | BH2-1+BD2-1 | -0.17 | -0.12 | -0.001 | +0.004 | 103.6% | 145.0% |
| Ex29 | BH1-1+BD2-2 | BH2-1+BD2-1 | -0.15 | -0.10 | -0.001 | +0.004 | 103.0% | 144.4% |
| Ex30 | BH1-1+BD2-3 | BH2-1+BD2-1 | -0.15 | -0.08 | -0.001 | +0.003 | 104.1% | 144.0% |
| Ex31 | BH1-2+BD2-1 | BH2-1+BD2-1 | -0.14 | -0.09 | -0.001 | +0.004 | 103.2% | 146.4% |
| Ex32 | BH1-2+BD2-2 | BH2-1+BD2-1 | -0.10 | -0.06 | -0.001 | +0.003 | 103.3% | 145.9% |
| Ex33 | BH1-2+BD2-3 | BH2-1+BD2-1 | -0.17 | -0.12 | -0.001 | +0.003 | 103.9% | 144.7% |
| Ex34 | BH1-3+BD2-1 | BH2-1+BD2-1 | -0.09 | -0.04 | -0.001 | +0.004 | 103.0% | 145.4% |
| Ex35 | BH1-3+BD2-2 | BH2-1+BD2-1 | -0.11 | -0.08 | -0.001 | +0.004 | 102.8% | 144.9% |
| Ex36 | BH1-3+BD2-3 | BH2-1+BD2-1 | -0.13 | -0.10 | -0.001 | +0.003 | 103.7% | 144.7% |

As shown in Tables 1 to 4, in comparison to the OLED of Comparative Examples 1 and 2, the OLED of Examples 1 to 36 has an advantage in at least one of the driving voltage, the color purity, the emitting efficiency and the lifespan.

In addition, as shown in Examples 10 to 18, when the first dopant in the first blue emitting layer is the compound represented by Formula 5 and the second dopant in the second blue emitting layer is the compound represented by Formula 6, the OLED has big advantage in the driving voltage, the emitting efficiency and the lifespan with sufficient color purity.

As shown in Examples 19 to 27, when the first dopant in the first blue emitting layer is the compound represented by Formula 6 and the second dopant in the second blue emitting layer is the compound represented by Formula 5, the OLED has big advantage in the driving voltage, the color purity and the lifespan with sufficient emitting efficiency.

As shown in Examples 28 to 36, when the first dopant in the first blue emitting layer is the compound represented by Formula 6 and the second dopant in the second blue emitting layer is the compound represented by Formula 6, the OLED has big advantage in the driving voltage, the color purity and the lifespan with sufficient emitting efficiency.

### [OLED3]

On an anode (ITO, 1100 Å), an HIL (the compound in Formula 9 and the compound in Formula 10 (20wt%), 100 Å), an HTL (the compound in Formula 9, 800 Å), an EBL (the compound in Formula 11, 150 Å), a first blue emitting layer (a first host and a first dopant (the compound BD2-1 in Formula 8, 1.5wt% doping)), a second blue emitting layer (a second host and a second dopant (the compound BD2-1 in Formula 8, 1.5wt% doping)), an ETL (the compound in Formula 12, 200 Å), an EIL (LiF, 15 Å), and a cathode (Al, 1000 Å) were sequentially stacked to form an OLED.

### 3. Examples

### (1) Example 37 (Ex37)

The compound BH1-1 in Formula 2 was used as the first host to form the first blue emitting layer (25 Å), and the compound BH2-1 in Formula 4 was used as the second host to form the second blue emitting layer (225 Å).

### (2) Example 38 (Ex38)

The compound BH1-1 in Formula 2 was used as the first host to form the first blue emitting layer (50 Å), and the compound BH2-1 in Formula 4 was used as the second host to form the second blue emitting layer (200 Å).

### (3) Example 39 (Ex39)

The compound BH1-1 in Formula 2 was used as the first host to form the first blue emitting layer (75 Å), and the compound BH2-1 in Formula 4 was used as the second host to form the second blue emitting layer (175 Å).

### (4) Example 40 (Ex40)

The compound BH1-2 in Formula 2 was used as the first host to form the first blue emitting layer (25 Å), and the compound BH2-1 in Formula 4 was used as the second host to form the second blue emitting layer (225 Å).

### (5) Example 41 (Ex41)

The compound BH1-2 in Formula 2 was used as the first host to form the first blue emitting layer (50 Å), and the compound BH2-1 in Formula 4 was used as the second host to form the second blue emitting layer (200 Å).

### (6) Example 42 (Ex42)

The compound BH1-2 in Formula 2 was used as the first host to form the first blue emitting layer (75 Å), and the compound BH2-1 in Formula 4 was used as the second host to form the second blue emitting layer (175 Å).

The properties, i.e., a voltage (V), a color coordinate (CIEx, CIEy), an external quantum efficiency (EQE) and a lifespan (T95), of the OLEDs manufactured in Comparative Example 1 and Examples 37 to 42 were measured and listed in Table 5.

**Table 5**

| | B-EML | | Property (@10mA/cm²) | | | | | T95 (%) |
|---|---|---|---|---|---|---|---|---|
| | B-EML1 | B-EML2 | Volt (V) | Volt (V) @100J | CIEx | CIEy | EQE (%) | |
| Ref1 | BH2-1 (250Å) | | 0 | 0 | 0.000 | 0.000 | 100.0% | 100.0% |
| Ex37 | BH1-1 (25Å) | BH2-1 (225Å) | -0.02 | -0.03 | -0.002 | +0.004 | 103% | 141% |
| Ex38 | BH1-1 (50Å) | BH2-1 (200Å) | -0.06 | -0.11 | -0.002 | +0.005 | 104% | 145% |
| Ex39 | BH1-1 (75Å) | BH2-1 (175Å) | -0.05 | -0.11 | -0.002 | +0.006 | 103% | 135% |
| Ex40 | BH1-2 (25Å) | BH2-1 (225Å) | -0.01 | -0.01 | -0.001 | +0.004 | 102.7% | 145.7% |
| Ex41 | BH1-2 (50Å) | BH2-1 (200Å) | -0.03 | -0.05 | -0.001 | +0.004 | 103.2% | 146.4% |
| Ex42 | BH1-2 (75Å) | BH2-1 (175Å) | -0.04 | -0.05 | -0.001 | +0.005 | 103.0% | 146.0% |

As shown in Table 5, when a thickness of the first blue emitting layer, which includes the first host represented by Formula 1, is smaller than that of the second blue emitting layer, which includes the second host represented by Formula 3, the OLED has an advantage in at least one of the driving voltage, the color purity, the emitting efficiency and the lifespan.

In addition, as the OLEDs in Examples 38 and 41, when a thickness, e.g., 50 Å, of the first blue emitting layer is about 1/4 of a thickness, e.g., 200 Å, of the second blue emitting layer, the OLED has big advantage in at least one of the driving voltage, the color purity, the emitting efficiency and the lifespan.

## Claims

1. An organic light emitting diode, comprising:
a first electrode;
a second electrode facing the first electrode; and
a first emitting part including a first blue emitting layer and a second blue emitting layer and positioned between the first and second electrodes, the second blue emitting layer positioned between the first blue emitting layer and the second electrode and contacting the first blue emitting layer,
wherein the first blue emitting layer includes a first host and a first dopant, and the second blue emitting layer includes a second host and a second dopant,
wherein the first host is a pyrene derivative, and the second host is an anthracene derivative,
**characterized in that**
wherein the first dopant is a first compound represented by Formula 5 or a second compound represented by Formula 6, and the second dopant is a third compound represented by Formula 5 or a fourth compound represented by Formula 6, 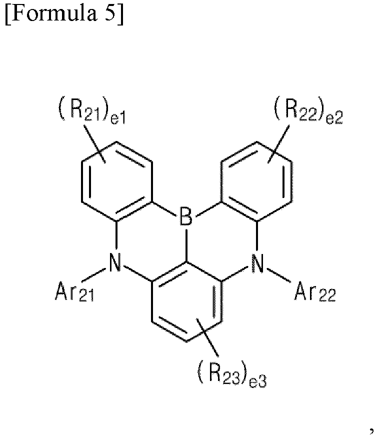
wherein in the Formula 5,
each of e1 and e2 is independently an integer of 0 to 4, and e3 is an integer of 0 to 3,
each of Ar₂₁ and Ar₂₂ is independently selected from the group consisting of a substituted or unsubstituted C6 to C30 arylamino group, a substituted or unsubstituted C6 to C30 aryl group, a substituted or unsubstituted C3 to C30 heteroaryl group and a substituted or unsubstituted C6 to C30 alicyclic group, and
R₂₁, R₂₂ and R₂₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group, 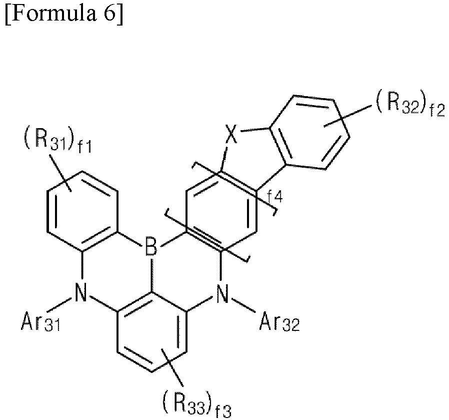 , and
wherein in the Formula 6,
each of f1 and f2 is independently an integer of 0 to 4, f3 is an integer of 0 to 3, f4 is 0 or 1,
X is O or S,
each of Ar₃₁ and Ar₃₂ is independently selected from the group consisting of a substituted or unsubstituted C6 to C30 arylamino group, a substituted or unsubstituted C6 to C30 aryl group, a substituted or unsubstituted C3 to C30 heteroaryl group and a substituted or unsubstituted C6 to C30 alicyclic group or forms a substituted or unsubstituted ring with adjacent benzene ring, and
each of R₃₁, R₃₂ and R₃₃ is independently selected from the group consisting of a substituted or unsubstituted C1 to C30 alkyl group, a substituted or unsubstituted C3 to C30 cycloalkyl group, a substituted or unsubstituted C6 to C30 arylamino group, a substituted or unsubstituted C6 to C30 aryl group and a substituted or unsubstituted C3 to C30 heteroaryl group,
wherein each of the second compound and the fourth compound represented by Formula 6 is independently one of compounds in Formula 8: 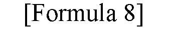 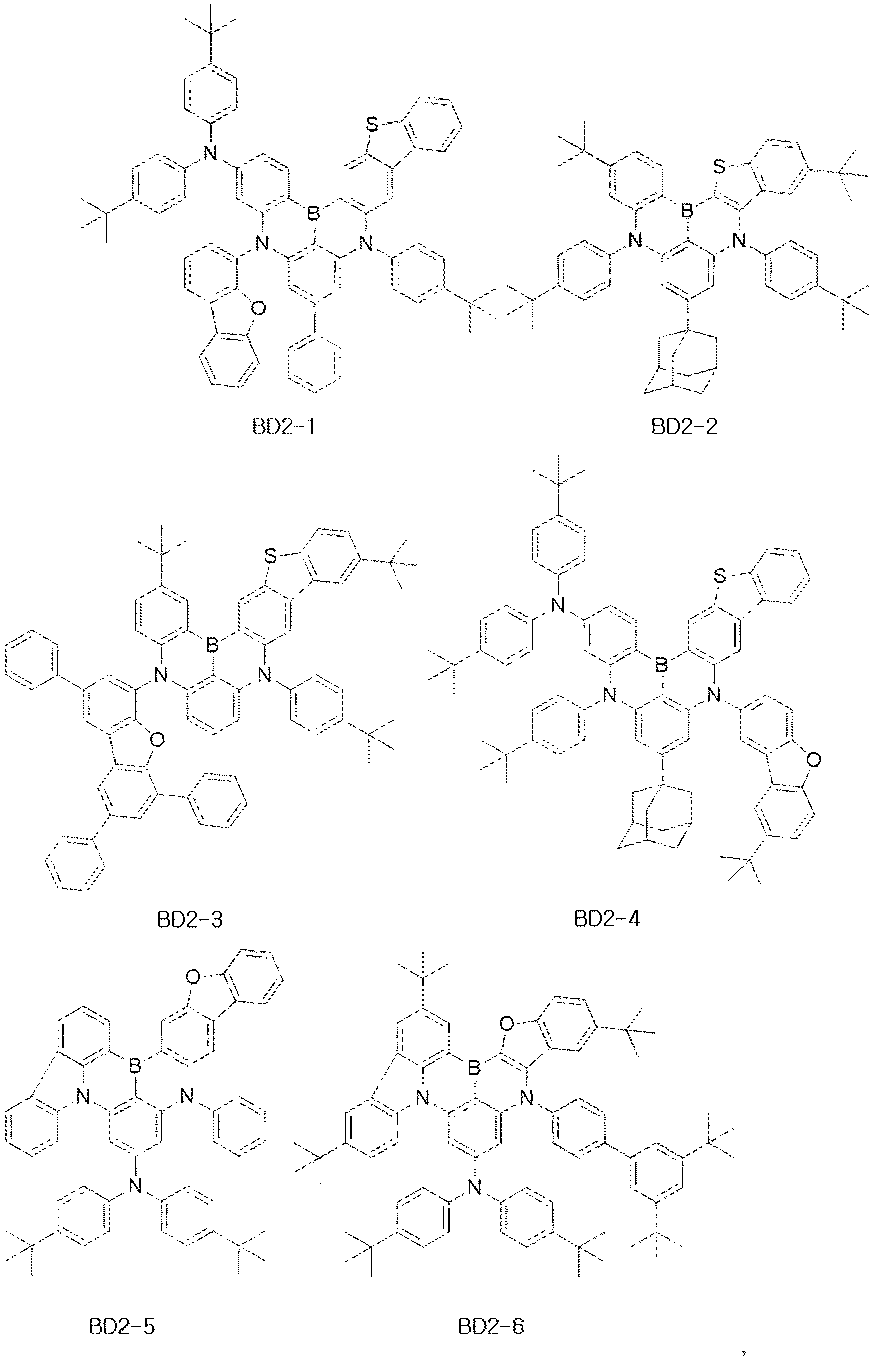
wherein the first dopant is represented by one of the Formulas 5 and 6, and the second dopant is represented by the other one of the Formulas 5 and 6.

2. The organic light emitting diode according to claim 1, wherein when the first dopant is the first compound and the second dopant is the fourth compound, a weight % of the first dopant in the first blue emitting material layer is smaller than a weight % of the second dopant in the second blue emitting material layer, or
wherein when the first dopant is the second compound and the second dopant is the third compound, a weight % of the first dopant in the first blue emitting material layer is greater than a weight % of the second dopant in the second blue emitting material layer.

3. The organic light emitting diode according to claim 1 or 2, wherein each of the first compound and the third compound is independently one of compounds in Formula 7:

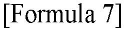

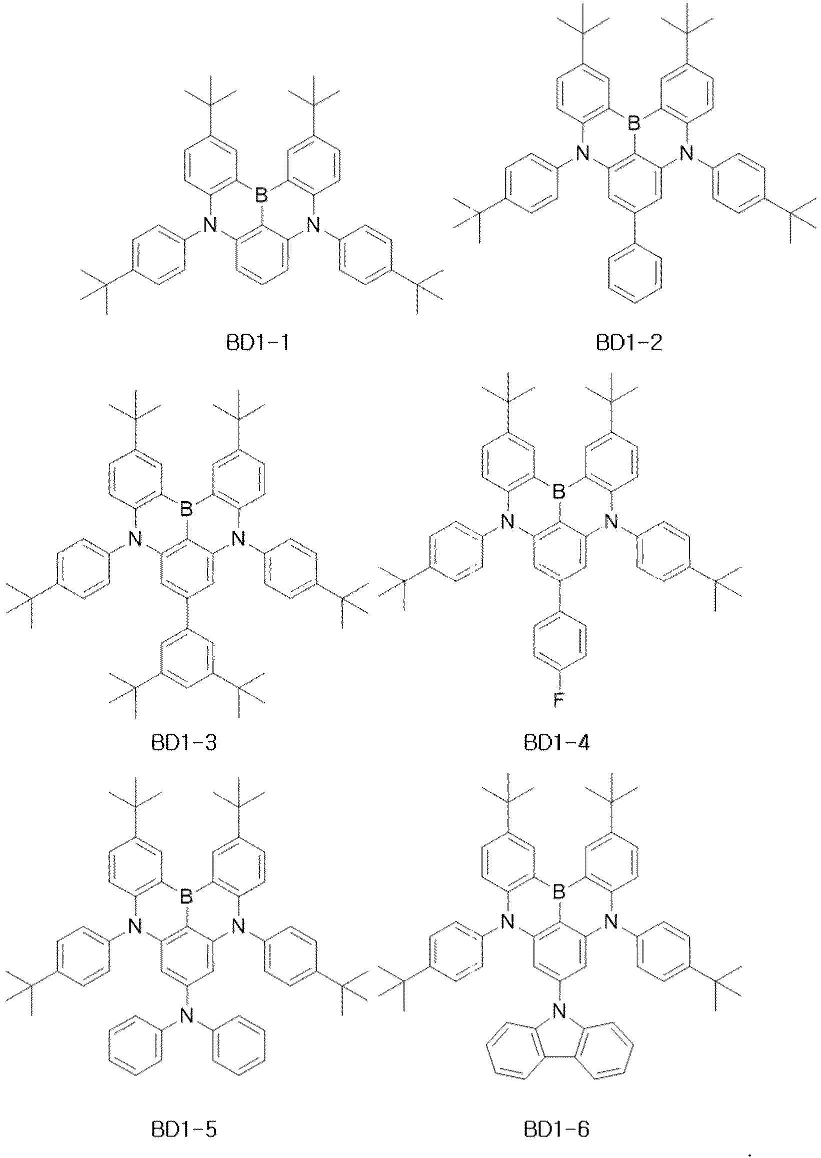

4. The organic light emitting diode according to any of claims 1 to 3, wherein the first host is represented by Formula 1: 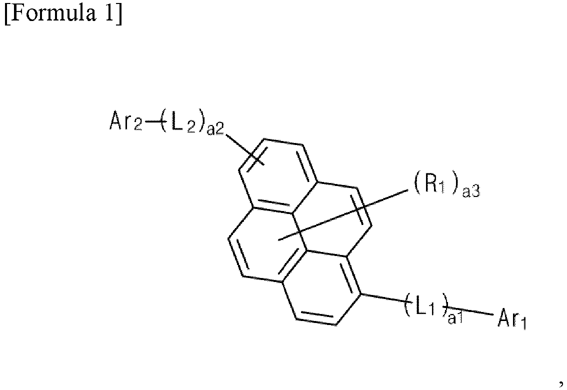
wherein in the Formula 1,
each of a1 and a2 is independently 0 or 1, and a3 is an integer of 0 to 4,
R₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of Ar₁ and Ar₂ is independently selected from the group consisting of hydrogen, deuterium, a substituted or unsubstituted C6 to C30 aryl group and a substituted or unsubstituted C3 to C30 heteroaryl group, and
each of L₁ and L₂ is independently selected from the group consisting of a substituted or unsubstituted C6 to C30 arylene group and a substituted or unsubstituted C3 to C30 heteroarylene group.

5. The organic light emitting diode according to any of claims 1 to 4, wherein the first host includes at least one of first host compounds in Formula 2:

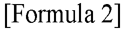

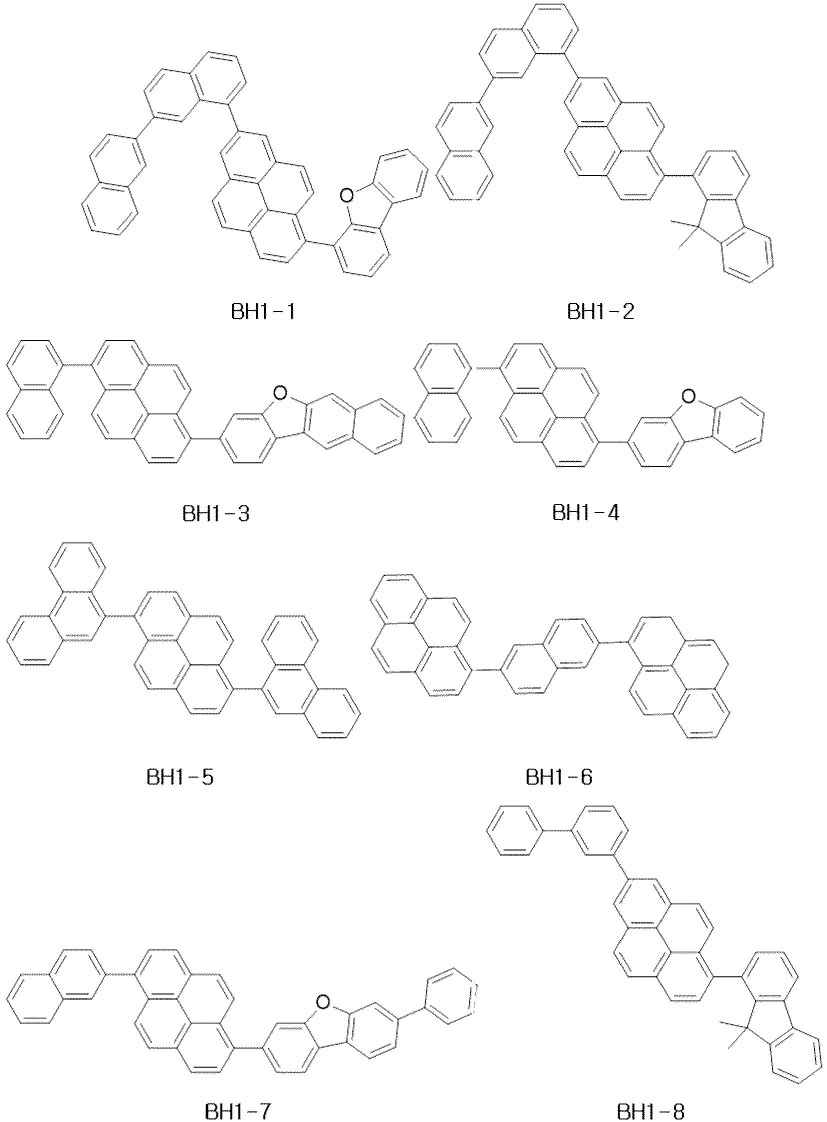

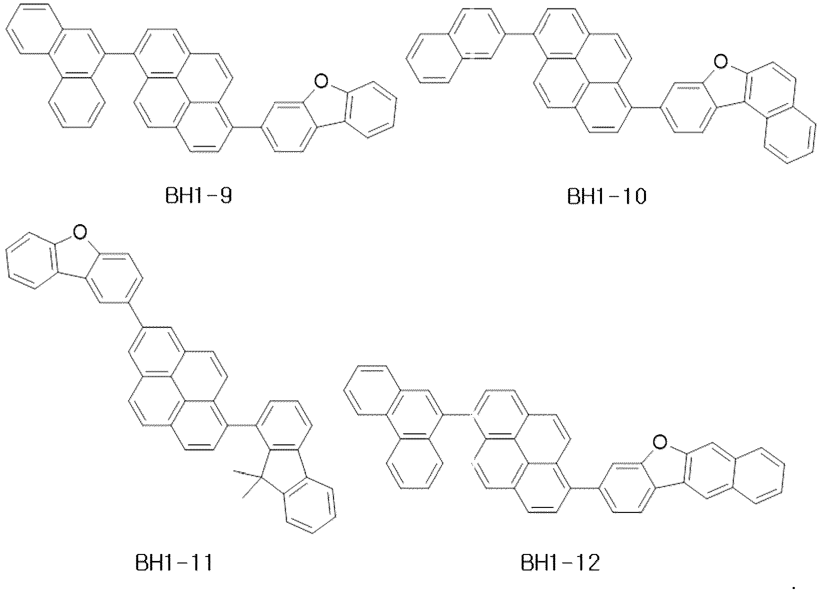

6. The organic light emitting diode according to any of claims 1 to 5, wherein the second host is represented by Formula 3: 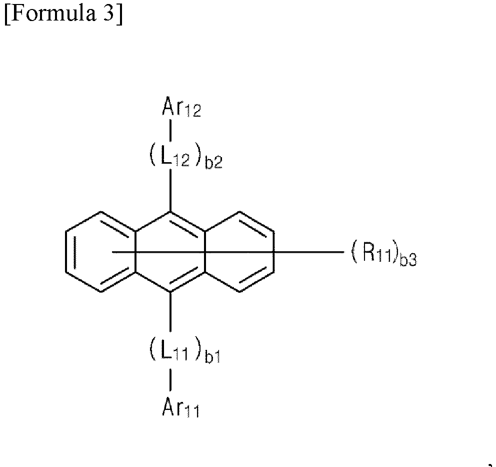
wherein in the Formula 3,
each of b1 and b2 is independently 0 or 1, and b3 is an integer of 0 to 8,
R₁₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of L₁₁ and L₁₂ is independently selected from the group consisting of a substituted or unsubstituted C6 to C30 arylene group and a substituted or unsubstituted C3 to C30 heteroarylene group, and
each of Ar₁₁ and Ar₁₂ is independently selected from the group consisting of a substituted or unsubstituted C6 to C30 aryl group and a substituted or unsubstituted C3 to C30 heteroaryl group.

7. The organic light emitting diode according to any of claims 1 to 6, wherein the second host includes at least one of second host compounds in Formula 4:

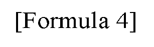

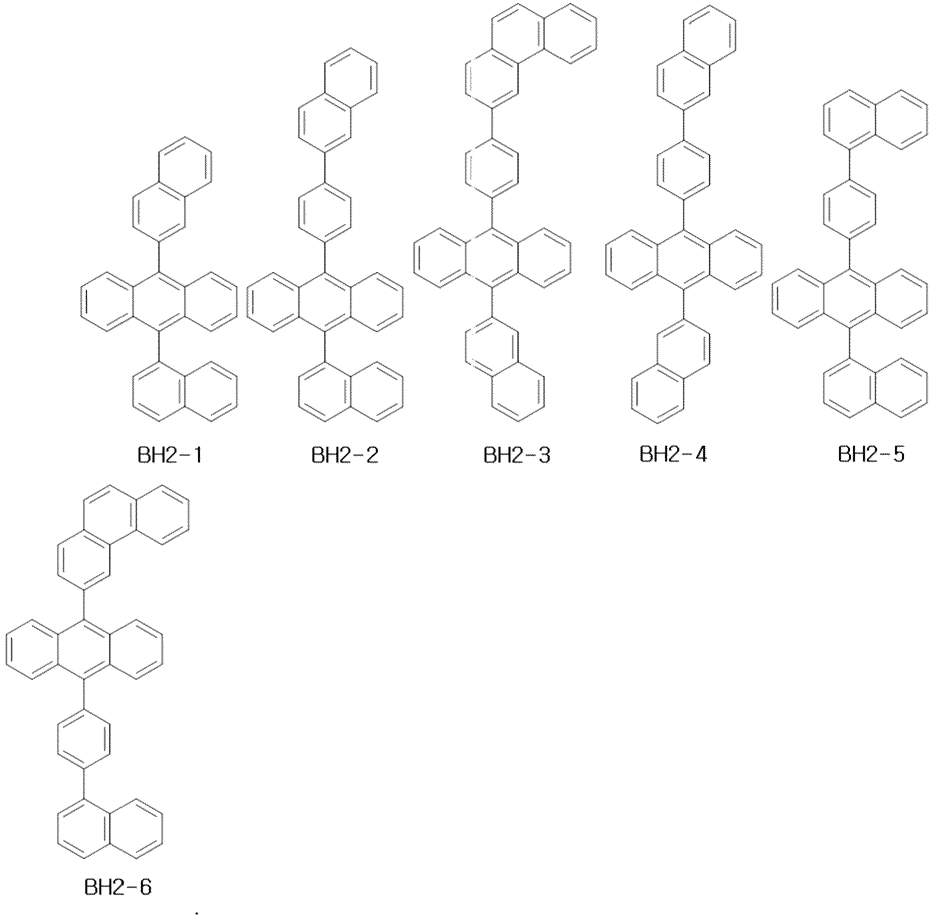

8. The organic light emitting diode according to any of claims 1 to 7, further comprising:
a second emitting part including a third blue emitting layer and a fourth blue emitting layer and positioned between the first emitting part and the second electrode, the fourth blue emitting layer positioned between the third blue emitting layer and the second electrode and contacting the third blue emitting layer,
wherein the third blue emitting layer includes a third host and a third dopant, and the fourth blue emitting layer includes a fourth host and a fourth dopant,
wherein the third host is the pyrene derivative, and the fourth host is the anthracene derivative,
wherein the third dopant is a fifth compound represented by the Formula 5 or a sixth compound, and the second dopant is a seventh compound represented by the Formula 5 or an eighth compound, and
wherein each of the sixth compound and the eighth compound is independently one of compounds in Formula 8.

9. The organic light emitting diode according to claim 8, wherein the third dopant is represented by one of the Formulas 5 and 6, and the fourth dopant is represented by the other one of the Formulas 5 and 6.

10. The organic light emitting diode according to claims 8 or 9, wherein when the third dopant is the fifth compound and the fourth dopant is the eighth compound, a weight % of the third dopant in the third blue emitting material layer is smaller than a weight % of the fourth dopant in the fourth blue emitting material layer, or
wherein when the third dopant is the sixth compound and the second dopant is the seventh compound, a weight % of the third dopant in the third blue emitting material layer is greater than a weight % of the fourth dopant in the fourth blue emitting material layer.

11. The organic light emitting diode according to any of claims 8 to 10, wherein the third host is represented by Formula 1: 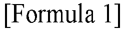 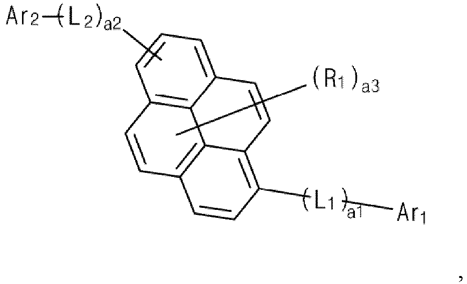
wherein in the Formula 1,
each of a1 and a2 is independently 0 or 1, and a3 is an integer of 0 to 4,
R₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of Ar₁ and Ar₂ is independently selected from the group consisting of hydrogen, deuterium, a substituted or unsubstituted C6 to C30 aryl group and a substituted or unsubstituted C3 to C30 heteroaryl group, and
each of L₁ and L₂ is independently selected from the group consisting of a substituted or unsubstituted C6 to C30 arylene group and a substituted or unsubstituted C3 to C30 heteroarylene group.

12. The organic light emitting diode according to any of claims 8 to 11, wherein the fourth host is represented by Formula 3: 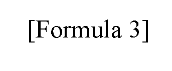 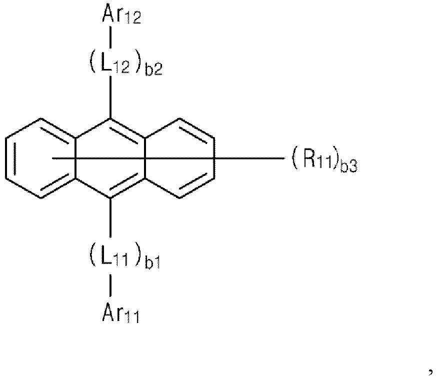
wherein in the Formula 3,
each of b1 and b2 is independently 0 or 1, and b3 is an integer of 0 to 8,
R₁₁ is selected from the group consisting of deuterium, a substituted or unsubstituted C1 to C30 alkyl group, a substituted or unsubstituted C1 to C30 alkoxy group, a substituted or unsubstituted C6 to C30 aryl group and a substituted or unsubstituted C3 to C30 heteroaryl group,
each of L₁₁ and L₁₂ is independently selected from the group consisting of a substituted or unsubstituted C6 to C30 arylene group and a substituted or unsubstituted C3 to C30 heteroarylene group, and
each of Ar₁₁ and Ar₁₂ is independently selected from the group consisting of a substituted or unsubstituted C6 to C30 aryl group and a substituted or unsubstituted C3 to C30 heteroaryl group.

13. An organic light emitting device (100), comprising:
a substrate (110);
an organic light emitting diode of any of claims 1 to 12 over the substrate (110); and
an encapsulation layer (170) covering the organic light emitting diode.

## Patentansprüche

1. Organische Leuchtdiode, umfassend:
eine erste Elektrode;
eine zweite Elektrode, die der ersten Elektrode gegenüberliegt; und
einen ersten emittierenden Teil, der eine erste blau emittierende Schicht und eine zweite blau emittierende Schicht umfasst und zwischen der ersten und der zweiten Elektrode angeordnet ist, wobei die zweite blau emittierende Schicht zwischen der ersten blau emittierenden Schicht und der zweiten Elektrode angeordnet ist und die erste blau emittierende Schicht kontaktiert,
wobei die erste blau emittierende Schicht einen ersten Wirtsstoff und einen ersten Dotierstoff umfasst und die zweite blau emittierende Schicht einen zweiten Wirtsstoff und einen zweiten Dotierstoff umfasst,
wobei der erste Wirtsstoff ein Pyrenderivat ist und der zweite Wirtsstoff ein Anthracenderivat ist,
**dadurch gekennzeichnet, dass**
wobei der erste Dotierstoff eine erste Verbindung ist, dargestellt durch die Formel 5, oder eine zweite Verbindung, dargestellt durch die Formel 6, und der zweite Dotierstoff eine dritte Verbindung ist, dargestellt durch die Formel 5, oder eine vierte Verbindung, dargestellt durch die Formel 6, 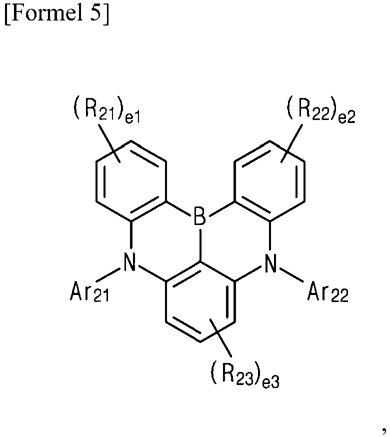
wobei in der Formel 5
e1 und e2 jeweils unabhängig voneinander eine ganze Zahl von 0 bis 4 sind und e3 eine ganze Zahl von 0 bis 3 ist,
Ar₂₁ und Ar₂₂ jeweils unabhängig voneinander ausgewählt sind aus der Gruppe, bestehend aus einer substituierten oder unsubstituierten C6- bis C30-Arylaminogruppe, einer substituierten oder unsubstituierten C6- bis C30-Arylgruppe, einer substituierten oder unsubstituierten C3- bis C30-Heteroarylgruppe und einer substituierten oder unsubstituierten alicyclischen C6- bis C30-Gruppe, und
R₂₁, R₂₂ und R₂₃ unabhängig voneinander ausgewählt sind aus der Gruppe, bestehend aus einer substituierten oder unsubstituierten C1- bis C30-Alkylgruppe, einer substituierten oder unsubstituierten C3- bis C30-Cycloalkylgruppe, einer substituierten oder unsubstituierten C6- bis C30-Arylaminogruppe, einer substituierten oder unsubstituierten C6- bis C30-Arylgruppe und einer substituierten oder unsubstituierten C3- bis C30-Heteroarylgruppe, 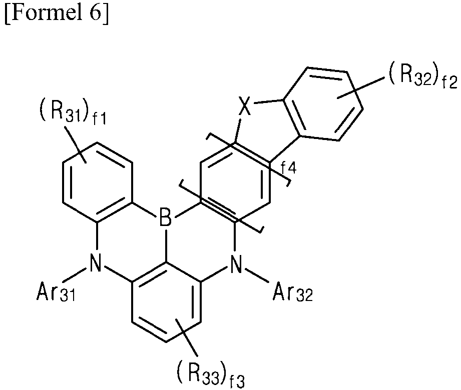 , und
wobei in der Formel 6
f1 und f2 jeweils unabhängig voneinander eine ganze Zahl von 0 bis 4 sind, f3 eine ganze Zahl von 0 bis 3 ist, f4 0 oder 1 ist,
X O oder S ist,
Ar₃₁ und Ar₃₂ jeweils unabhängig voneinander ausgewählt sind aus der Gruppe, bestehend aus einer substituierten oder unsubstituierten C6- bis C30-Arylaminogruppe, einer substituierten oder unsubstituierten C6- bis C30-Arylgruppe, einer substituierten oder unsubstituierten C3- bis C30-Heteroarylgruppe und einer substituierten oder unsubstituierten alicyclischen C6- bis C30-Gruppe, oder einen substituierten oder
unsubstituierten Ring mit einem benachbarten Benzolring bildet, und
R₃₁, R₃₂ und R₃₃ jeweils unabhängig voneinander ausgewählt sind aus der Gruppe, bestehend aus einer substituierten oder unsubstituierten C1- bis C30-Alkylgruppe, einer substituierten oder unsubstituierten C3- bis C30-Cycloalkylgruppe, einer substituierten oder unsubstituierten C6- bis C30-Arylaminogruppe, einer substituierten oder unsubstituierten C6- bis C30-Arylgruppe und einer substituierten oder unsubstituierten C3- bis C30-Heteroarylgruppe,
wobei sowohl die zweite Verbindung als auch die vierte Verbindung, die durch die Formel 6 dargestellt werden, jeweils unabhängig voneinander eine der Verbindungen in der Formel 8 ist: 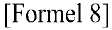 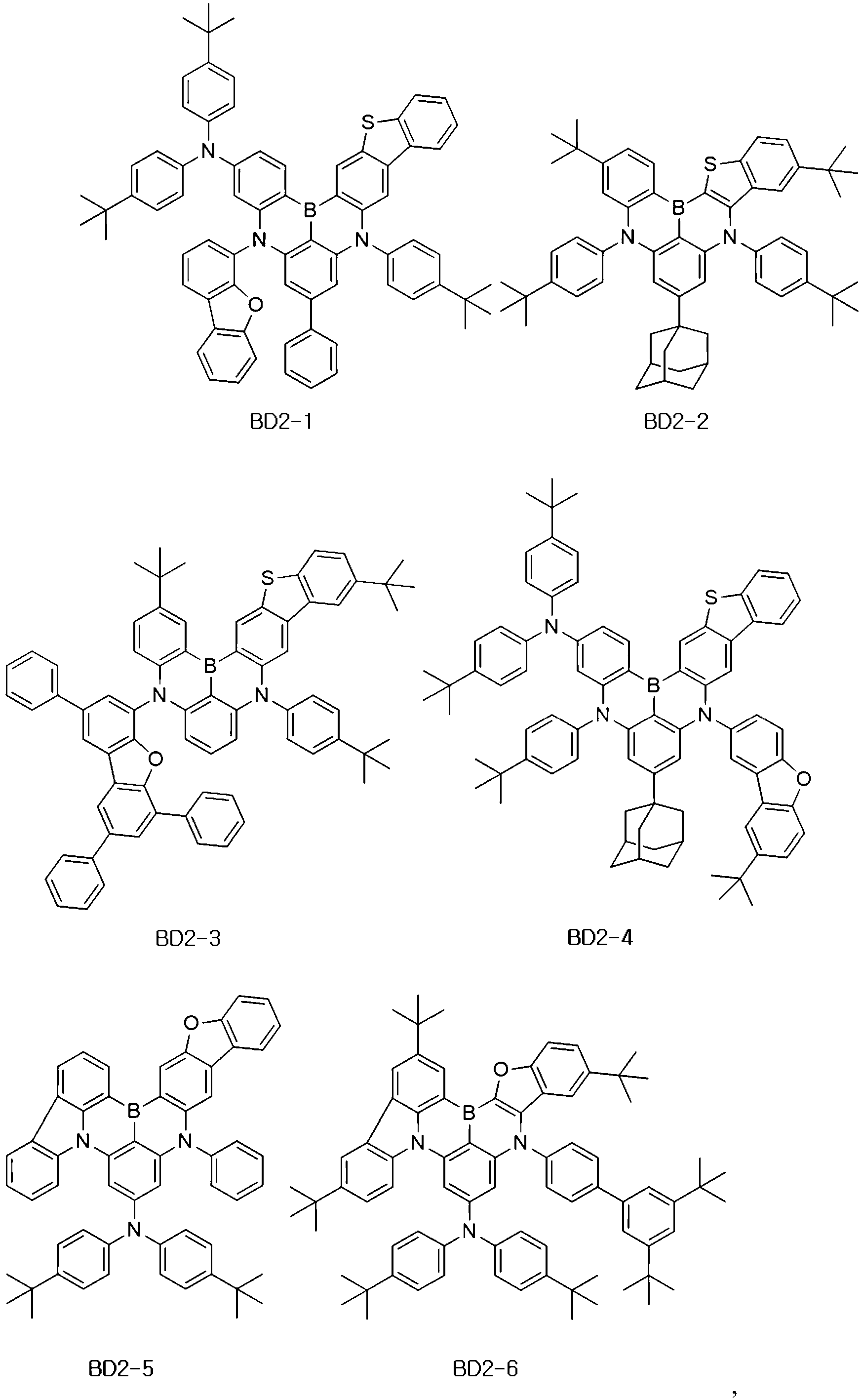
wobei der erste Dotierstoff durch eine der Formeln 5 und 6 dargestellt wird und der zweite Dotierstoff durch die andere der Formeln 5 und 6 dargestellt wird.

2. Organische Leuchtdiode gemäß Anspruch 1, wobei, wenn der erste Dotierstoff die erste Verbindung ist und der zweite Dotierstoff die vierte Verbindung ist, der Gewichtsanteil des ersten Dotierstoffs in der ersten blau emittierenden Materialschicht kleiner ist als der Gewichtsanteil des zweiten Dotierstoffs in der zweiten blau emittierenden Materialschicht, oder
wobei, wenn der erste Dotierstoff die zweite Verbindung ist und der zweite Dotierstoff die dritte Verbindung ist, der Gewichtsanteil des ersten Dotierstoffs in der ersten blau emittierenden Materialschicht größer ist als der Gewichtsanteil des zweiten Dotierstoffs in der zweiten blau emittierenden Materialschicht.

3. Organische Leuchtdiode gemäß Anspruch 1 oder 2, wobei die erste Verbindung und die dritte Verbindung jeweils unabhängig voneinander eine der Verbindungen in der Formel 7 sind:

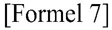

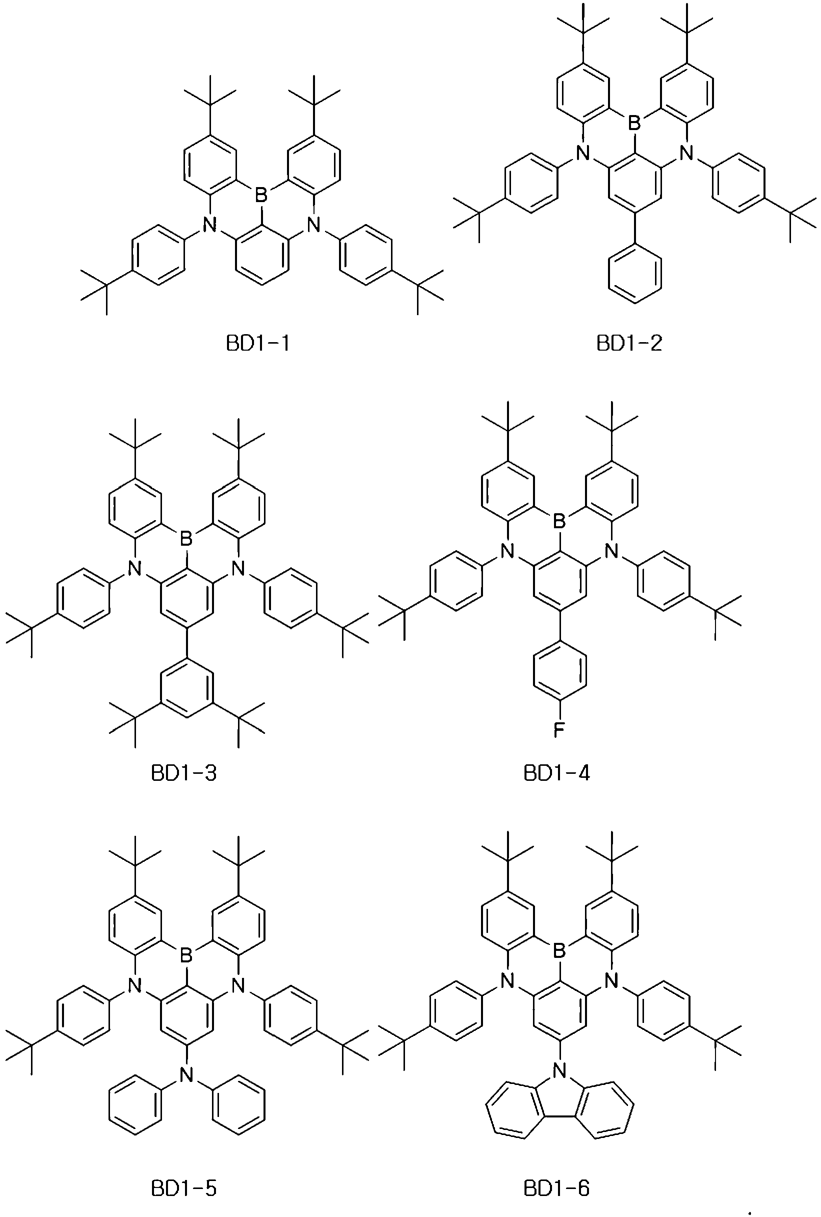

4. Organische Leuchtdiode gemäß einem der Ansprüche 1 bis 3, wobei der erste Wirtsstoff durch die Formel 1 dargestellt wird: 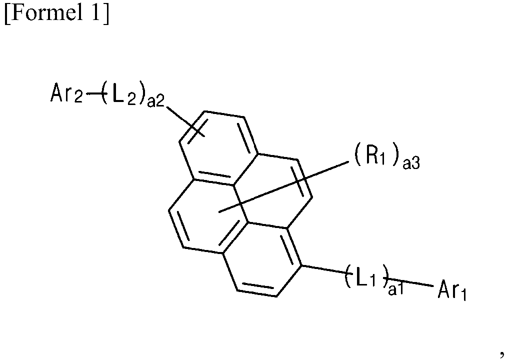 wobei in der Formel 1
a1 und a2 jeweils unabhängig voneinander 0 oder 1 sind und a3 eine ganze Zahl von 0 bis 4 ist,
R₁ ausgewählt ist aus der Gruppe, bestehend aus Deuterium, einer substituierten oder unsubstituierten C1- bis C30-Alkylgruppe, einer substituierten oder unsubstituierten C1-bis C30-Alkoxygruppe, einer substituierten oder unsubstituierten C6- bis C30-Arylgruppe und einer substituierten oder unsubstituierten C3- bis C30-Heteroarylgruppe, Ar₁ und Ar₂ jeweils unabhängig voneinander ausgewählt sind aus der Gruppe, bestehend aus Wasserstoff, Deuterium, einer substituierten oder unsubstituierten C6- bis C30-Arylgruppe und einer substituierten oder unsubstituierten C3- bis C30-Heteroarylgruppe, und
L₁ und L₂ jeweils unabhängig voneinander ausgewählt sind aus der Gruppe, bestehend aus einer substituierten oder unsubstituierten C6- bis C30-Arylengruppe und einer substituierten oder unsubstituierten C3- bis C30-Heteroarylengruppe.

5. Organische Leuchtdiode gemäß einem der Ansprüche 1 bis 4, wobei der erste Wirtsstoff mindestens eine der ersten Wirtsstoffverbindungen in der Formel 2 umfasst:

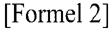

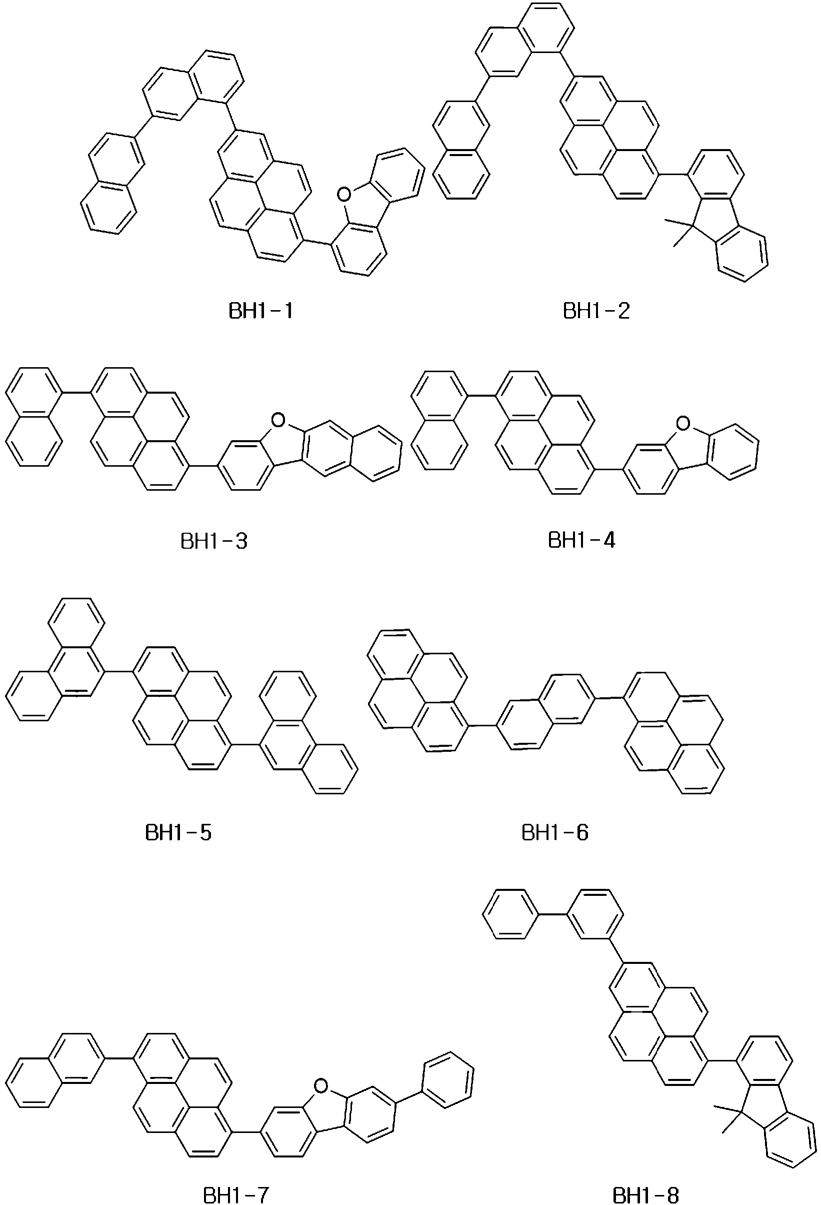

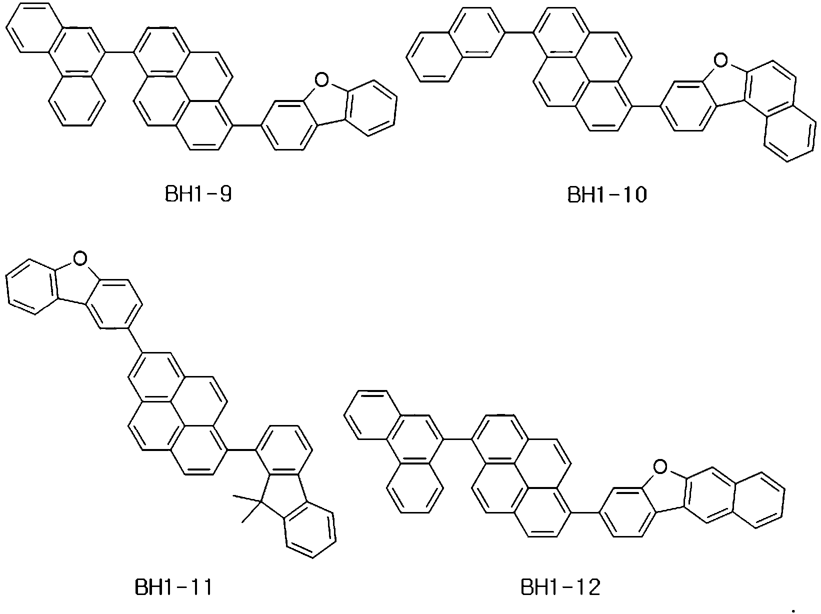

6. Organische Leuchtdiode gemäß einem der Ansprüche 1 bis 5, wobei der zweite Wirtsstoff durch die Formel 3 dargestellt wird: 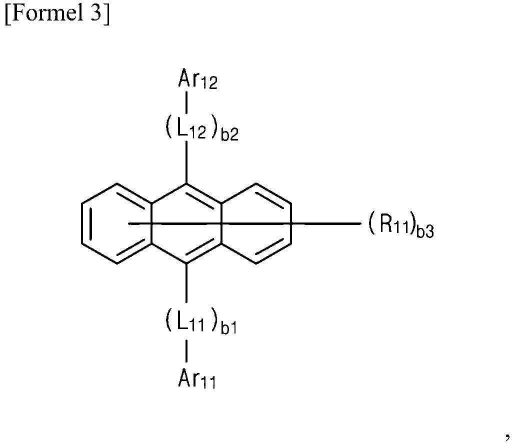 wobei in der Formel 3
b1 und b2 jeweils unabhängig voneinander 0 oder 1 sind und b3 eine ganze Zahl von 0 bis 8 ist,
R₁₁ ausgewählt ist aus der Gruppe, bestehend aus Deuterium, einer substituierten oder unsubstituierten C1- bis C30-Alkylgruppe, einer substituierten oder unsubstituierten C1-bis C30-Alkoxygruppe, einer substituierten oder unsubstituierten C6- bis C30-Arylgruppe und einer substituierten oder unsubstituierten C3- bis C30-Heteroarylgruppe, L₁₁ und L₁₂ jeweils unabhängig voneinander ausgewählt sind aus der Gruppe, bestehend aus einer substituierten oder unsubstituierten C6- bis C30-Arylengruppe und einer substituierten oder unsubstituierten C3- bis C30-Heteroarylengruppe, und
Ar₁₁ und Ar₁₂ jeweils unabhängig voneinander ausgewählt sind aus der Gruppe, bestehend aus einer substituierten oder unsubstituierten C6- bis C30-Arylgruppe und einer substituierten oder unsubstituierten C3- bis C30-Heteroarylgruppe.

7. Organische Leuchtdiode gemäß einem der Ansprüche 1 bis 6, wobei der zweite Wirtsstoff mindestens eine der zweiten Wirtsstoffverbindungen in der Formel 4 enthält:

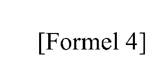

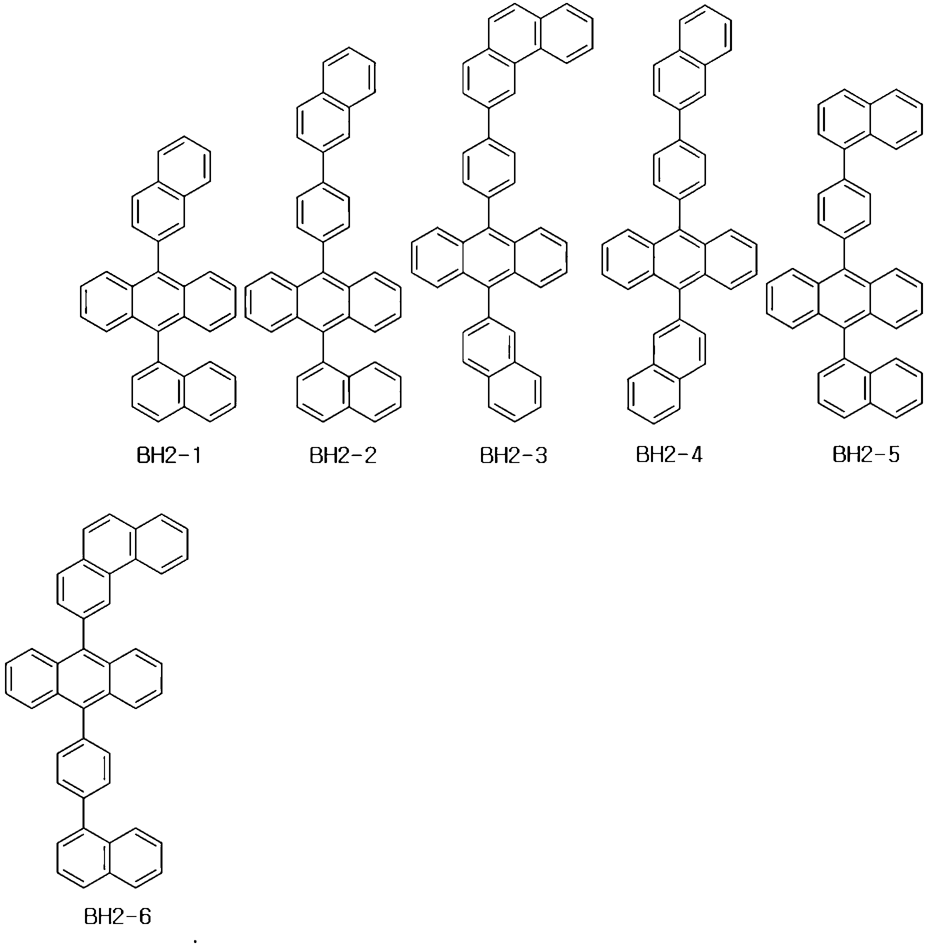

8. Organische Leuchtdiode gemäß einem der Ansprüche 1 bis 7, ferner umfassend:
einen zweiten emittierenden Teil, der eine dritte blau emittierende Schicht und eine vierte blau emittierende Schicht umfasst und zwischen dem ersten emittierenden Teil und der zweiten Elektrode angeordnet ist, wobei die vierte blau emittierende Schicht zwischen der dritten blau emittierenden Schicht und der zweiten Elektrode angeordnet ist und die dritte blau emittierende Schicht kontaktiert,
wobei die dritte blau emittierende Schicht einen dritten Wirtsstoff und einen dritten Dotierstoff umfasst und die vierte blau emittierende Schicht einen vierten Wirtsstoff und einen vierten Dotierstoff umfasst,
wobei der dritte Wirtsstoff das Pyrenderivat ist und der vierte Wirtsstoff das Anthracenderivat ist,
wobei der dritte Dotierstoff eine fünfte Verbindung, dargestellt durch die Formel 5, oder eine sechste Verbindung ist, und der zweite Dotierstoff eine siebte Verbindung, dargestellt durch die Formel 5, oder eine achte Verbindung ist, und
wobei die sechste Verbindung und die achte Verbindung jeweils unabhängig voneinander eine der Verbindungen in der Formel 8 sind.

9. Organische Leuchtdiode gemäß Anspruch 8, wobei der dritte Dotierstoff durch eine der Formeln 5 und 6 dargestellt wird und der vierte Dotierstoff durch die andere der Formeln 5 und 6 dargestellt wird.

10. Organische Leuchtdiode gemäß Anspruch 8 oder 9, wobei, wenn der dritte Dotierstoff die fünfte Verbindung ist und der vierte Dotierstoff die achte Verbindung ist, der Gewichtsanteil des dritten Dotierstoffs in der dritten blau emittierenden Materialschicht kleiner ist als der Gewichtsanteil des vierten Dotierstoffs in der vierten blau emittierenden Materialschicht, oder
wobei, wenn der dritte Dotierstoff die sechste Verbindung ist und der zweite Dotierstoff die siebte Verbindung ist, der Gewichtsanteil des dritten Dotierstoffs in der dritten blau emittierenden Materialschicht größer ist als der Gewichtsanteil des vierten Dotierstoffs in der vierten blau emittierenden Materialschicht.

11. Organische Leuchtdiode gemäß einem der Ansprüche 8 bis 10, wobei der dritte Wirtsstoff durch die Formel 1 dargestellt wird: 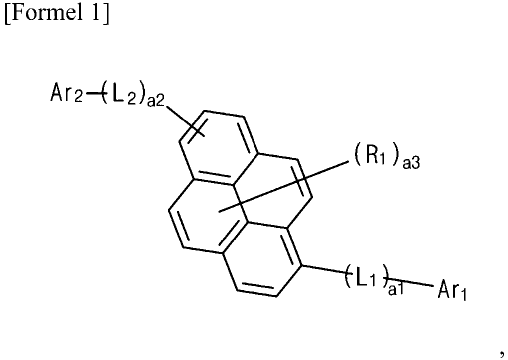 wobei in der Formel 1
a1 und a2 jeweils unabhängig voneinander 0 oder 1 sind und a3 eine ganze Zahl von 0 bis 4 ist,
R₁ ausgewählt ist aus der Gruppe, bestehend aus Deuterium, einer substituierten oder unsubstituierten C1- bis C30-Alkylgruppe, einer substituierten oder unsubstituierten C1-bis C30-Alkoxygruppe, einer substituierten oder unsubstituierten C6- bis C30-Arylgruppe und einer substituierten oder unsubstituierten C3- bis C30-Heteroarylgruppe, Ar₁ und Ar₂ jeweils unabhängig voneinander ausgewählt sind aus der Gruppe, bestehend aus Wasserstoff, Deuterium, einer substituierten oder unsubstituierten C6- bis C30-Arylgruppe und einer substituierten oder unsubstituierten C3- bis C30-Heteroarylgruppe, und
L₁ und L₂ jeweils unabhängig voneinander ausgewählt sind aus der Gruppe, bestehend aus einer substituierten oder unsubstituierten C6- bis C30-Arylengruppe und einer substituierten oder unsubstituierten C3- bis C30-Heteroarylengruppe.

12. Organische Leuchtdiode gemäß einem der Ansprüche 8 bis 11, wobei der vierte Wirtsstoff durch die Formel 3 dargestellt ist: 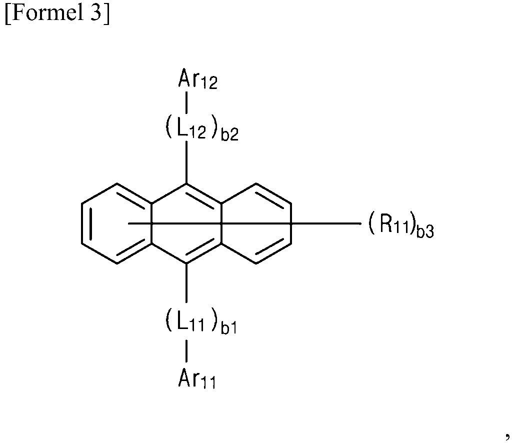 wobei in der Formel 3
b1 und b2 jeweils unabhängig voneinander 0 oder 1 sind und b3 eine ganze Zahl von 0 bis 8 ist,
R₁₁ ausgewählt ist aus der Gruppe, bestehend aus Deuterium, einer substituierten oder unsubstituierten C1- bis C30-Alkylgruppe, einer substituierten oder unsubstituierten C1-bis C30-Alkoxygruppe, einer substituierten oder unsubstituierten C6- bis C30-Arylgruppe und einer substituierten oder unsubstituierten C3- bis C30-Heteroarylgruppe, L₁₁ und L₁₂ jeweils unabhängig voneinander ausgewählt sind aus der Gruppe, bestehend aus einer substituierten oder unsubstituierten C6- bis C30-Arylengruppe und einer substituierten oder unsubstituierten C3- bis C30-Heteroarylengruppe, und
Ar₁₁ und Ar₁₂ jeweils unabhängig voneinander ausgewählt sind aus der Gruppe, bestehend aus einer substituierten oder unsubstituierten C6- bis C30-Arylgruppe und einer substituierten oder unsubstituierten C3- bis C30-Heteroarylgruppe.

13. Organische lichtemittierende Vorrichtung (100), umfassend:
ein Substrat (110);
eine organische Leuchtdiode nach einem der Ansprüche 1 bis 12 über dem Substrat (110); und
eine Verkapselungsschicht (170), die die organische Leuchtdiode bedeckt.

## Revendications

1. Diode électroluminescente organique, comportant :
une première électrode ;
une seconde électrode faisant face à la première électrode ; et
une première partie émettrice incluant une première couche émettrice de bleu et une deuxième couche émettrice de bleu et positionnée entre les première et seconde électrodes, la deuxième couche émettrice de bleu étant positionnée entre la première couche émettrice de bleu et la seconde électrode et en contact avec la première couche émettrice de bleu,
dans laquelle la première couche émettrice de bleu inclut un premier hôte et un premier dopant, et la deuxième couche émettrice de bleu comporte un deuxième hôte et un deuxième dopant,
dans laquelle le premier hôte est un dérivé de pyrène, et le deuxième hôte est un dérivé d'anthracène,
**caractérisée en ce que**
dans laquelle le premier dopant est un premier composé représenté par la Formule 5 ou un deuxième composé représenté par la Formule 6, et le deuxième dopant est un troisième composé représenté par la Formule 5 ou un quatrième composé représenté par la Formule 6, 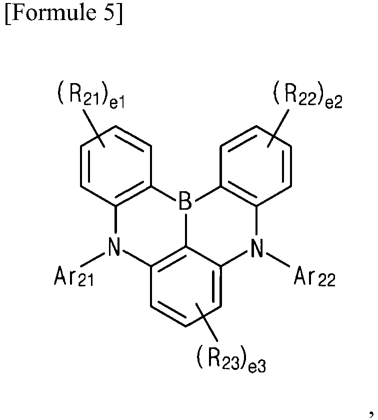
dans laquelle, dans la Formule 5,
chaque élément parmi e1 et e2 est indépendamment un entier de 0 à 4, et e3 est un entier de 0 à 3,
chaque élément parmi Ar₂₁ et Ar₂₂ est choisi indépendamment de l'autre parmi le groupe constitué d'un groupe arylamino en C₆ à C₃₀ substitué ou non substitué, d'un groupe aryle en C₆ à C₃₀ substitué ou non substitué, d'un groupe hétéroaryle en C₃ à C₃₀ substitué ou non substitué, et d'un groupe alicyclique en C₆ à C₃₀ substitué ou non substitué, et
R₂₁, R₂₂ et R₂₃ sont choisis indépendamment les uns des autres parmi le groupe constitué d'un groupe alkyle en C₁ à C₃₀ substitué ou non substitué, d'un groupe cycloalkyle en C₃ à C₃₀ substitué ou non substitué, d'un groupe arylamino en C₆ à C₃₀ substitué ou non substitué, d'un groupe aryle en C₆ à C₃₀ substitué ou non substitué, et d'un groupe hétéroaryle en C₃ à C₃₀ substitué ou non substitué, 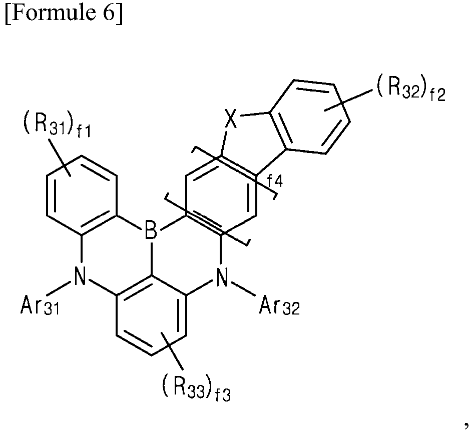 et
dans laquelle, dans la Formule 6,
chaque élément parmi f1 et f2 est indépendamment un entier de 0 à 4, f3 est un entier de 0 à 3, f4 vaut 0 ou 1,
X est O ou S,
chaque élément parmi Ar₃₁ et Ar₃₂ est choisi indépendamment de l'autre parmi le groupe constitué d'un groupe arylamino en C₆ à C₃₀ substitué ou non substitué, d'un groupe aryle en C₆ à C₃₀ substitué ou non substitué, d'un groupe hétéroaryle en C₃ à C₃₀ substitué ou non substitué, et d'un groupe alicyclique en C₆ à C₃₀ substitué ou non substitué, ou forme un cycle substitué ou non substitué avec un cycle benzénique adjacent, et
chaque élément parmi R₃₁, R₃₂ et R₃₃ est choisi indépendamment des autres parmi le groupe constitué d'un groupe alkyle en C₁ à C₃₀ substitué ou non substitué, d'un groupe cycloalkyle en C₃ à C₃₀ substitué ou non substitué, d'un groupe arylamino en C₆ à C₃₀ substitué ou non substitué, d'un groupe aryle en C₆ à C₃₀ substitué ou non substitué, et d'un groupe hétéroaryle en C₃ à C₃₀ substitué ou non substitué,
dans laquelle chaque composé parmi le deuxième composé et le quatrième composé représentés par la Formule 6 est indépendamment l'un des composés de la Formule 8 : 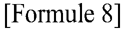 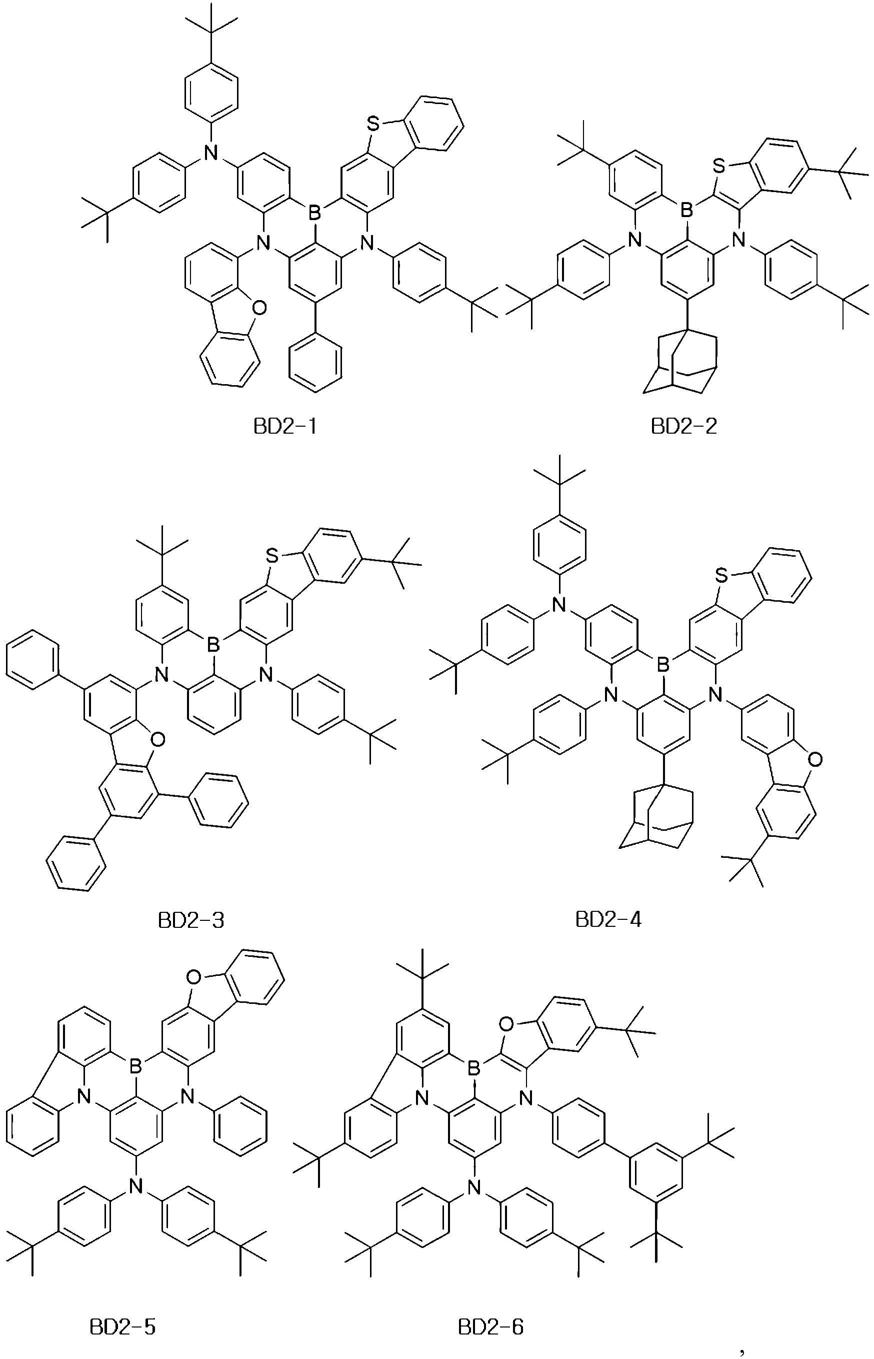
dans laquelle le premier dopant est représenté par l'une des Formules 5 et 6, et le deuxième dopant est représenté par l'autre des Formules 5 et 6.

2. Diode électroluminescente organique selon la revendication 1, dans laquelle, lorsque le premier dopant est le premier composé et le deuxième dopant est le quatrième composé, un % en poids du premier dopant dans la première couche de matière émettrice de bleu est inférieur à un % en poids du deuxième dopant dans la seconde couche de matière émettrice de bleu, ou
dans laquelle, lorsque le premier dopant est le deuxième composé et le deuxième dopant est le troisième composé, un % en poids du premier dopant dans la première couche de matière émettrice de bleu est supérieur à un % en poids du deuxième dopant dans la seconde couche de matière émettrice de bleu.

3. Diode électroluminescente organique selon la revendication 1 ou 2, dans laquelle chaque composé parmi le premier composé et le troisième composé est indépendamment l'un des composés de Formule 7 :

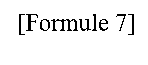

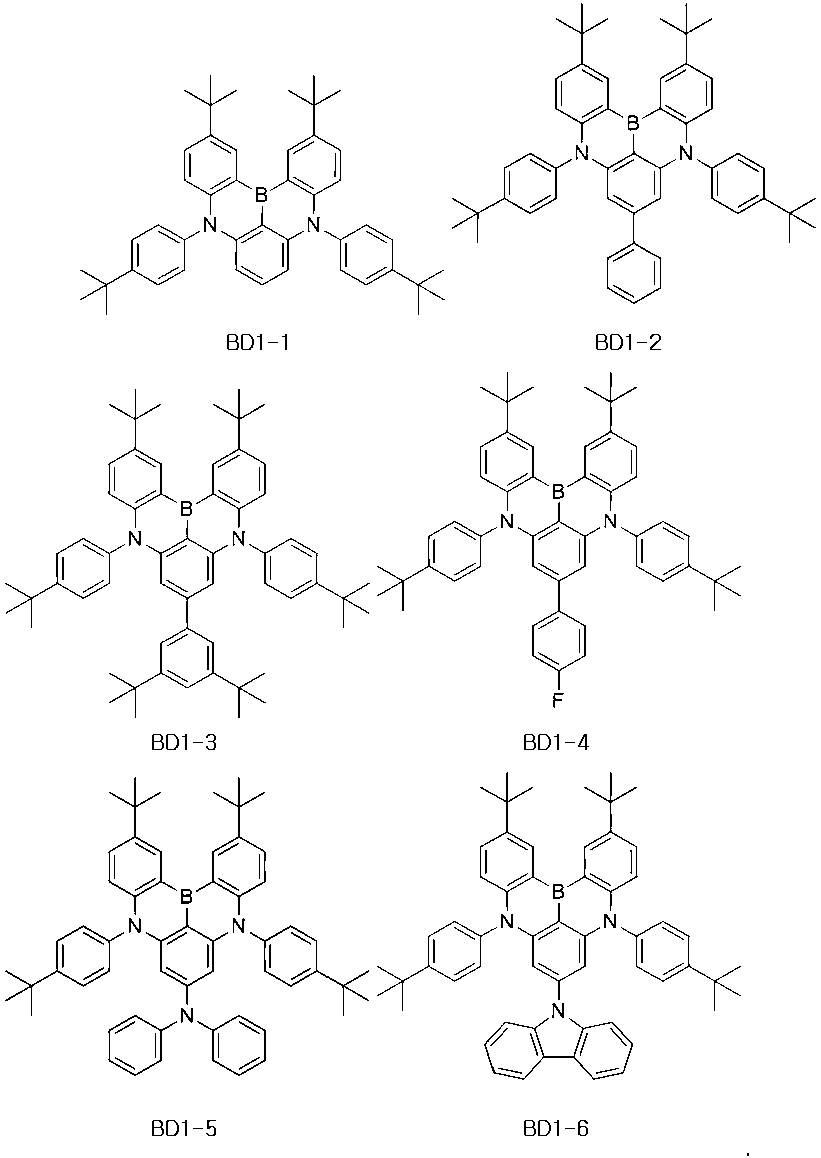

4. Diode électroluminescente organique selon l'une quelconque des revendications 1 à 3, dans laquelle le premier hôte est représenté par la Formule 1 : 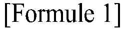 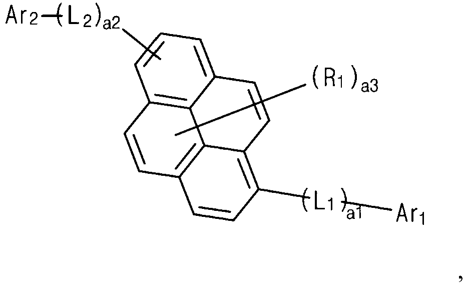 dans laquelle, dans la Formule 1,
chaque élément parmi a1 et a2 vaut indépendamment 0 ou 1, et a3 est un entier de 0 à 4,
R₁ est choisi parmi le groupe constitué du deutérium, d'un groupe alkyle en C₁ à C₃₀ substitué ou non substitué, d'un groupe alcoxy en C₁ à C₃₀ substitué ou non substitué, d'un groupe aryle en C₆ à C₃₀ substitué ou non substitué, et d'un groupe hétéroaryle en C₃ à C₃₀ substitué ou non substitué,
chaque élément parmi Ar₁ et Ar₂ est choisi indépendamment de l'autre parmi le groupe constitué de l'hydrogène, du deutérium, d'un groupe aryle en C₆ à C₃₀ substitué ou non substitué, et d'un groupe hétéroaryle en C₃ à C₃₀ substitué ou non substitué, et
chaque élément parmi L₁ et L₂ est choisi indépendamment de l'autre parmi le groupe constitué d'un groupe arylène en C₆ à C₃₀ substitué ou non substitué, et d'un groupe hétéroarylène en C₃ à C₃₀ substitué ou non substitué.

5. Diode électroluminescente organique selon l'une quelconque des revendications 1 à 4, dans laquelle le premier hôte inclut au moins l'un des composés du premier hôte dans la Formule 2 :

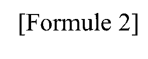

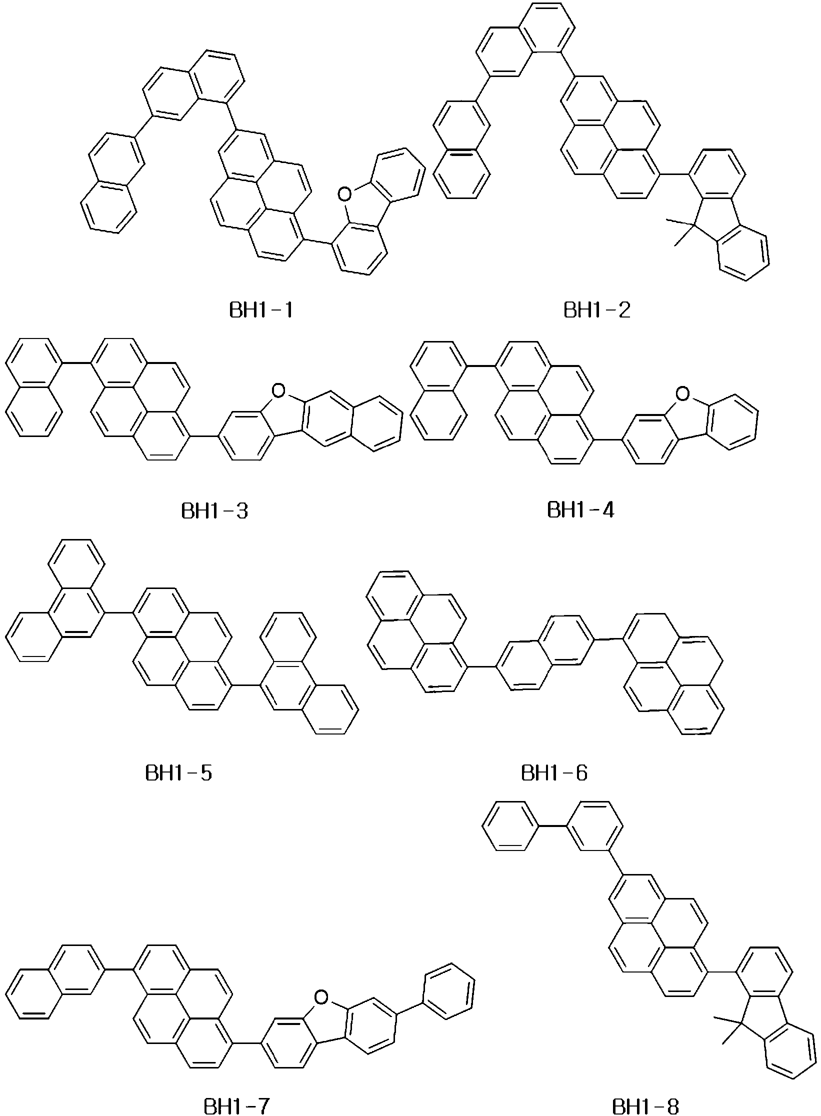

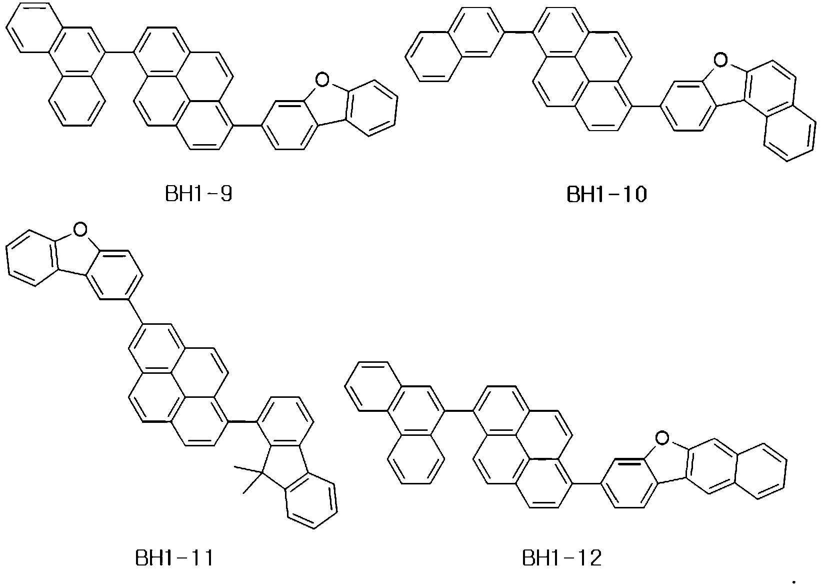

6. Diode électroluminescente organique selon l'une quelconque des revendications 1 à 5, dans laquelle le deuxième hôte est représenté par la Formule 3 : 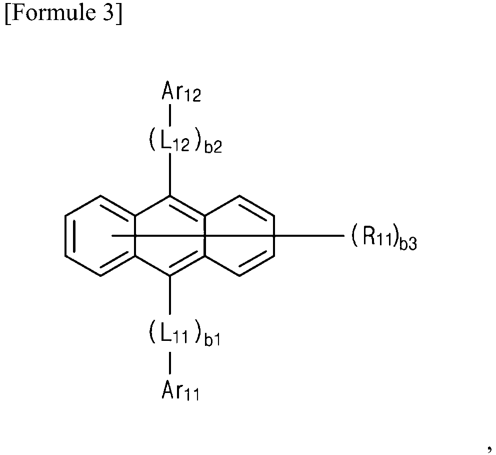 dans laquelle, dans la Formule 3,
chaque élément parmi b1 et b2 vaut indépendamment 0 ou 1, et b3 est un entier de 0 à 8,
R₁₁ est choisi parmi le groupe constitué du deutérium, d'un groupe alkyle en C₁ à C₃₀ substitué ou non substitué, d'un groupe alcoxy en C₁ à C₃₀ substitué ou non substitué, d'un groupe aryle en C₆ à C₃₀ substitué ou non substitué, et d'un groupe hétéroaryle en C₃ à C₃₀ substitué ou non substitué,
chaque élément parmi L₁₁ et L₁₂ est choisi indépendamment de l'autre parmi le groupe constitué d'un groupe arylène en C₆ à C₃₀ substitué ou non substitué, et d'un groupe hétéroarylène en C₃ à C₃₀ substitué ou non substitué, et
chaque élément parmi Ar₁₁ et Ar₁₂ est choisi indépendamment de l'autre parmi le groupe constitué d'un groupe aryle en C₆ à C₃₀ substitué ou non substitué, et d'un groupe hétéroaryle en C₃ à C₃₀ substitué ou non substitué.

7. Diode électroluminescente organique selon l'une quelconque des revendications 1 à 6, dans laquelle le deuxième hôte inclut au moins l'un des composés du deuxième hôte dans la Formule 4 :

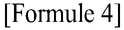

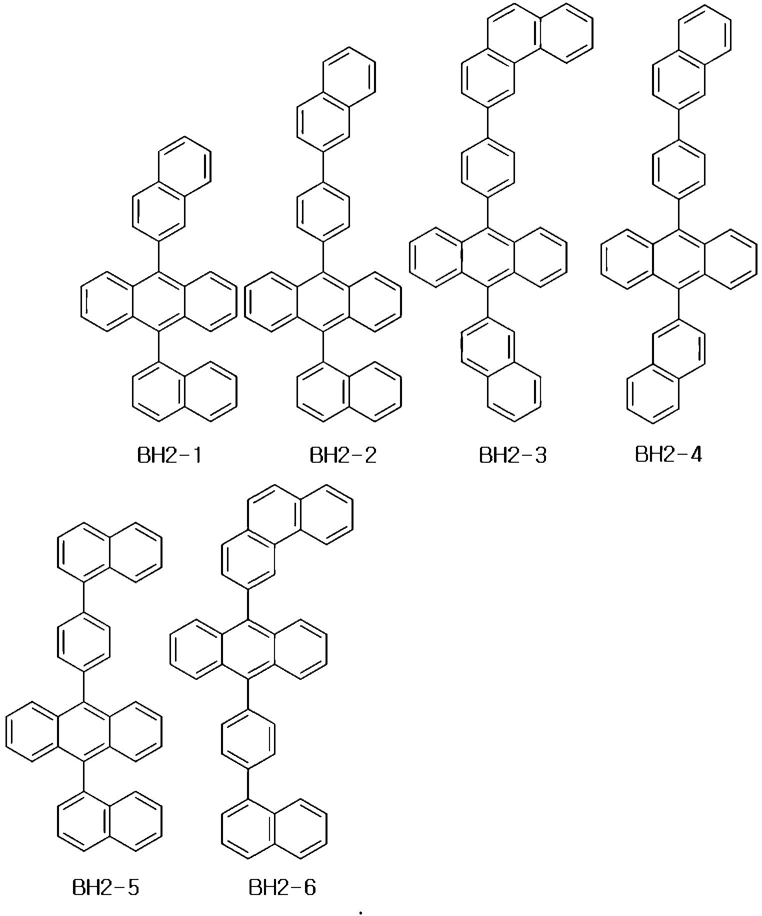

8. Diode électroluminescente organique selon l'une quelconque des revendications 1 à 7, comportant en outre :
une seconde partie émettrice incluant une troisième couche émettrice de bleu et une quatrième couche émettrice de bleu et positionnée entre la première partie émettrice et la seconde électrode, la quatrième couche émettrice de bleu étant positionnée entre la troisième couche émettrice de bleu et la seconde électrode et en contact avec la troisième couche émettrice de bleu,
dans laquelle la troisième couche émettrice de bleu inclut un troisième hôte et un troisième dopant, et la quatrième couche émettrice de bleu inclut un quatrième hôte et un quatrième dopant,
dans laquelle le troisième hôte est un dérivé de pyrène, et le quatrième hôte est un dérivé d'anthracène,
dans laquelle le troisième dopant est un cinquième composé représenté par la Formule 5 ou un sixième composé, et le deuxième dopant est un septième composé représenté par la Formule 5 ou un huitième composé, et
dans laquelle chaque composé parmi le sixième composé et le huitième composé est indépendamment l'un des composés de Formule 8.

9. Diode électroluminescente organique selon la revendication 8, dans laquelle le troisième dopant est représenté par l'une des Formules 5 et 6, et le quatrième dopant est représenté par l'autre des Formules 5 et 6.

10. Diode électroluminescente organique selon les revendications 8 ou 9, dans laquelle, lorsque le troisième dopant est le cinquième composé et le quatrième dopant est le huitième composé, un % en poids du troisième dopant dans la troisième couche de matière émettrice de bleu est inférieur à un % en poids du quatrième dopant dans la quatrième couche de matière émettrice de bleu, ou
dans laquelle, lorsque le troisième dopant est le sixième composé et le deuxième dopant est le septième composé, un % en poids du troisième dopant dans la troisième couche de matière émettrice de bleu est supérieur à un % en poids du quatrième dopant dans la quatrième couche de matière émettrice de bleu.

11. Diode électroluminescente organique selon l'une quelconque des revendications 8 à 10, dans laquelle le troisième hôte est représenté par la Formule 1 : 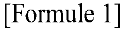 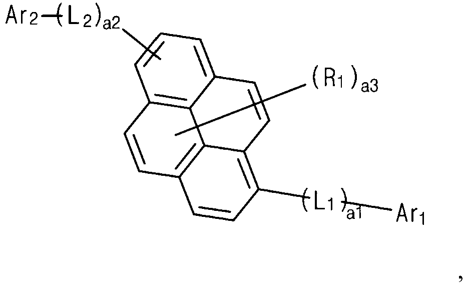 dans laquelle, dans la Formule 1,
chaque élément parmi a1 et a2 vaut indépendamment 0 ou 1, et a3 est un entier de 0 à 4,
R₁ est choisi parmi le groupe constitué du deutérium, d'un groupe alkyle en C₁ à C₃₀ substitué ou non substitué, d'un groupe alcoxy en C₁ à C₃₀ substitué ou non substitué, d'un groupe aryle en C₆ à C₃₀ substitué ou non substitué, et d'un groupe hétéroaryle en C₃ à C₃₀ substitué ou non substitué,
chaque élément parmi Ar₁ et Ar₂ est choisi indépendamment de l'autre parmi le groupe constitué de l'hydrogène, du deutérium, d'un groupe aryle en C₆ à C₃₀ substitué ou non substitué, et d'un groupe hétéroaryle en C₃ à C₃₀ substitué ou non substitué, et
chaque élément parmi L₁ et L₂ est choisi indépendamment de l'autre parmi le groupe constitué d'un groupe arylène en C₆ à C₃₀ substitué ou non substitué, et d'un groupe hétéroarylène en C₃ à C₃₀ substitué ou non substitué.

12. Diode électroluminescente organique selon l'une quelconque des revendications 8 à 11, dans laquelle le quatrième hôte est représenté par la Formule 3 : 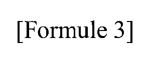 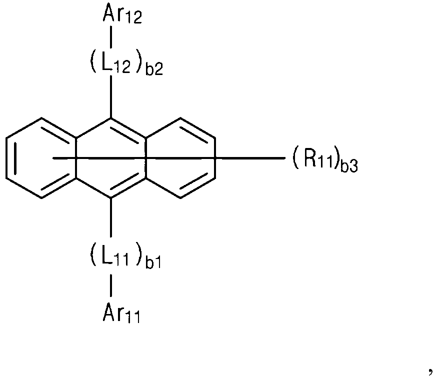 dans laquelle, dans la Formule 3,
chaque élément parmi b1 et b2 vaut indépendamment 0 ou 1, et b3 est un entier de 0 à 8,
R₁₁ est choisi parmi le groupe constitué du deutérium, d'un groupe alkyle en C₁ à C₃₀ substitué ou non substitué, d'un groupe alcoxy en C₁ à C₃₀ substitué ou non substitué, d'un groupe aryle en C₆ à C₃₀ substitué ou non substitué, et d'un groupe hétéroaryle en C₃ à C₃₀ substitué ou non substitué,
chaque élément parmi L₁₁ et L₁₂ est choisi indépendamment de l'autre parmi le groupe constitué d'un groupe arylène en C₆ à C₃₀ substitué ou non substitué, et d'un groupe hétéroarylène en C₃ à C₃₀ substitué ou non substitué, et
chaque élément parmi Ar₁₁ et Ar₁₂ est choisi indépendamment de l'autre parmi le groupe constitué d'un groupe aryle en C₆ à C₃₀ substitué ou non substitué, et d'un groupe hétéroaryle en C₃ à C₃₀ substitué ou non substitué.

13. Dispositif électroluminescent organique (100), comportant :
un substrat (110) ;
une diode électroluminescente organique selon l'une quelconque des revendications 1 à 12 au-dessus du substrat (110) ; et
une couche d'encapsulation (170) recouvrant la diode électroluminescente organique.
